# EUROPEAN PATENT APPLICATION

(11) **EP 4 831 739 A2**
(43) Date of publication of application: **28.10.2026**
(21) Application number: 26171330.9
(22) Date of filing: 09.04.2026
(51) Int. Cl.: G03F 7/09

(54) **COMPOSITION FOR FORMING RESIST UNDERLAYER FILM, PATTERNING PROCESS, AND METHOD FOR FORMING RESIST UNDERLAYER FILM**

(30) Priority: 22.04.2025 JP 2025070558
(71) Applicant: SHIN-ETSU CHEMICAL CO., LTD., Tokyo 100-0005 (JP)
(72) Inventor: WATANABE, Mamoru, Niigata (JP); IMATA, Tomohiro, Niigata (JP); MIYAZAKI, Rin, Niigata (JP); NAKADA, Seiya, Niigata (JP); KORI, Daisuke, Niigata (JP); TACHIBANA, Seiichiro, Niigata (JP)
(74) Representative: Schicker, Silvia

(57) **Abstract**

The present invention is a composition for forming a resist underlayer film, containing: (A) a polymer including a structural unit that includes an organic sulfonyl anion structure and an onium cation structure derived from a sulfur atom, the onium cation structure being pendently bonded to a polymer main chain; (B) a thermal acid generator; and (C) an organic solvent, where the polymer (A) and the thermal acid generator (B) each have an identical organic sulfonyl anion molecule. This can provide: a composition for forming a resist underlayer film that has favorable storage stability, and that also that gives a resist underlayer film having favorable pattern collapse suppression performance, and the ability to remove resist residues at the bottom of a pattern; a patterning process using the composition; and a method for forming the resist underlayer film by using the composition.

## Description

### TECHNICAL FIELD

The present invention relates to: a composition for forming a resist underlayer film; a patterning process using the composition for forming a resist underlayer film; and a method for forming a resist underlayer film by using the composition for forming a resist underlayer film.

### BACKGROUND ART

As LSI advances toward high integration and high processing speed, miniaturization of pattern size is progressing rapidly. Along with the miniaturization, lithography technology has achieved a fine patterning by shortening the wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a resist mechanism that makes an exposed part soluble, thereby dissolving the exposed part to form a pattern and processing a substrate to be processed coated with a photoresist composition by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the film thickness of the photoresist film has been thinned along with the miniaturization.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus damaged during processing of the substrate to be processed and the photoresist film collapses during processing of the substrate to be processed, so that the resist pattern cannot be transferred accurately to the substrate to be processed. Accordingly, higher dry etching resistance has been required in a photoresist composition accompanying miniaturization of the pattern. In addition, resins used for photoresist compositions have been required to have low absorbance at the wavelength to be used for the exposure owing to the shortening of the exposure wavelength. Accordingly, along with the shift from i-beam to KrF and to ArF, the resin also shifts to novolak resins, polyhydroxystyrene, and resins having an aliphatic polycyclic skeleton. This shift actually accelerates an etching rate under the dry etching conditions, and recent photoresist compositions having high resolution tend to have low etching resistance.

As a result, a substrate to be processed has to be dry-etched with a thinner photoresist film having lower etching resistance. A material for this process and the process itself are urgently needed.

A multilayer resist method is one solution for these problems. This method is as follows: a resist middle layer film having a different etching selectivity from a photoresist film (i.e., a resist upper layer film) is placed between the resist upper layer film and a substrate to be processed; a pattern is formed in the resist upper layer film; then, the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a 3-layer resist method, which can be performed with a typical resist composition used in the monolayer resist method. For example, this 3-layer resist method includes the following steps: an organic film containing a novolak or the like is formed as a resist underlayer film on a substrate to be processed; a silicon-containing film is formed thereon as a silicon-containing resist middle layer film; and a usual organic photoresist film is formed thereon as a resist upper layer film. Since the organic resist upper layer film exhibits a favorable etching selectivity ratio relative to the silicon-containing resist middle layer film when dry etching is performed with fluorine-based gas plasma, the resist upper layer film pattern is transferred to the silicon-containing resist middle layer film by dry etching with fluorine-based gas plasma. Furthermore, when etching is performed using oxygen gas or hydrogen gas, the silicon-containing resist middle layer film exhibits a favorable etching selectivity ratio relative to the resist underlayer film, so that the silicon-containing resist middle layer film pattern is transferred to the resist underlayer film by etching with oxygen gas or hydrogen gas. According to this process, even when using a photoresist composition which is difficult to form a pattern in so that the pattern has a sufficient film thickness for directly processing the substrate to be processed or a photoresist composition which does not have sufficient dry etching resistance for processing the substrate, a pattern can be transferred to a silicon-containing film (silicon-containing resist middle layer film). In this manner, it is possible to obtain a pattern of an organic film (resist underlayer film) containing a novolak or the like having a sufficient dry etching resistance for the processing.

In recent years, as an effective technology to take the place of a combination of ArF immersion lithography and multiple exposure process, vacuum ultraviolet ray (EUV) lithography with a wavelength of 13.5 nm is attracting attention. By using this technology, it has become possible to form a fine pattern with a half pitch of 25 nm or less in one exposure.

Meanwhile, in EUV lithography, higher sensitivity in a resist material is strongly required to compensate for insufficient output of a light source. However, increase in shot noise that accompanies higher sensitization leads to increase in edge roughness (LER and LWR) of line patterns, and compatibility of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element, such as barium, titanium, hafnium, zirconium, or tin, has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, a resist material with added metal salt or organometallic complex (Patent Documents 1, 2) or a non-chemically amplified resist material that uses nanoparticles of metal oxide (Patent Documents 3, 4, Non Patent Document 1) are considered. However, these metal-containing resists have a problem that pattern collapse and resist residues at the bottom of the pattern adversely affect the process.

Accordingly, there have been reported materials that suppress pattern collapse and resist residues by using an adhesive film containing an organic sulfonyl anion to supply an acid to the bottom of the resist and promote the reaction in the resist in exposed portions (Patent Documents 5, 6, 7). However, these materials have issues such as: low storage stability due to the precipitation of a resin containing an organic sulfonyl anion having low solubility; and residues caused by intermixing due to insufficient film curability.

### CITATION LIST

### PATENT LITERATURE

Patent Document 1: JP5708521B2
Patent Document 2: JP5708522B2
Patent Document 3: US9310684B2
Patent Document 4: WO2003/017002A1
Patent Document 5: JP5415982B2
Patent Document 6: JP7634473B2
Patent Document 7: WO2025/028314A1

### NON PATENT LITERATURE

Non Patent Document 1: Proc. SPIE Vol. 7969, 796915 (2011)

### SUMMARY OF INVENTION

### TECHNICAL PROBLEM

The present invention has been made in view of the above-described circumstances. An object of the present invention is to provide: a composition for forming a resist underlayer film that has favorable storage stability, and that also gives a resist underlayer film having favorable pattern collapse suppression performance and the ability to remove resist residues at the bottom of a pattern; a patterning process using the composition; and a method for forming the resist underlayer film by using the composition.

### SOLUTION TO PROBLEM

To achieve the object, the present invention provides a composition for forming a resist underlayer film, comprising:
(A) a polymer including a structural unit that includes an organic sulfonyl anion structure and an onium cation structure derived from a sulfur atom, the onium cation structure being pendently bonded to a polymer main chain;
(B) a thermal acid generator; and
(C) an organic solvent,
wherein the polymer (A) and the thermal acid generator (B) each have an identical organic sulfonyl anion molecule.

Such a composition for forming a resist underlayer film can achieve favorable film curability by virtue of the thermal acid generator, and can prevent the precipitation of components derived from the polymer or the thermal acid generator when stored for a long time.

In the present invention, the structural unit including the organic sulfonyl anion structure and the onium cation structure derived from a sulfur atom, included in the polymer (A), preferably has a structure represented by the following general formula (1) or (2), 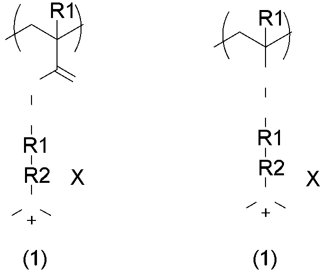 wherein R1 represents a hydrogen atom or a methyl group; R2 represents a substituted or unsubstituted divalent organic group optionally containing an ether bond or an ester bond or represents a single bond; Ar1 and Ar2 each represent a substituted or unsubstituted aromatic ring structure; Ar3 represents a substituted or unsubstituted divalent aromatic ring structure; L1 represents a divalent organic group having 1 to 30 carbon atoms or represents a single bond; X1 represents a nitrogen atom or a carbon atom, each optionally having a substituent, or represents an ether bond, an ester bond, a thioether bond, or a single bond; X⁻ has a structure identical to that of the organic sulfonyl anion molecule included in the thermal acid generator (B); and R2, Ar1, and Ar2 each optionally form a cyclic structure.

Such a composition for forming a resist underlayer film can further enhance the advantageous effects of the present invention.

In this event, the X⁻ preferably has an alicyclic structure.

Such a polymer (A) has a bulky alicyclic structure, and therefore, solubility can be improved and it is possible to prevent precipitation during long-term storage.

In the present invention, it is further preferable that the polymer (A) does not include a structural unit that satisfies the following conditions:
contains a total of two or more nitrogen atoms, oxygen atoms, or sulfur atoms, each having an unpaired electron, in a structure excluding an acrylate group or methacrylate group that functions as a polymerizable group, and two or fewer atoms are present between the two nitrogen atoms, oxygen atoms, or sulfur atoms.

Such a composition for forming a resist underlayer film has favorable adhesiveness to various resists, and makes it possible to remove residues at the bottom of a resist without increasing pattern roughness.

In the present invention, a ratio of the structural unit including the organic sulfonyl anion structure and the onium cation structure derived from a sulfur atom among structural units of the polymer (A) is preferably 1 mol% or more and 30 mol% or less.

Such a composition for forming a resist underlayer film can prevent the precipitation of components derived from the polymer or the thermal acid generator when stored for a long time, and favorable storage stability can be achieved.

In the present invention, the polymer (A) preferably has at least one structural unit represented by the following general formula (3), 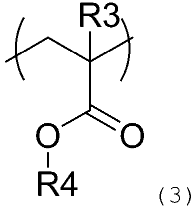
wherein R3 represents a hydrogen atom or a methyl group; and R4 represents a group selected from the following formulae (3-1) to (3-3), 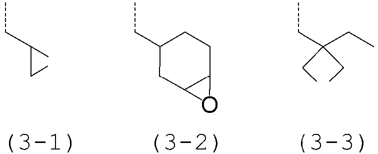
wherein a broken line represents an attachment point.

When such structural units are included, the inventive composition for forming a resist underlayer film can achieve favorable curability without the adhesiveness to other resists being degraded.

In the present invention, the polymer (A) preferably has a weight-average molecular weight of 1,000 to 50,000.

Furthermore, in the present invention, the organic solvent (C) is preferably a mixture of one or more kinds of organic solvent having a boiling point of lower than 150°C and one or more kinds of organic solvent having a boiling point of 150°C or higher and a boiling point of lower than 220°C.

Furthermore, in the present invention, the composition for forming a resist underlayer film more preferably further comprises at least one kind selected from (D) a surfactant and (E) a crosslinking agent.

Such a composition for forming a resist underlayer film can achieve favorable coating property, and in addition, it is possible to make fine adjustments to properties such as coating property and film curability, and therefore, such a composition is preferable in terms of practical use.

In addition, the present invention provides a patterning process for forming a pattern in a substrate to be processed, comprising the steps of:
(I-1) applying the above-described composition for forming a resist underlayer film on a substrate to be processed and then performing a heat treatment to form a resist underlayer film;
(I-2) forming a resist upper layer film on the resist underlayer film by using a photoresist material;
(I-3) subjecting the resist upper layer film to pattern exposure and then development to form a pattern in the resist upper layer film;
(I-4) transferring the pattern to the resist underlayer film by dry etching while using the resist upper layer film having the formed pattern as a mask; and
(I-5) forming the pattern in the substrate to be processed by processing the substrate to be processed while using the resist underlayer film having the transferred pattern as a mask.

The present invention also provides a patterning process for forming a pattern in a substrate to be processed, comprising the steps of:
(II-1) forming an organic film on a substrate to be processed;
(II-2) forming a silicon-containing resist middle layer film on the organic film;
(II-3) applying the above-described composition for forming a resist underlayer film on the silicon-containing resist middle layer film and then performing a heat treatment to form a resist underlayer film;
(II-4) forming a resist upper layer film on the resist underlayer film by using a photoresist material;
(II-5) subjecting the resist upper layer film to pattern exposure and then development to form a pattern in the resist upper layer film;
(II-6) transferring the pattern to the resist underlayer film by dry etching while using the resist upper layer film having the formed pattern as a mask;
(II-7) transferring the pattern to the silicon-containing resist middle layer film by dry etching while using the resist underlayer film having the transferred pattern as a mask;
(II-8) transferring the pattern to the organic film by dry etching while using the silicon-containing resist middle layer film having the transferred pattern as a mask; and
(II-9) forming the pattern in the substrate to be processed by processing the substrate to be processed while using the organic film having the transferred pattern as a mask.

The present invention also provides a patterning process for forming a pattern in a substrate to be processed, comprising the steps of:
(III-1) forming an organic film on a substrate to be processed;
(III-2) forming an inorganic hard mask middle layer film selected from a silicon oxide film, a silicon nitride film, and a silicon oxynitride film on the organic film;
(III-3) applying the above-described composition for forming a resist underlayer film on the inorganic hard mask middle layer film and then performing a heat treatment to form a resist underlayer film;
(III-4) forming a resist upper layer film on the resist underlayer film by using a photoresist material;
(III-5) subjecting the resist upper layer film to pattern exposure and then development to form a pattern in the resist upper layer film;
(III-6) transferring the pattern to the resist underlayer film by dry etching while using the resist upper layer film having the formed pattern as a mask;
(III-7) transferring the pattern to the inorganic hard mask middle layer film by dry etching while using the resist underlayer film having the transferred pattern as a mask;
(III-8) transferring the pattern to the organic film by dry etching while using the inorganic hard mask middle layer film having the transferred pattern as a mask; and
(III-9) forming the pattern in the substrate to be processed by processing the substrate to be processed while using the organic film having the transferred pattern as a mask.

As described, the inventive composition for forming a resist underlayer film can be used suitably for various patterning processes such as a 2-layer resist process or a 4-layer resist process in which the resist underlayer film is formed on the silicon-containing middle layer film (silicon-containing resist middle layer film, inorganic hard mask middle layer film). These patterning processes are suitable for photolithography of a resist upper layer film.

In this event, the inorganic hard mask middle layer film is preferably formed by a CVD method or an ALD method.

In the present invention, photolithography at a wavelength of 10 nm or more to 300 nm or less, a direct drawing by electron beam, a nanoimprinting, or a combination thereof is preferably employed as a method for forming the pattern in the resist upper layer film.

In the present invention, it is further preferable that the resist upper layer film is formed using a photoresist material containing at least an organic metal compound and a solvent.

In the present invention, the development is preferably selected from alkaline development, development with an organic solvent, or development using dry etching.

In the present invention, pattern formation can be performed favorably and efficiently according to such a patterning process.

In the present invention, the substrate to be processed is preferably a semiconductor device substrate or the semiconductor device substrate coated with any of a metal film, a metal carbide film, a metal oxide film, a metal nitride film, a metal oxycarbide film, and a metal oxynitride film.

In this event, as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is preferably used.

According to the inventive patterning processes as described, the substrates to be processed described above can be processed in the above manner to form a pattern.

The present invention also provides a method for forming a resist underlayer film employed in a semiconductor device manufacturing process, the method comprising:
spin-coating a substrate to be processed with the above-described composition for forming a resist underlayer film; and
heating the substrate coated with the composition for forming a resist underlayer film at a temperature of 100°C or higher to 300°C or lower for 10 to 600 seconds to form a resist underlayer film.

The present invention also provides a method for forming a resist underlayer film employed in a semiconductor device manufacturing process, the method comprising:
spin-coating a substrate to be processed with the above-described composition for forming a resist underlayer film; and
heating the substrate coated with the composition for forming a resist underlayer film in an atmosphere having an oxygen concentration of 0.1% or more to 21% or less to form a resist underlayer film.

According to such methods, the crosslinking reaction during formation of the resist underlayer film can be promoted, so that mixing with the resist upper layer film can be more highly suppressed. Furthermore, by adjusting the heating temperature, time, and oxygen concentration appropriately within the above-described ranges, an effect of suppressing pattern collapse of the resist underlayer film suited to the usage can be provided, and in addition, pattern profile adjustment properties of the resist upper layer film can be achieved.

The present invention also provides a method for forming a resist underlayer film employed in a semiconductor device manufacturing process, the method comprising:
spin-coating a substrate to be processed with the above-described composition for forming a resist underlayer film; and
heating the substrate coated with the composition for forming a resist underlayer film in an atmosphere having an oxygen concentration of 0.0001% or more to less than 0.1% to form a resist underlayer film.

According to such a method, the substrate to be processed is not degraded, the crosslinking reaction during formation of the resist underlayer film can be promoted, and intermixing with the upper layer film can be suppressed more highly even when the substrate to be processed contains a material that is unstable to heating under an oxygen atmosphere. Therefore, such a method is useful.

### ADVANTAGEOUS EFFECTS OF INVENTION

As described above, the present invention provides a composition for forming a resist underlayer film that can prevent precipitation during long-term storage and has favorable storage stability. This composition for forming a resist underlayer film makes it possible to remove residues at the bottom of a resist while maintaining the adhesiveness of the resist pattern, and therefore, is extremely useful in a process that requires the formation of a very fine pattern. Meanwhile, according to the inventive methods for forming a resist underlayer film, the composition cures sufficiently on the substrate to be processed, and it is also possible to prevent resist residues resulting from intermixing. The methods are particularly useful in a fine patterning process according to a multilayer resist method in a semiconductor device manufacturing process.

### BRIEF DESCRIPTION OF DRAWINGS

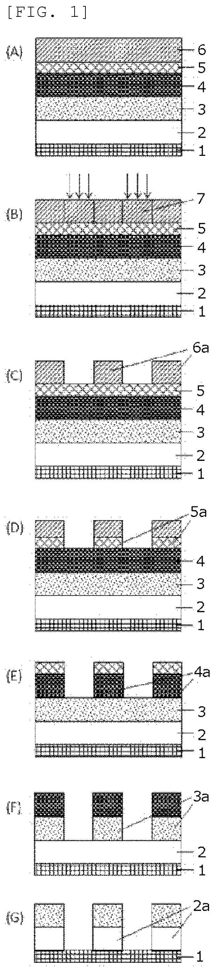

FIG. 1 is an explanatory diagram of an example of an inventive patterning process according to a 4-layer resist process.

### DESCRIPTION OF EMBODIMENTS

In the present description, when an element is described as being "directly under" another element, the element contacts the other element directly, and there is no intervening element. On the contrary, when an element is described as being "under" another element, there may be an intervening element between the elements. Similarly, when an element is described as being "directly on" another element, the element contacts the other element directly, and there is no intervening element. When an element is described as being "on" another element, there may be an intervening element between the elements.

As described above, there have been demands for a composition for forming a resist underlayer film that has favorable storage stability and that also makes it possible to remove residues at the bottom of a resist while maintaining adhesiveness to the resist pattern in a fine patterning process according to a multilayer resist method in a semiconductor device manufacturing process.

The present inventors have earnestly studied the object and found out that the object can be achieved by: a composition for forming a resist underlayer film containing a polymer having a particular structure and a thermal acid generator; a patterning process using the composition for forming a resist underlayer film; and a method for forming a resist underlayer film by using the composition for forming a resist underlayer film. Thus, the present invention has been completed.

That is, the present invention is a composition for forming a resist underlayer film, comprising:
(A) a polymer including a structural unit that includes an organic sulfonyl anion structure and an onium cation structure derived from a sulfur atom, the onium cation structure being pendently bonded to a polymer main chain;
(B) a thermal acid generator; and
(C) an organic solvent,
wherein the polymer (A) and the thermal acid generator (B) each have an identical organic sulfonyl anion molecule.

Hereinafter, the present invention will be described in detail. However, the present invention is not limited thereto.

### [Composition for Forming Resist Underlayer Film]

The present invention provides a composition for forming a resist underlayer film, containing:
(A) a polymer including a structural unit that includes an organic sulfonyl anion structure and an onium cation structure derived from a sulfur atom, the onium cation structure being pendently bonded to a polymer main chain;
(B) a thermal acid generator; and
(C) an organic solvent,
where the polymer (A) and the thermal acid generator (B) each have an identical organic sulfonyl anion molecule.

Incidentally, the inventive composition for forming a resist underlayer film may contain one kind of the polymer (A) or a combination of two or more kinds thereof. However, all the polymers (A) have an anion molecule identical to that in the thermal acid generator (B) .

### [(A) Polymer]

The inventive composition for forming a resist underlayer film contains a polymer (A). It is preferable that the structural unit including the organic sulfonyl anion structure and the onium cation structure derived from a sulfur atom, included in the polymer (A), has a structure represented by the following general formula (1) or (2).

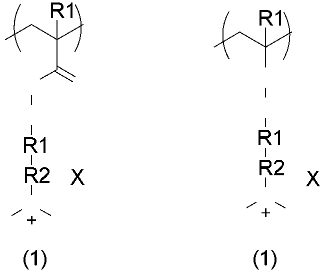

In the formulae, R1 represents a hydrogen atom or a methyl group; R2 represents a substituted or unsubstituted divalent organic group optionally containing an ether bond or an ester bond or represents a single bond; Ar1 and Ar2 each represent a substituted or unsubstituted aromatic ring structure; Ar3 represents a substituted or unsubstituted divalent aromatic ring structure; L1 represents a divalent organic group having 1 to 30 carbon atoms or represents a single bond; X1 represents a nitrogen atom or a carbon atom, each optionally having a substituent, or represents an ether bond, an ester bond, a thioether bond, or a single bond; X⁻ has a structure identical to that of the organic sulfonyl anion molecule included in the thermal acid generator (B); and R2, Ar1, and Ar2 each optionally form a cyclic structure.

In the general formulae (1) and (2), R1 represents a hydrogen atom or a methyl group.

In the general formulae (1) and (2), R2 represents a substituted or unsubstituted divalent organic group optionally containing an ether bond or an ester bond or represents a single bond.

In the general formulae (1) and (2), Ar1 and Ar2 each represent a substituted or unsubstituted aromatic ring structure.

In the general formula (2), Ar3 represents a substituted or unsubstituted divalent aromatic ring structure.

In the general formulae (1) and (2), L1 represents a divalent organic group having 1 to 30 carbon atoms or represents a single bond.

In the general formulae (1) and (2), X1 represents a nitrogen atom or a carbon atom, each optionally having a substituent, or represents an ether bond, an ester bond, a thioether bond, or a single bond.

In the general formulae (1) and (2), X⁻ has a structure identical to that of the organic sulfonyl anion molecule included in the thermal acid generator (B). X⁻ is preferably an organic sulfonyl anion having 9 or more carbon atoms. Furthermore, R2, Ar1, and Ar2 each optionally form a cyclic structure.

As specific examples of the structure represented by the general formula (1), the following structures are preferable. R1, Ar1, Ar2, and X⁻ are as defined above.

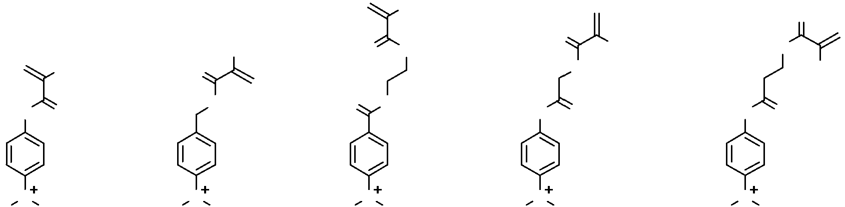

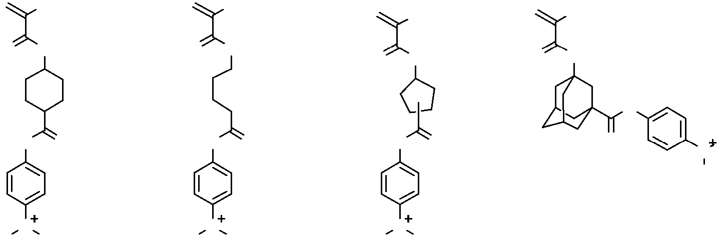

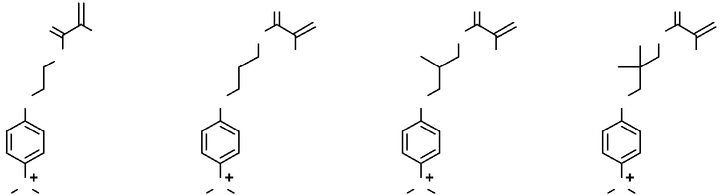

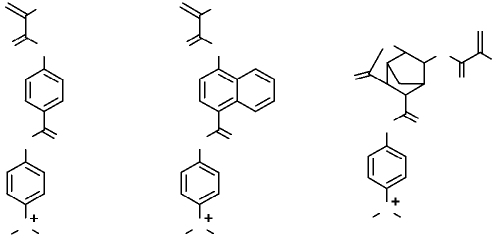

As specific examples of the structure represented by the general formula (2), the following structures are preferable. R1, Ar1, Ar2, and X⁻ are as defined above.

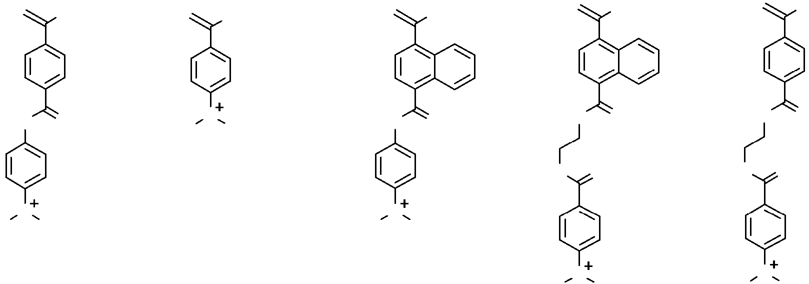

Preferable examples of the structures of the Ar1 and the Ar2 in the general formulae include the following. Here, "*" represents an attachment point to another structure.

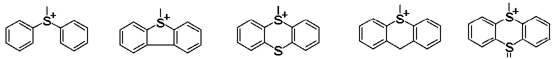

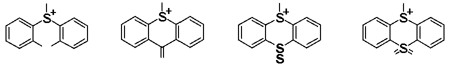

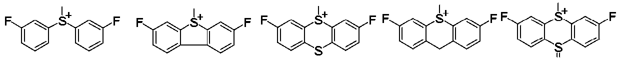

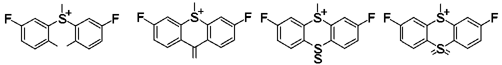

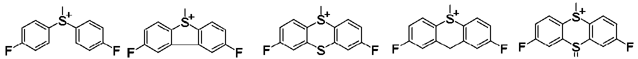

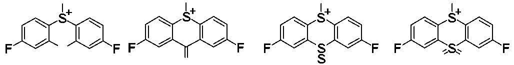

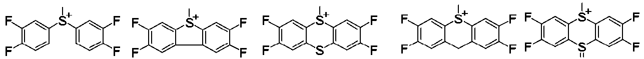

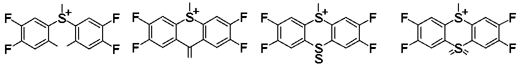

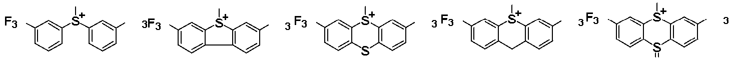

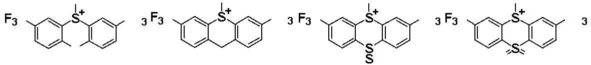

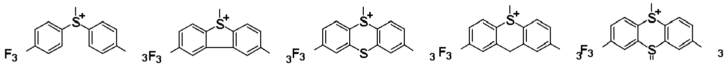

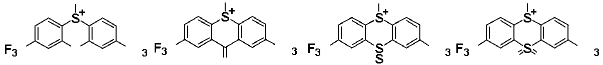

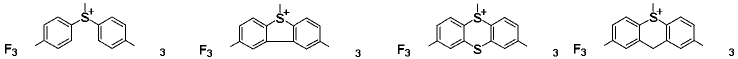

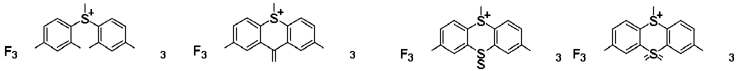

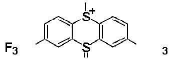

In the general formulae (1) and (2), X⁻ is preferably any of the following general formulae (h1-1) to (h1-3) or a halogen-containing organic sulfonyl anion described later.

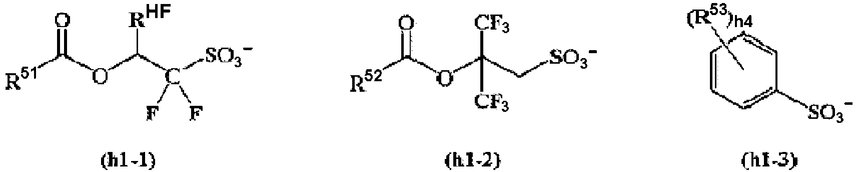

In the general formulae (h1-1) and (h1-2), R⁵¹ and R⁵² each independently represent a hydrocarbyl group having 1 to 40 carbon atoms and optionally containing a heteroatom. R^{HF} represents a hydrogen atom or a trifluoromethyl group. In the general formula (h1-3), R⁵³ represents a hydroxy group, a halogen atom, or a hydrocarbyl group having 1 to 40 carbon atoms and optionally having a heteroatom. "h4" represents an integer of 0 to 5.

Examples of the anion represented by the general formula (h1-1) include ones disclosed in paragraphs [0100] and [0101] of JP2014-177407A and ones represented by the following formulae, but are not limited thereto. Note that, in the following formulae, R^{HF} is as defined above.

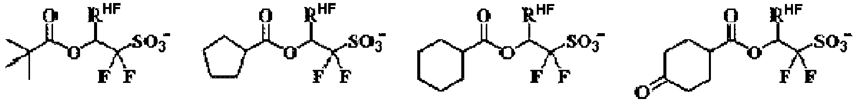

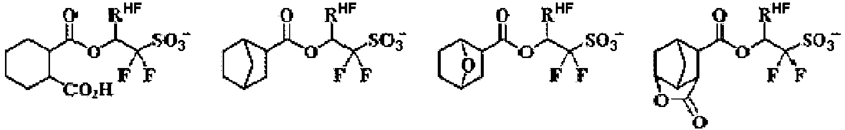

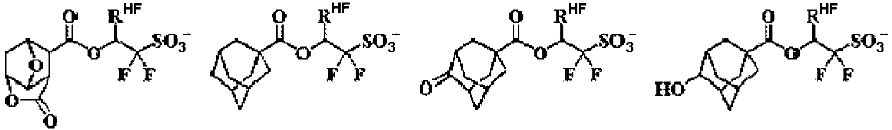

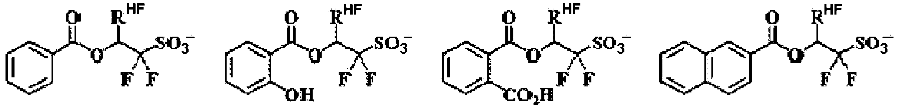

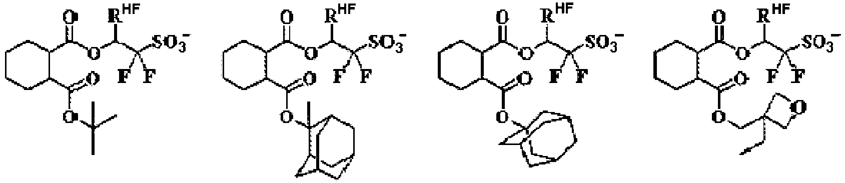

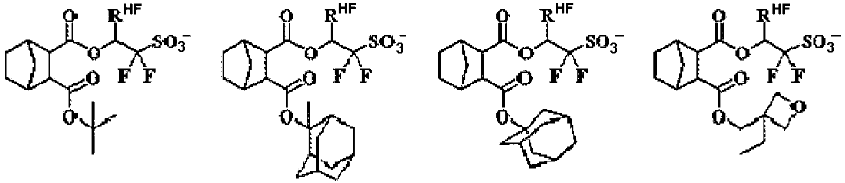

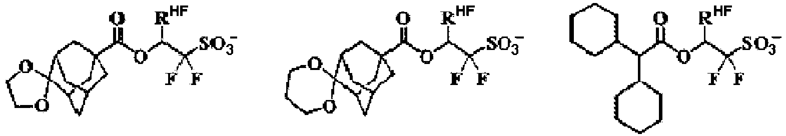

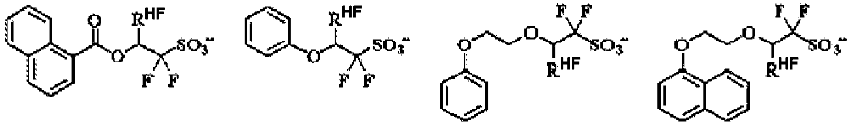

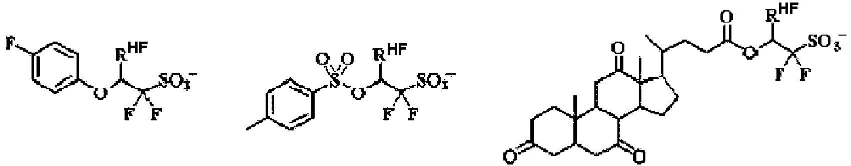

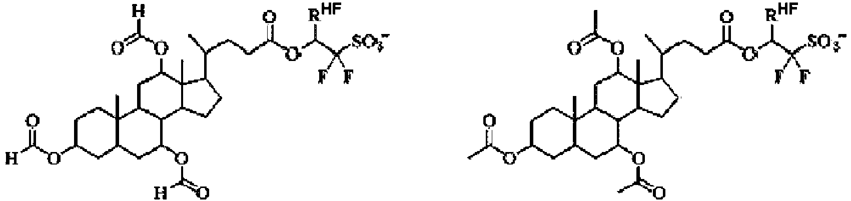

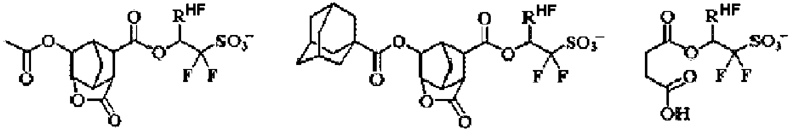

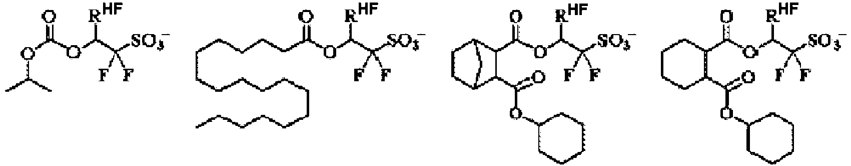

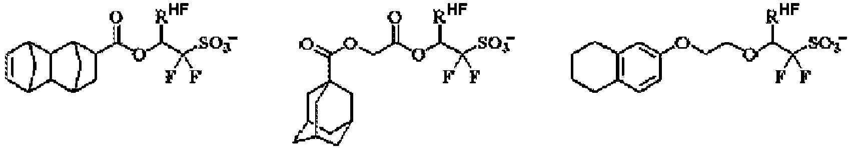

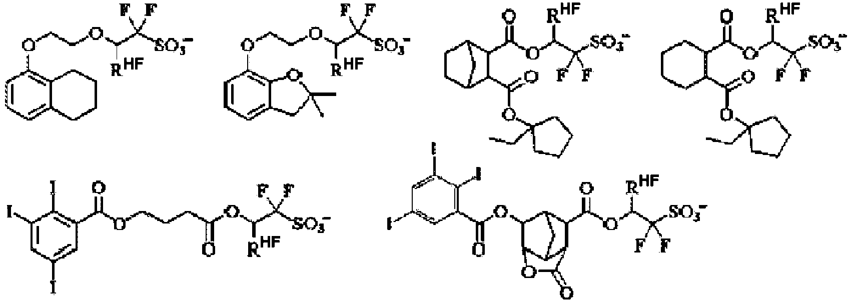

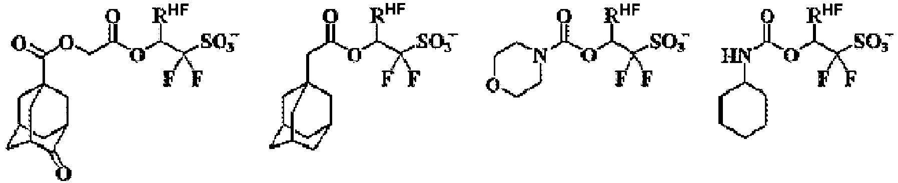

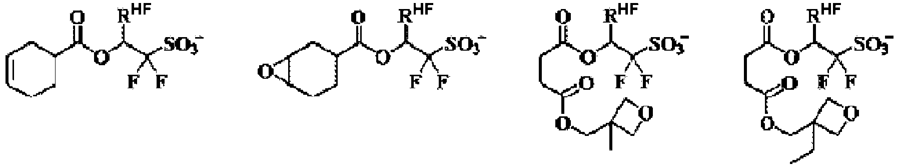

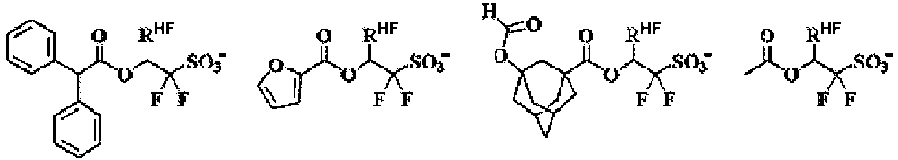

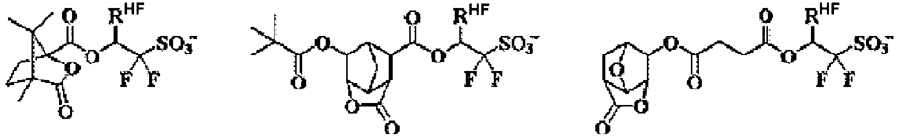

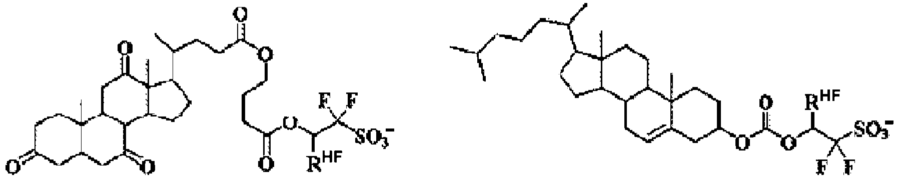

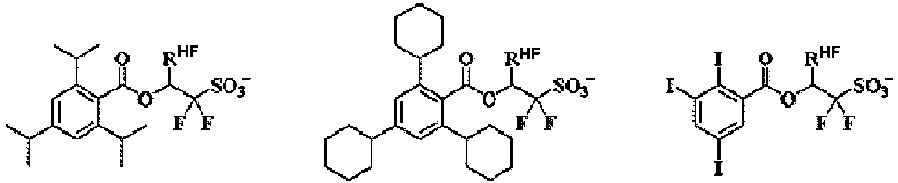

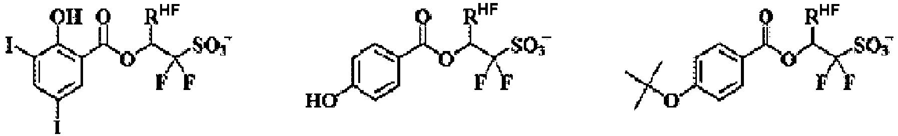

Examples of the anion represented by the general formula (h1-2) include ones disclosed in paragraphs [0080] and [0081] of JP2010-215608A and ones represented by the following formulae, but are not limited thereto. Note that, in the following formulae, Ac represents an acetyl group.

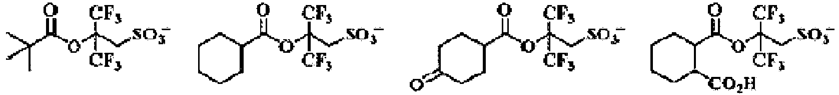

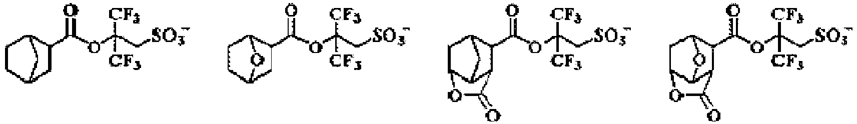

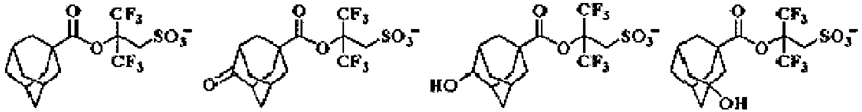

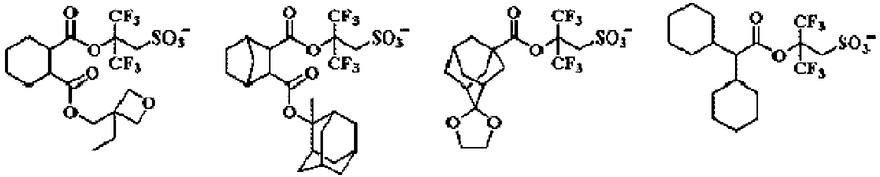

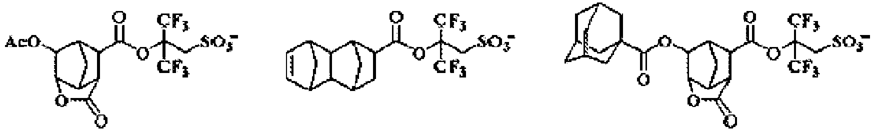

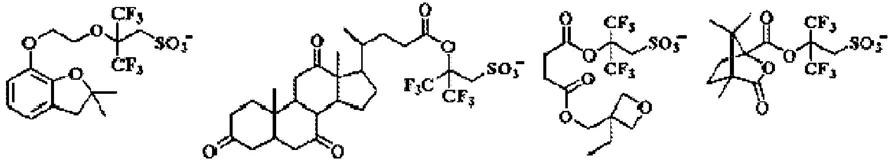

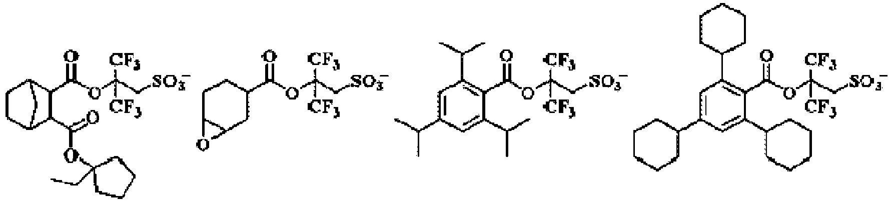

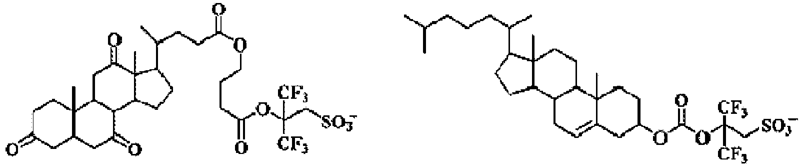

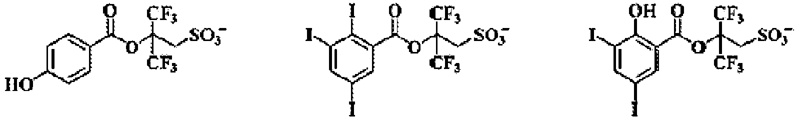

Examples of the anion represented by the general formula (h1-3) include ones represented by the following formulae, but are not limited thereto. Note that, in the following formulae, Me represents a methyl group.

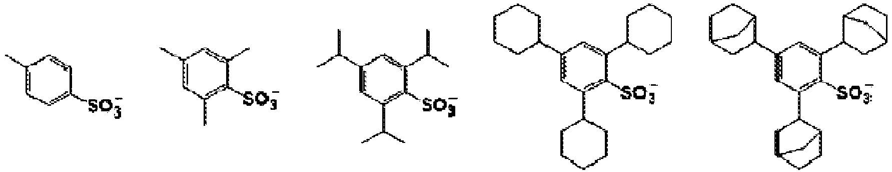

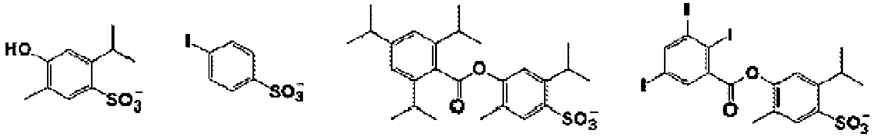

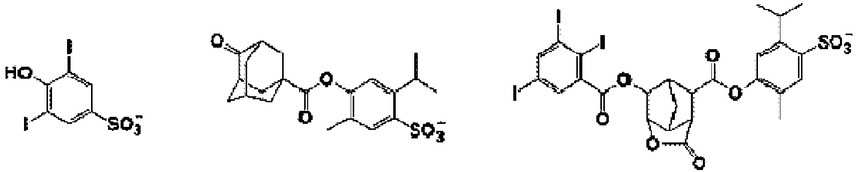

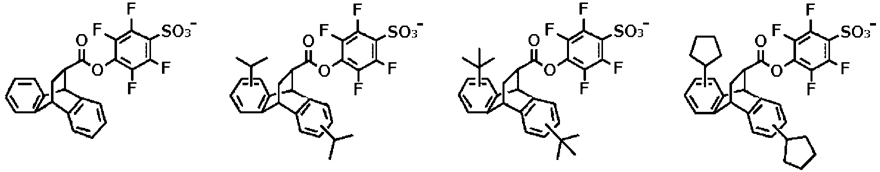

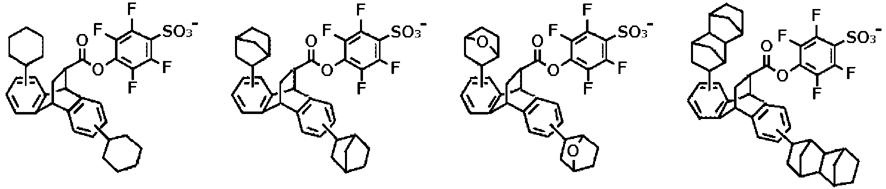

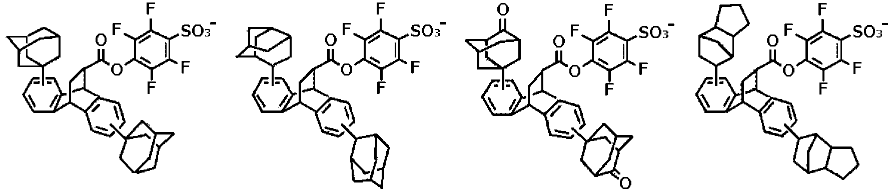

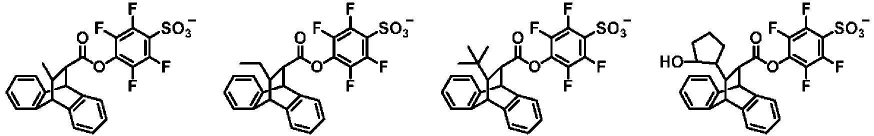

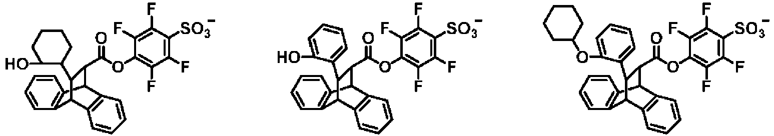

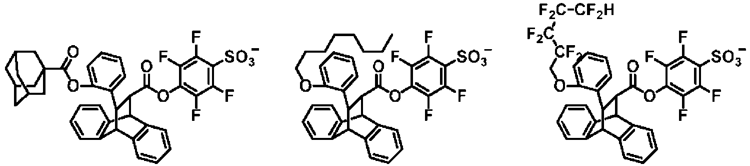

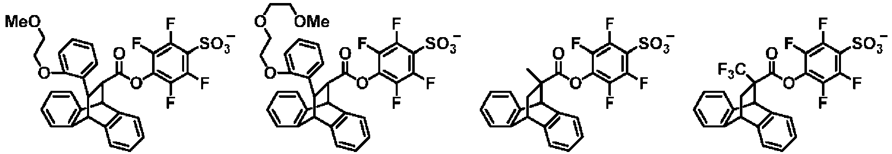

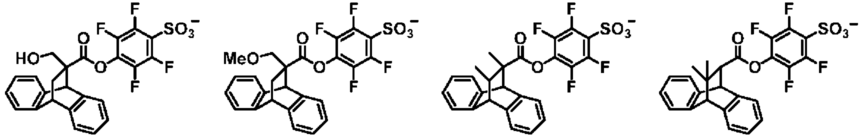

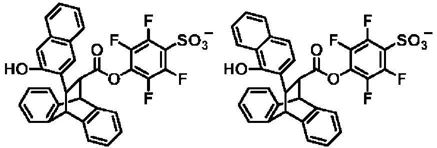

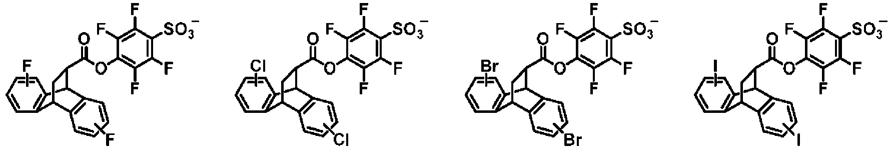

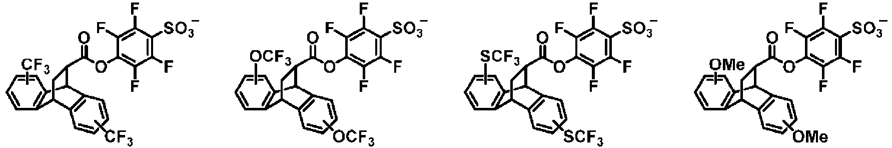

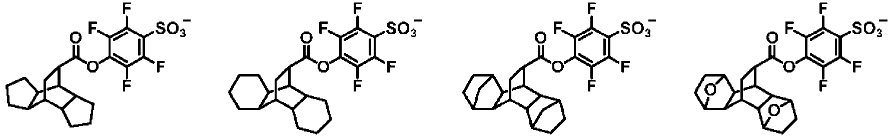

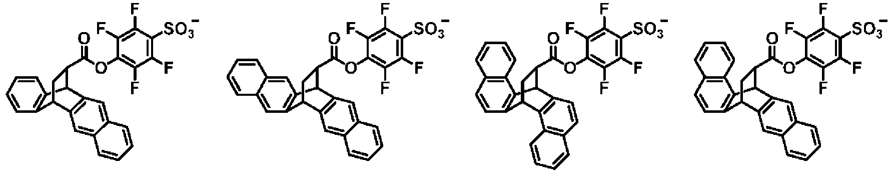

In the present invention, as X⁻, a halogen-containing organic sulfonyl anion, such as those shown below, can be used favorably besides the anions represented by the structures of the general formulae (h1-1) to (h1-3). Here, in the following formulae, X^{BI} represents a bromine atom or an iodine atom.

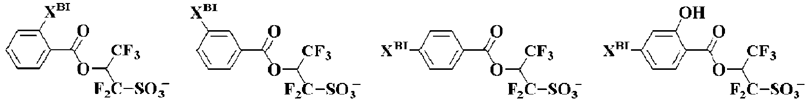

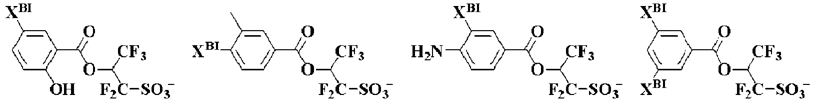

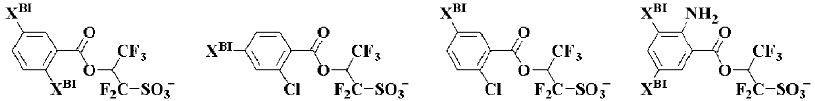

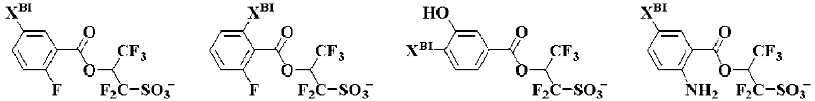

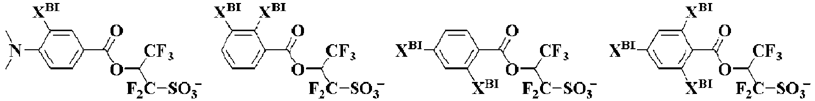

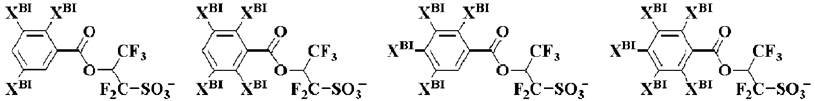

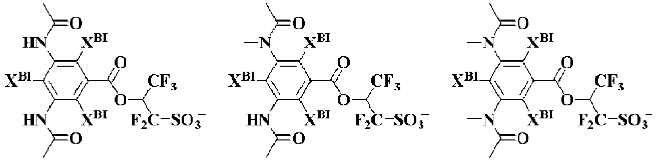

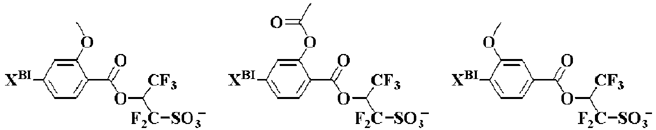

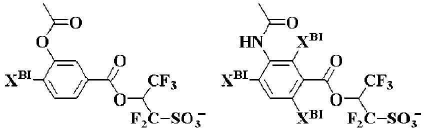

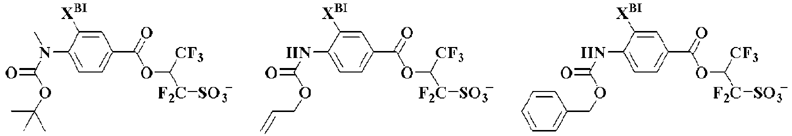

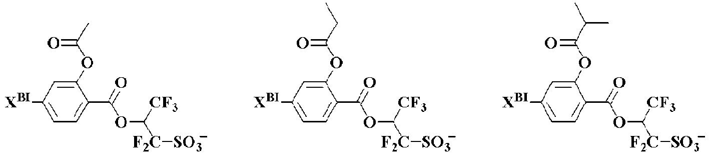

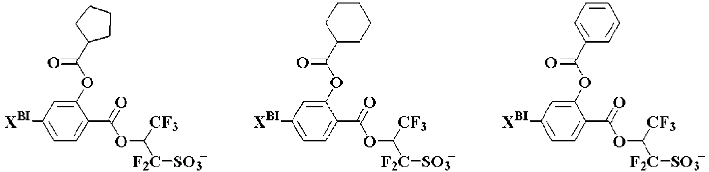

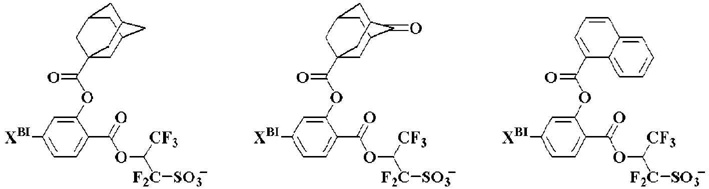

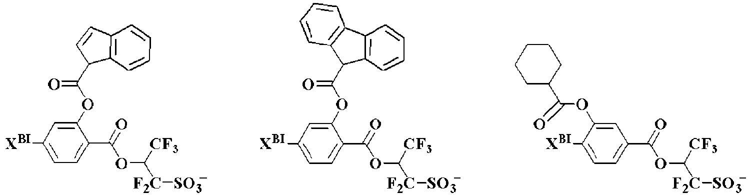

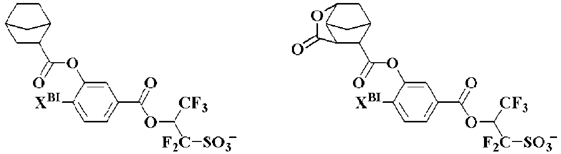

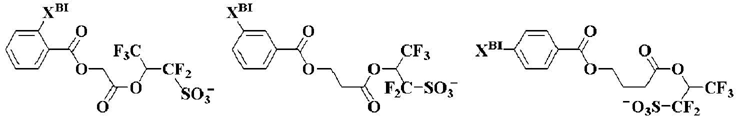

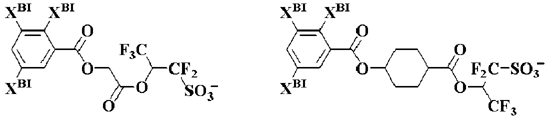

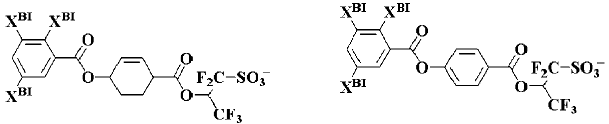

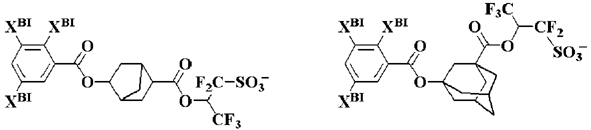

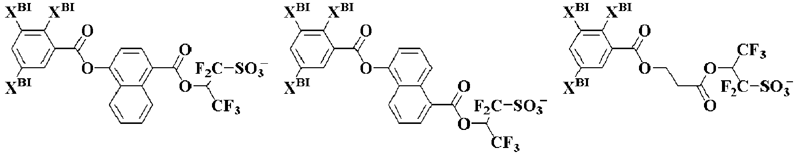

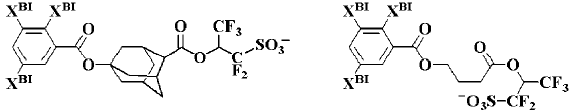

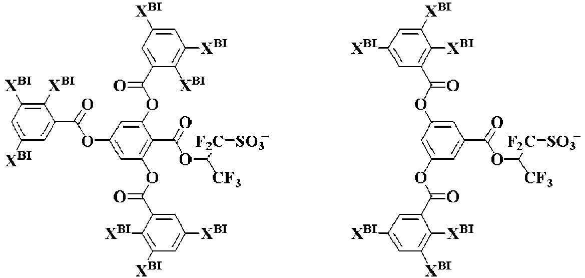

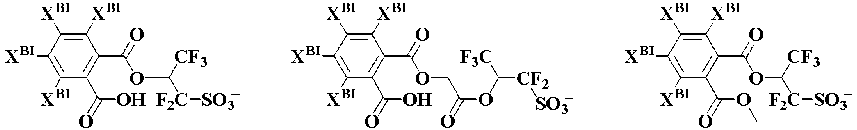

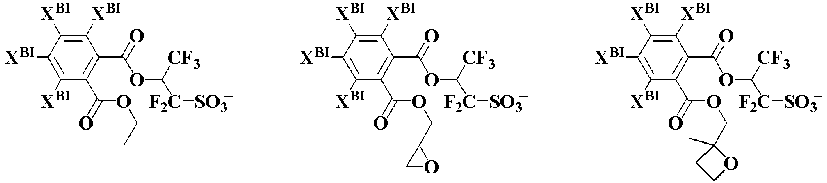

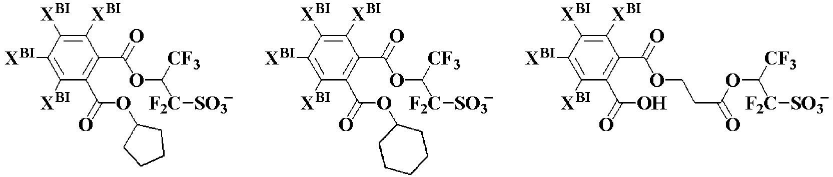

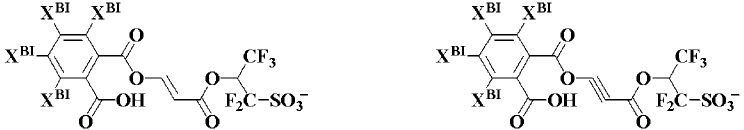

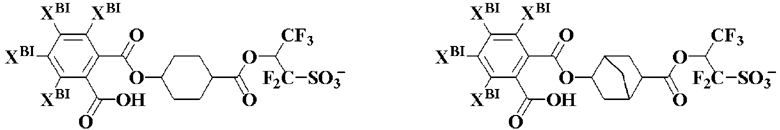

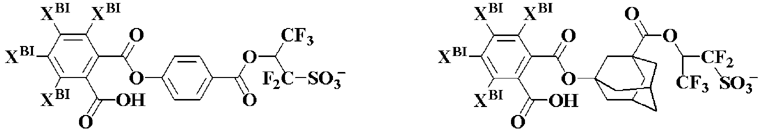

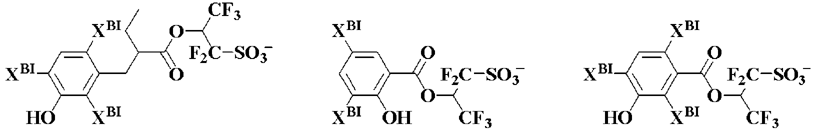

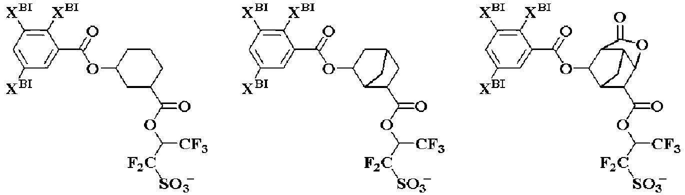

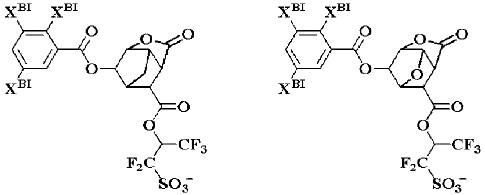

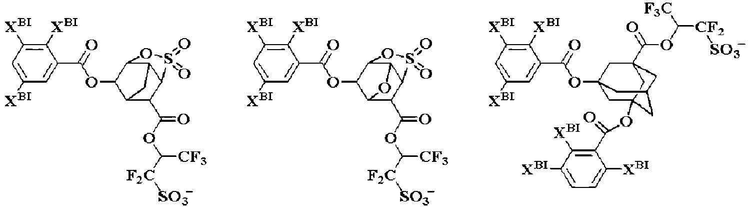

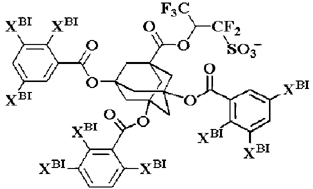

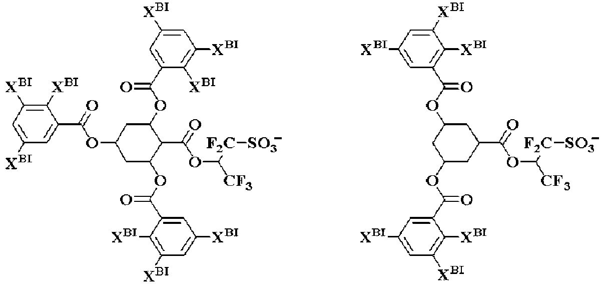

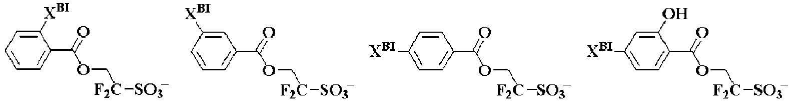

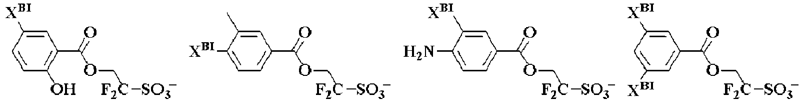

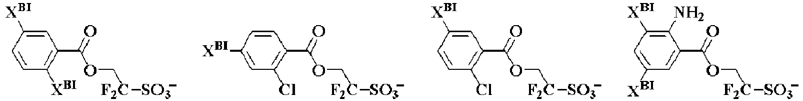

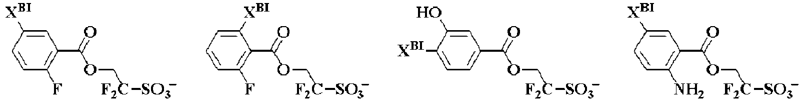

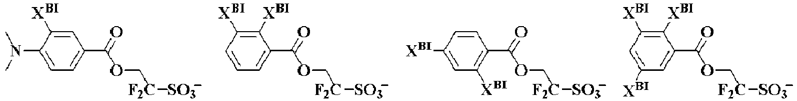

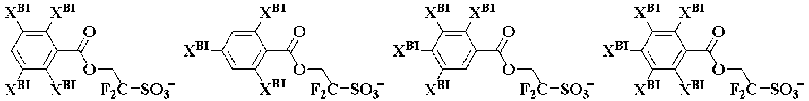

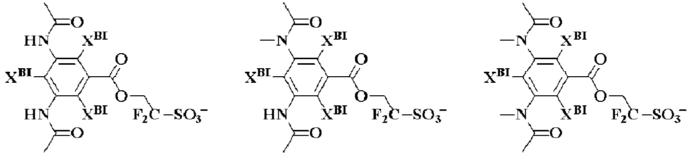

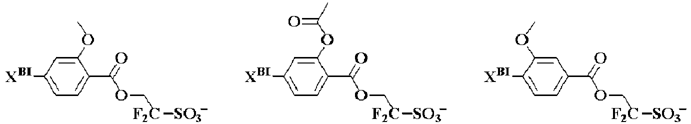

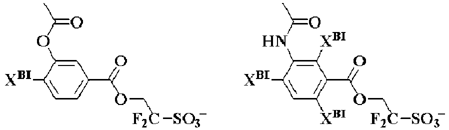

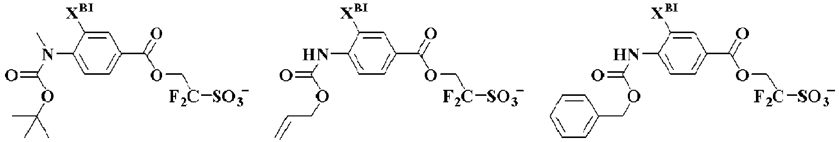

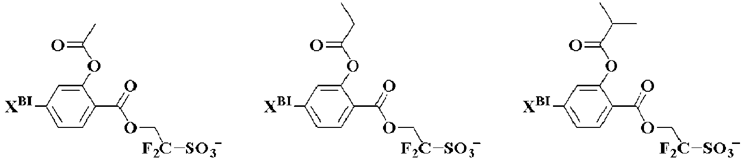

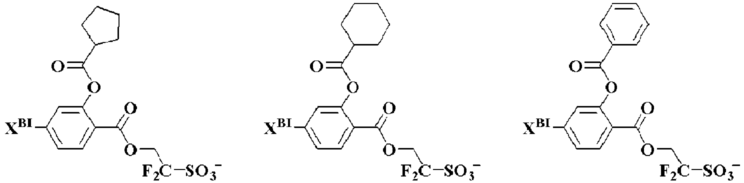

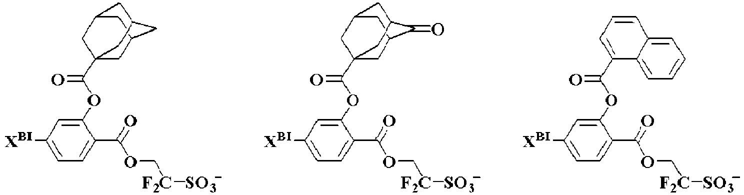

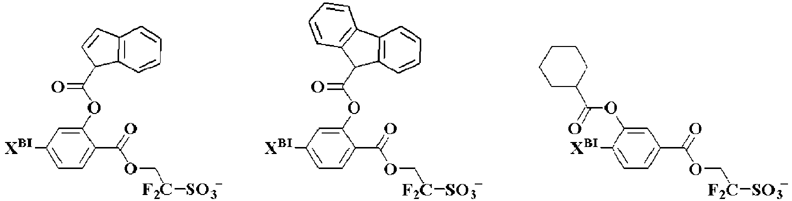

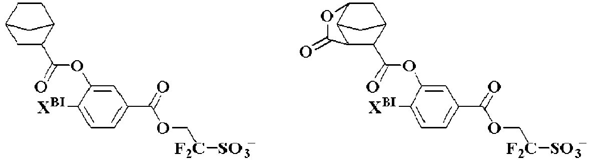

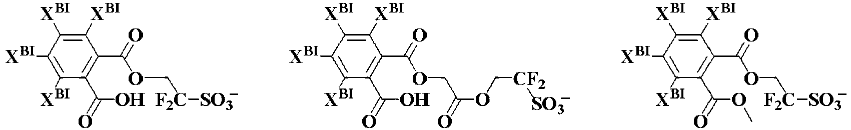

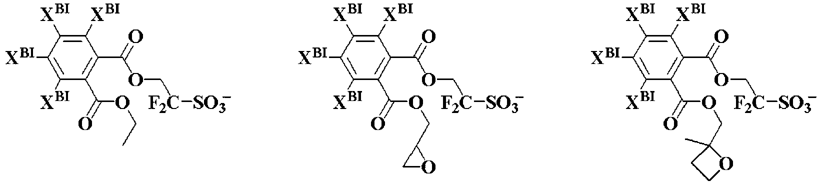

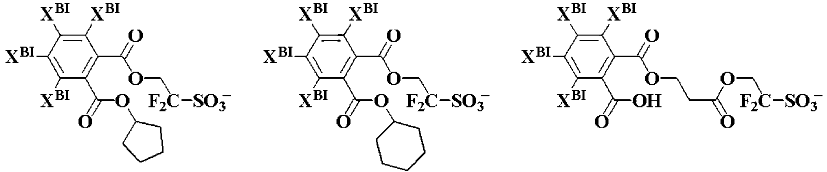

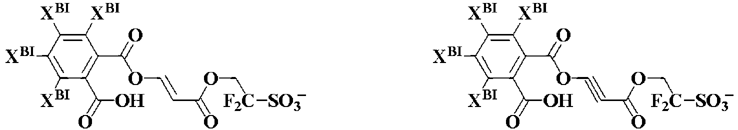

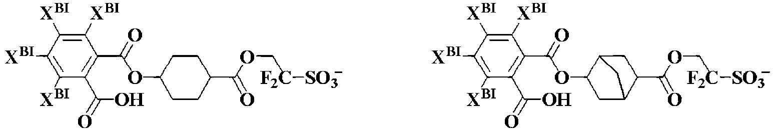

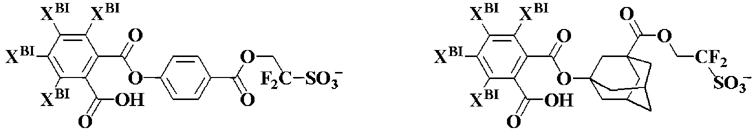

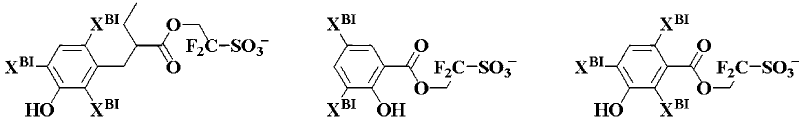

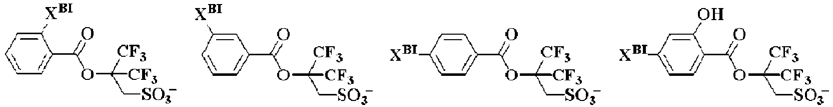

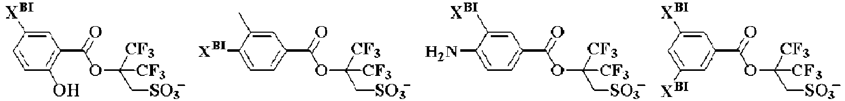

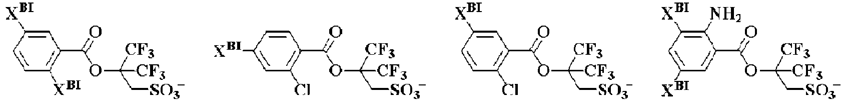

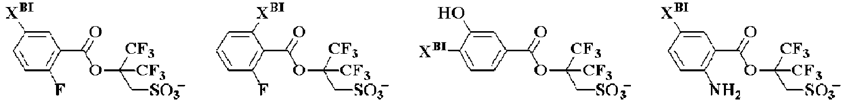

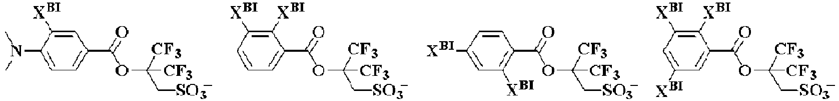

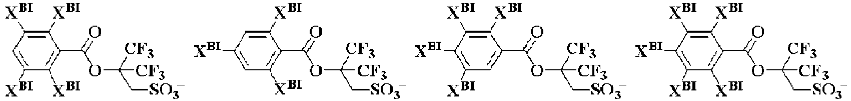

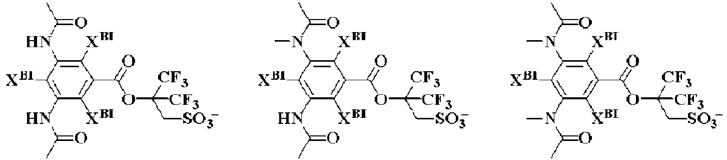

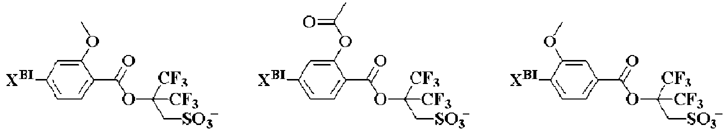

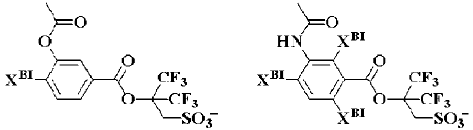

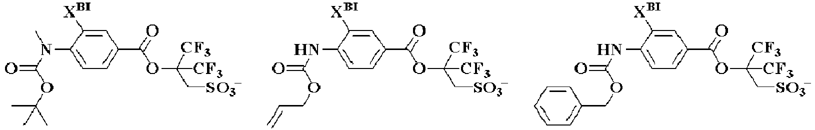

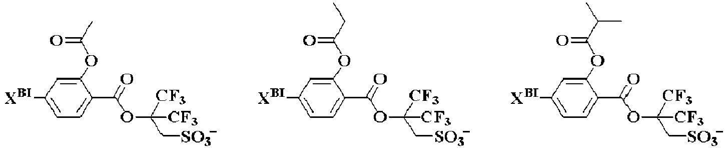

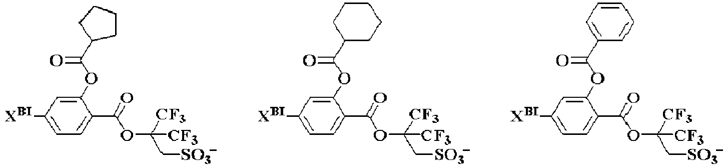

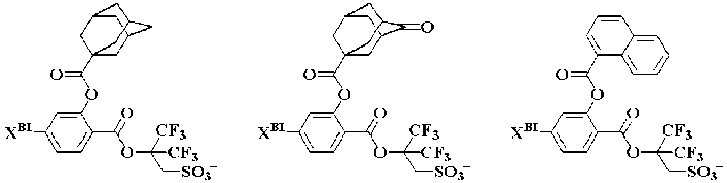

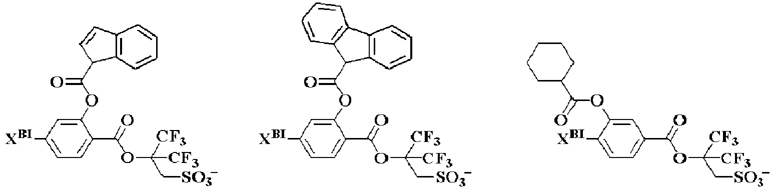

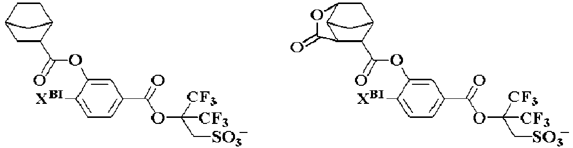

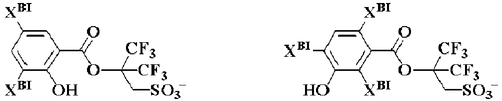

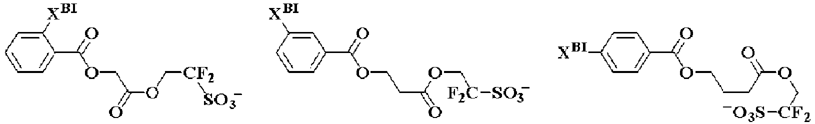

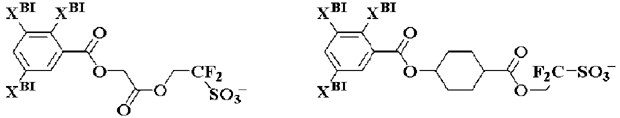

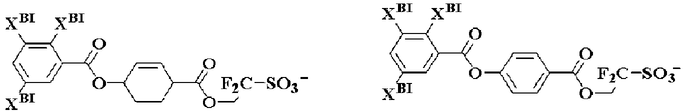

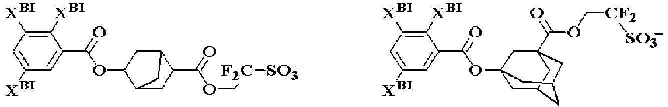

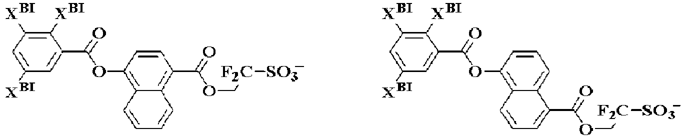

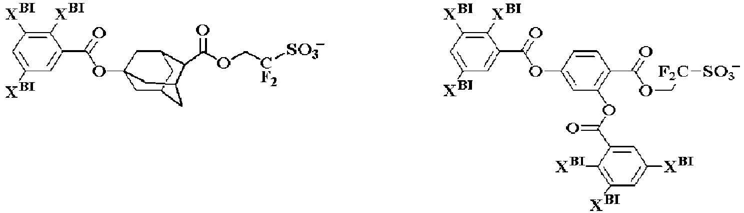

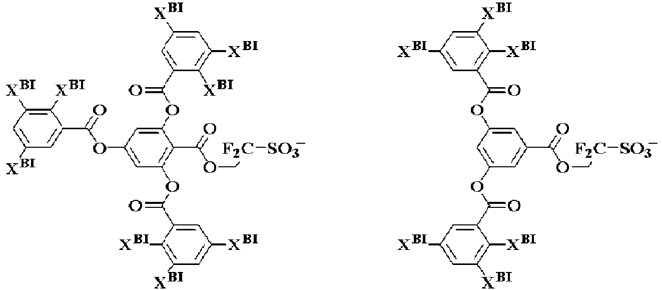

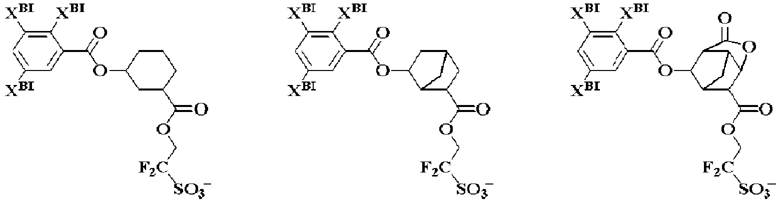

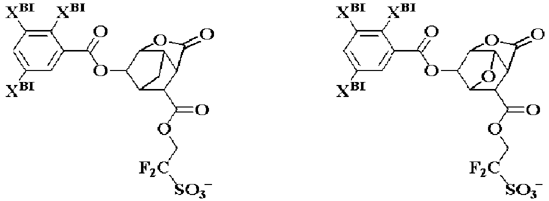

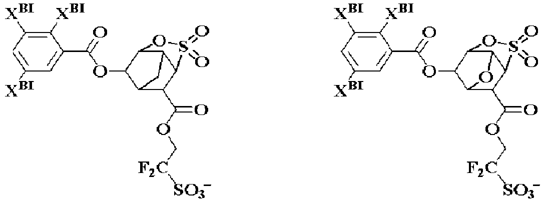

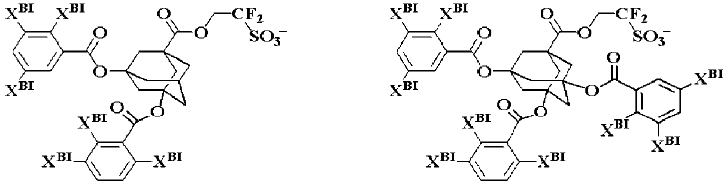

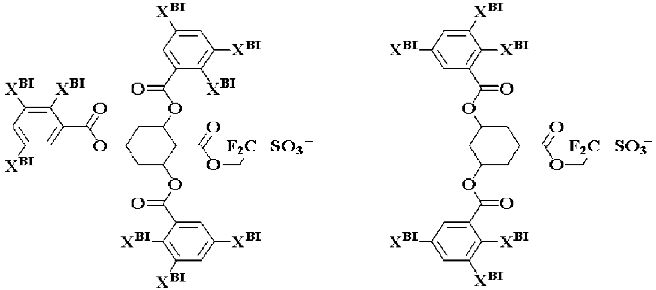

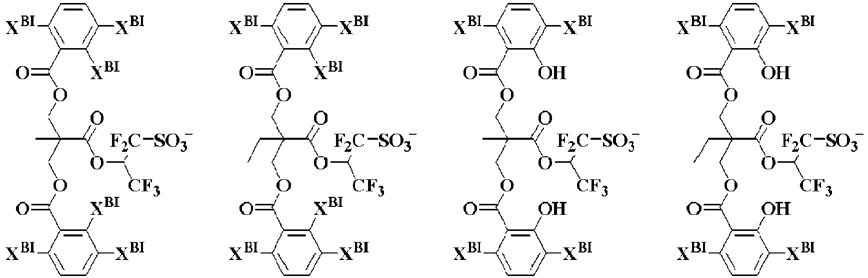

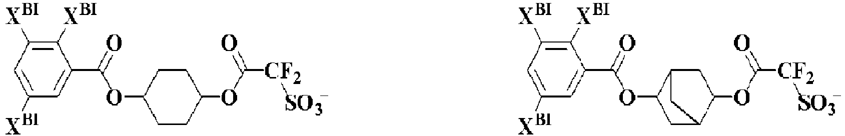

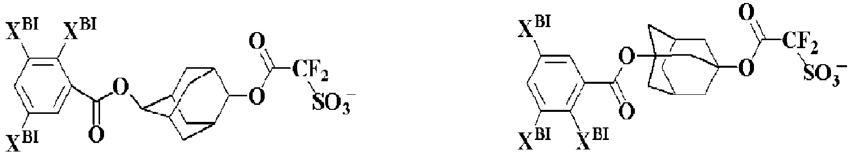

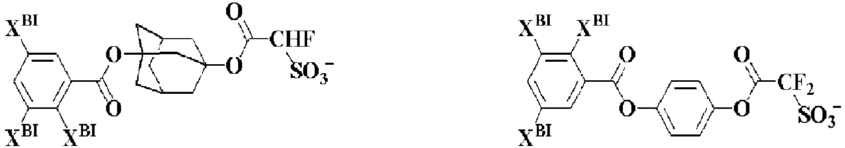

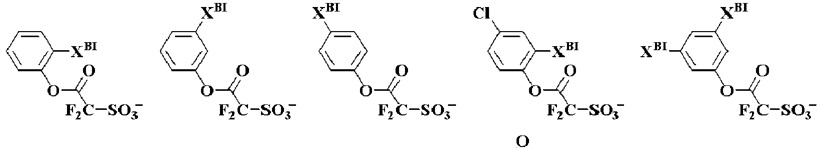

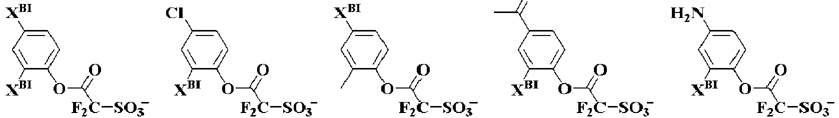

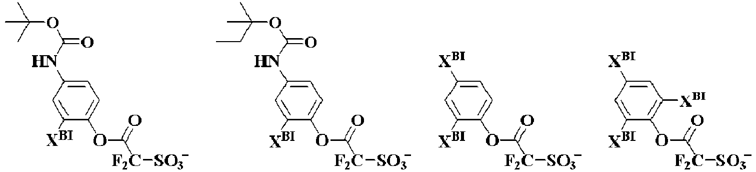

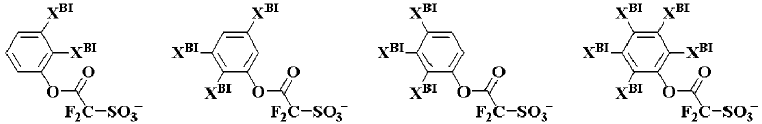

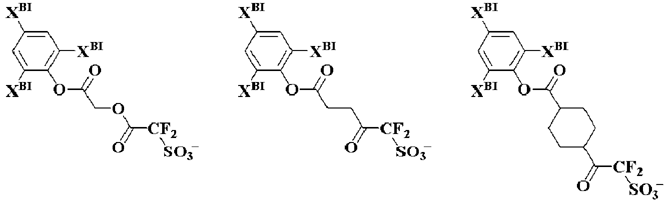

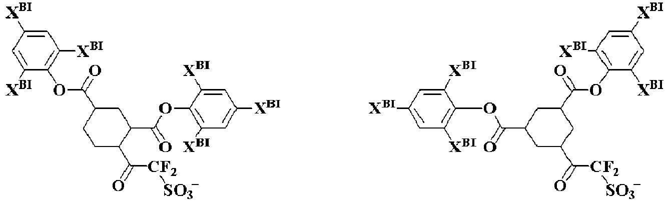

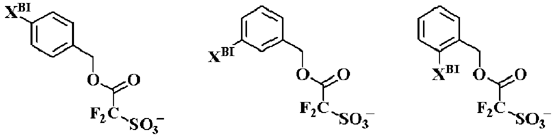

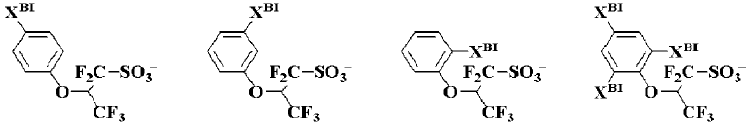

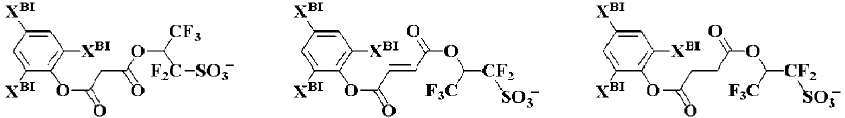

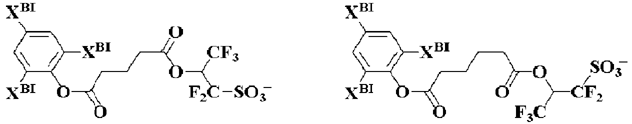

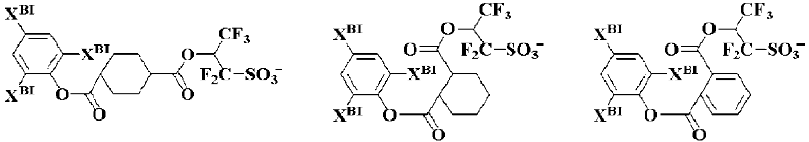

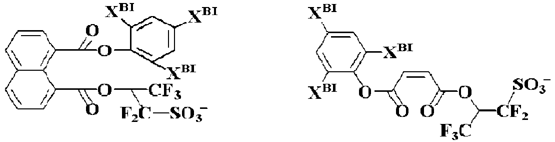

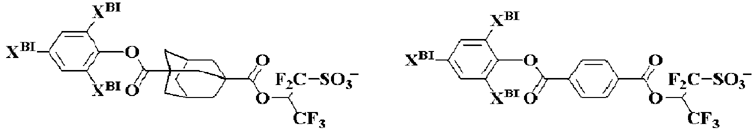

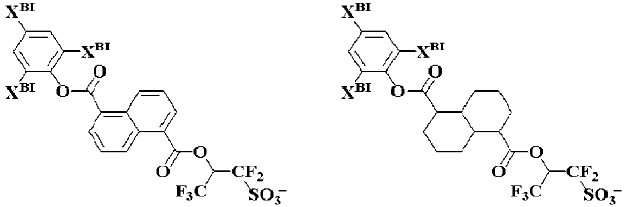

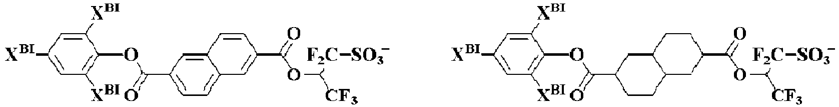

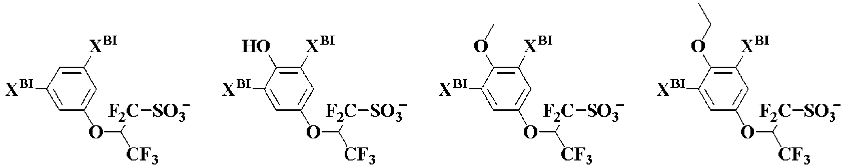

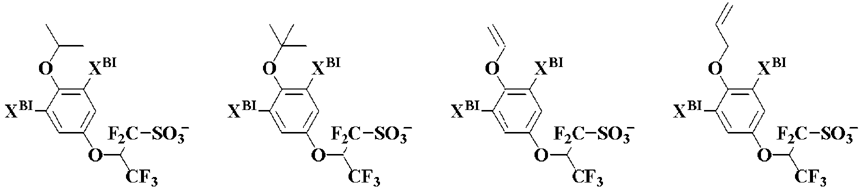

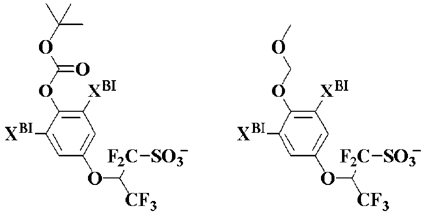

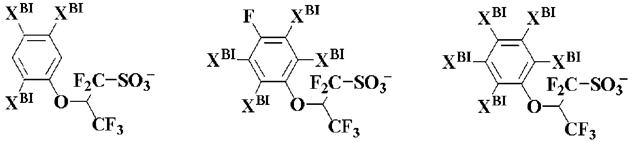

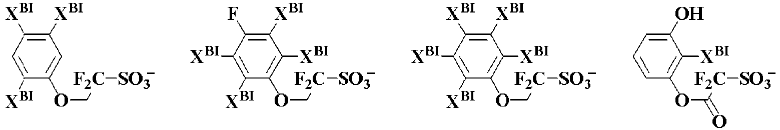

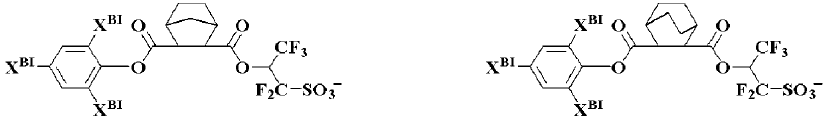

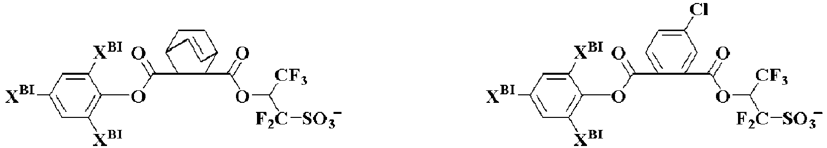

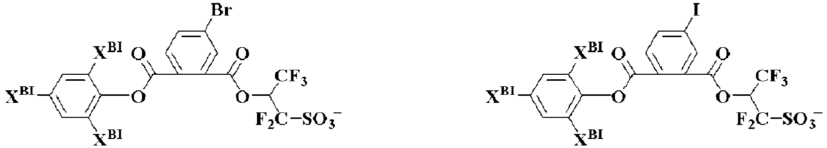

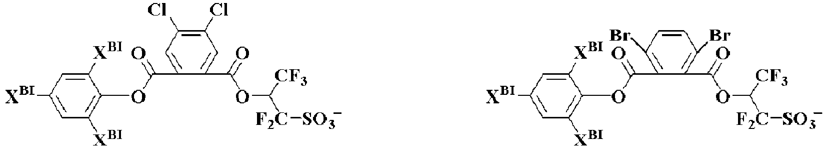

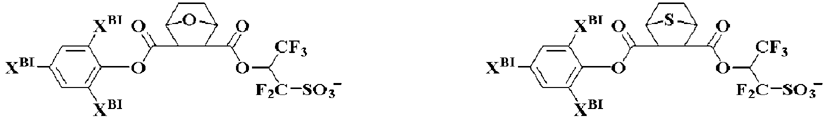

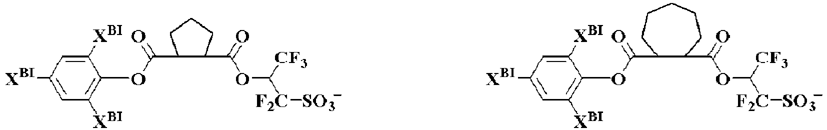

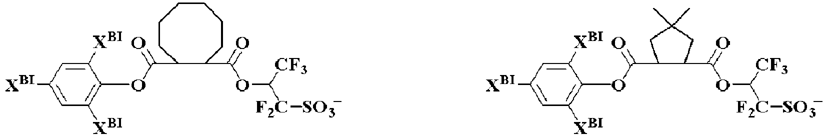

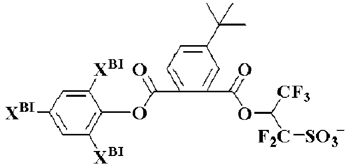

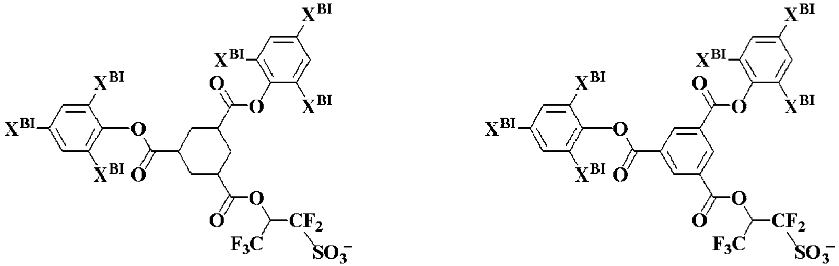

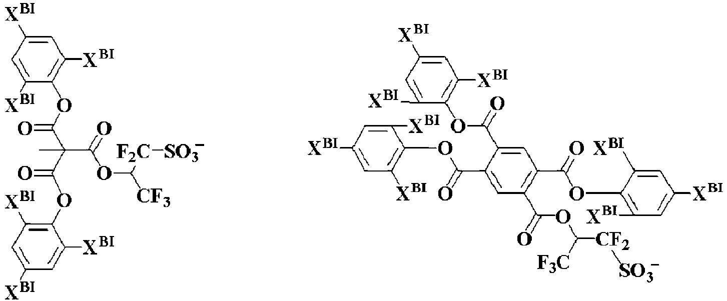

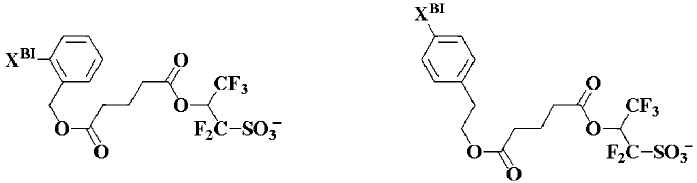

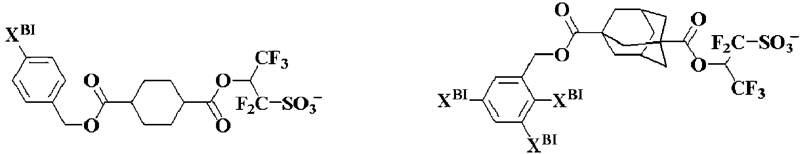

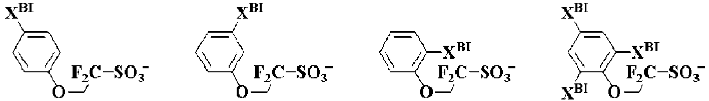

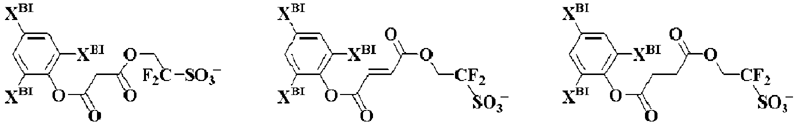

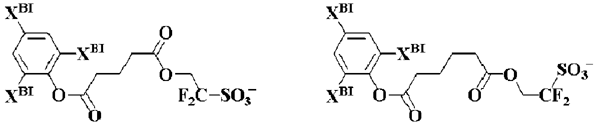

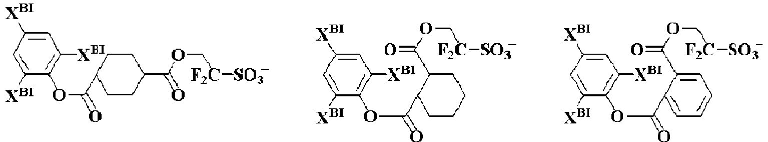

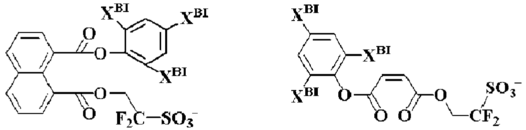

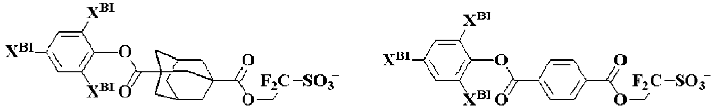

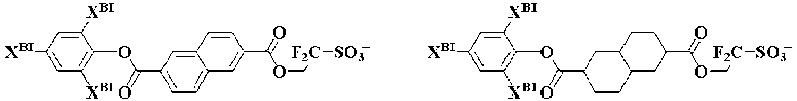

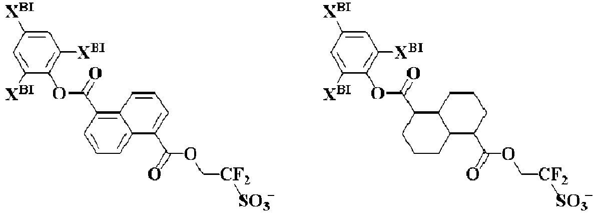

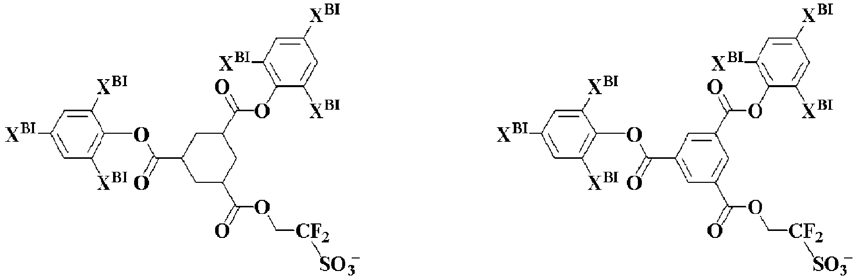

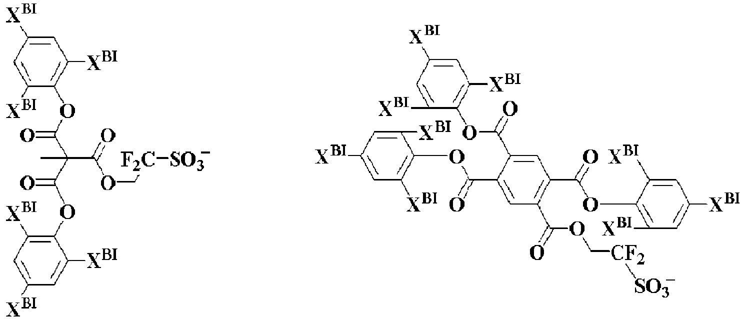

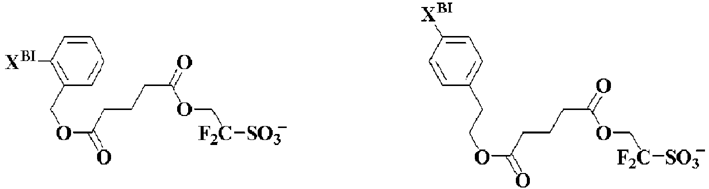

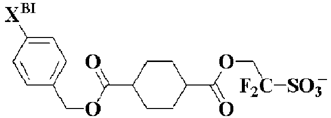

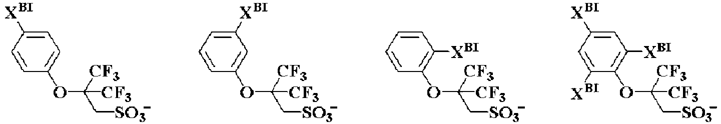

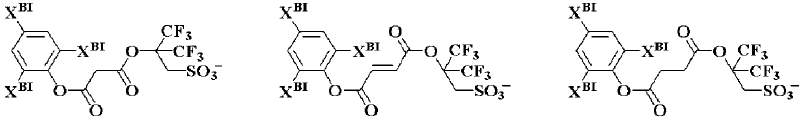

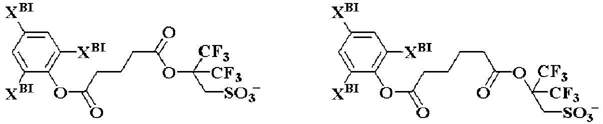

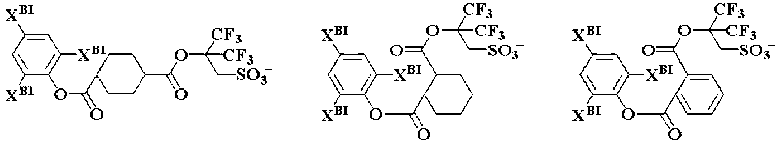

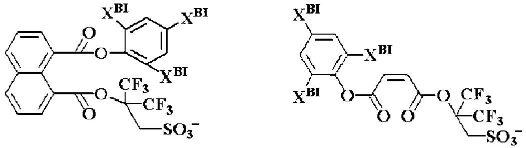

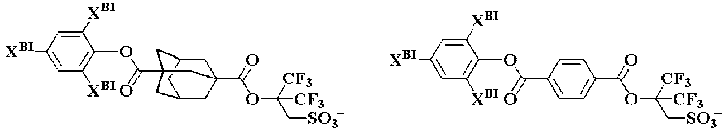

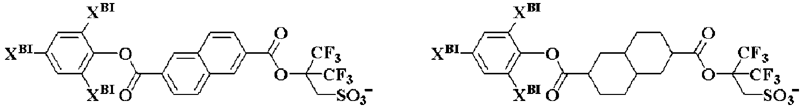

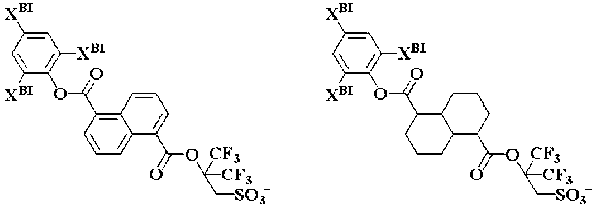

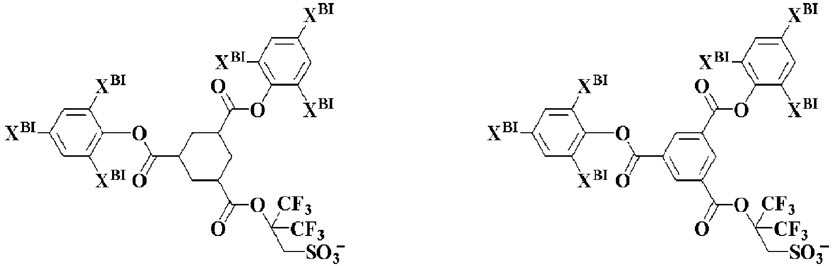

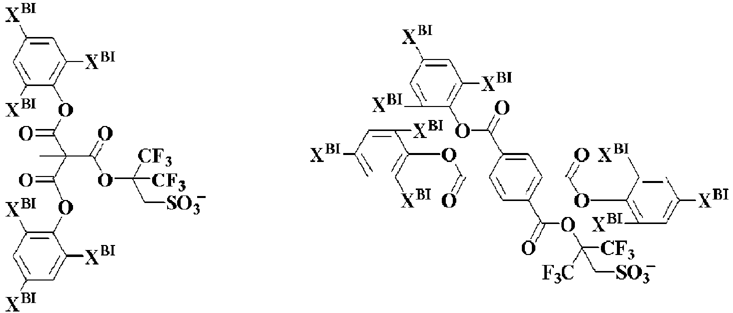

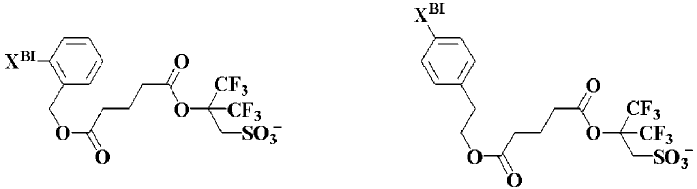

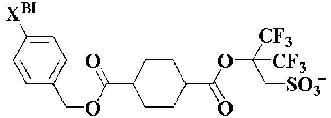

In the present invention, as the X⁻, an anion having a structure identical to that of the organic sulfonyl anion molecule included in the thermal acid generator (B) is used. In this manner, ion exchange in which new ion pairs are formed in the composition after formulation does not occur, and this contributes to the prevention of precipitation during long-term storage. Furthermore, the structure supplies an acid in exposed portions, and this can improve the adhesiveness of the resist when a negative resist composition is used, and can contribute to the removal of residues at the bottom of the resist when a positive resist composition is used. Furthermore, by selecting an anion having a comparatively large number of carbon atoms as X⁻, for example, one having 9 or more carbon atoms, diffusion of this acid can be further suppressed, and increase in pattern roughness can be further suppressed.

Furthermore, it is preferable that the polymer (A) does not include a structural unit that satisfies the following conditions:
contains a total of two or more nitrogen atoms, oxygen atoms, or sulfur atoms, each having an unpaired electron, in a structure excluding an acrylate group or methacrylate group that functions as a polymerizable group, and two or fewer atoms are present between the two nitrogen atoms, oxygen atoms, or sulfur atoms.

In particular, as the structural unit that satisfies the above conditions, it is more preferable that the polymer does not include a structural unit including a partial structure represented by the following general formula (P1) or (P2).

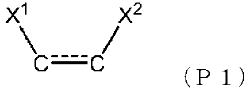

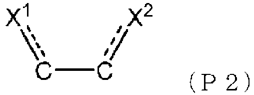

In the formulae, X¹ and X² each independently represent an oxygen atom, a sulfur atom, or a nitrogen atom. The following formula between the C and C in the general formula (P1) and between the X¹ and the lefthand C and between the X² and the right-hand C in the general formula (P2) each independently represent a single bond or a double bond.

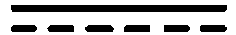

Examples of the partial structure represented by the general formula (P1) or (P2) include the following.

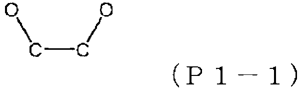

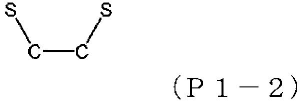

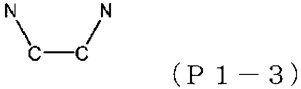

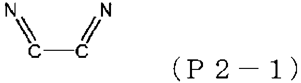

When a structural unit that satisfies the above-described conditions is included, such structures interact strongly with the resist composition, and there is a risk that a residue may occur at the bottom of the resist. To prevent this, it is preferable that such structural units are not contained.

In the general formula (1) or (2), the X⁻ preferably has an alicyclic structure, and further preferably does not contain an aromatic ring.

When a comparatively bulky alicyclic structure is contained, solubility can be improved, and it is possible to prevent precipitation during long-term storage. Furthermore, the diffusion length of the anion is shortened by virtue of the bulky structure, and increase in pattern roughness can be prevented. When an aromatic ring is contained, solubility is slightly degraded by intermolecular interaction caused by stacking, and therefore, it is more preferable that an aromatic ring is not contained.

A ratio of the structural unit including the organic sulfonyl anion structure and the onium cation structure derived from a sulfur atom among structural units of the polymer (A) is preferably 1 mol% or more and 30 mol% or less, more preferably 1 mol% or more and 20 mol% or less.

The above-described structural unit has a salt structure, and the contained amount thereof is preferably small from the viewpoint of the solubility of the polymer.

The polymer (A) preferably has at least one structural unit represented by the following general formula (3), and more preferably includes two or more.

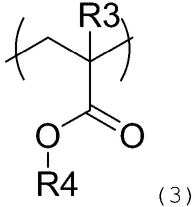

In the formula, R3 represents a hydrogen atom or a methyl group; and R4 represents a group selected from the following formulae (3-1) to (3-3).

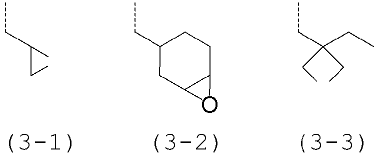

In the formulae, a broken line represents an attachment point.

The above-described structural unit acts as a crosslinking group and also forms a hydroxy group or an ether structure after crosslinking, and these contribute to the improvement of adhesiveness. By using multiple kinds of these structural units and adjusting the composition ratios thereof, it is possible to control the physical properties, such as curability and contact angle, of the film according to conditions of use. Therefore, such a structural unit is preferable in terms of practical use.

Furthermore, in the present invention, the polymer (A) preferably has a weight-average molecular weight of 1,000 to 50,000, more preferably 20,000 to 40,000. Note that the weight-average molecular weight is a value measured in terms of polystyrene or polymethyl methacrylate by gel permeation chromatography (GPC) using, as an eluent, tetrahydrofuran (THF), N,N-dimethylformamide (DMF), or a fluorine-containing solvent such as 1,1,1,3,3,3-hexafluoro-2-propanol.

When the molecular weight is in such a range, it is possible to prevent coating failure due to sublimation of low-molecular-weight components and defects due to high-molecular-weight components, and favorable coating property and defect performance can be achieved.

### [(B) Thermal Acid Generator]

The thermal acid generator (B) contained in the inventive composition for forming a resist underlayer film is not particularly limited as long as the thermal acid generator (B) has an organic sulfonyl anion molecule identical to that of the polymer (A), but preferably has a structure represented by the following general formula (4).

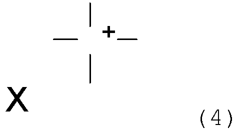

In the formula, X⁻ has a structure identical to that of the organic sulfonyl anion molecule included in the polymer (A). R₈, R₉, R₁₀, and R₁₁ each represent a hydrogen atom, a linear, branched, or cyclic alkyl group, alkenyl group, oxoalkyl group, or oxoalkenyl group each having 1 to 12 carbon atoms, an aryl group having 6 to 20 carbon atoms, or an aralkyl group or aryloxoalkyl group each having 7 to 12 carbon atoms, part or all of the hydrogen atoms of these groups optionally being substituted with an alkoxy group or the like. In addition, R₈ and R₉ or R₈, R₉, and R₁₀ may form a ring. When forming a ring, R₈ and R₉ or R₈, R₉, and R₁₀ represent an alkylene group having 3 to 10 carbon atoms, or a heterocyclic aromatic ring containing the nitrogen atom in the formula therein.

In the general formula (4), R₈, R₉, R₁₀, and R₁₁ may be identical to or different from one another. Specifically, examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, etc. Examples of the alkenyl group include a vinyl group, an allyl group, a propenyl group, a butenyl group, a hexenyl group, a cyclohexenyl group, etc. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, etc. Examples of the oxoalkenyl group include a 2-oxo-4-cyclohexenyl group, a 2-oxo-4-propenyl group, etc. Examples of the aryl group include a phenyl group, a naphthyl group, etc.; alkoxyphenyl groups, such as a p-methoxyphenyl group, an m-methoxyphenyl group, an o-methoxyphenyl group, an ethoxyphenyl group, a p-tert-butoxyphenyl group, and an m-tert-butoxyphenyl group; alkylphenyl groups, such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups, such as a methylnaphthyl group and an ethylnaphthyl group; alkoxynaphthyl groups, such as a methoxynaphthyl group and an ethoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group; etc. Examples of the aralkyl group include a benzyl group, a phenylethyl group, a phenethyl group, etc. Examples of the aryloxoalkyl group include 2-aryl-2-oxoethyl groups, such as a 2-phenyl-2-oxoethyl group, a 2-(1-naphthyl)-2-oxoethyl group, and a 2-(2-naphthyl)-2-oxoethyl group; etc.

In addition, examples of the heterocyclic aromatic ring, the R₈, R₉, R₁₀, and R₁₁ having, in the ring, the nitrogen atom in the formula, include imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperadine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

In the present invention, the X⁻ has a structure identical to that of the organic sulfonyl anion molecule included in the polymer (A). As specific examples of the structure, preferable examples include those given as examples of the X⁻ in the general formulae (1) and (2).

In the present invention one or more kinds of thermal acid generator can be contained as the thermal acid generator (B), and when two or more kinds are contained, it is preferable that all the thermal acid generators have a structure identical to that of the organic sulfonyl anion molecule included in the polymer (A). By selecting such a thermal acid generator, it is possible to prevent the precipitation of components derived from the resin or the thermal acid generator during long-term storage, and not only excellent storage stability but also an effect of suppressing defects caused by precipitates generated at the time of film formation can be expected. Thus, not only storage stability of the composition for forming a resist underlayer film but also a quality improvement effect can be expected.

The amount of the thermal acid generator (B) to be contained is preferably 0.1 to 10 parts by mass, more preferably 0.1 to 3 parts by mass, based on 100 parts by mass of the polymer (A).

### [(C) Organic Solvent]

The organic solvent (C) contained in the inventive composition for forming a resist underlayer film is not particularly limited as long as the organic solvent is capable of dissolving the above-described polymer (A), thermal acid generator (B), and if contained, other additives, etc., but the organic solvent is preferably a mixture of one or more kinds of organic solvent having a boiling point of lower than 150°C and one or more kinds of organic solvent having a boiling point of 150°C or higher and a boiling point of lower than 220°C. Specific examples include organic solvents disclosed in paragraphs [0144] and [0145] of JP2008-111103A including: ketones, such as cyclohexanone, cyclopentanone, methyl-2-n-pentyl ketone, and 2-heptanone; alcohols, such as 3-methoxybutanol, 3-methyl-3-methoxybutanol, 1-methoxy-2-propanol, 1-ethoxy-2-propanol, and diacetone alcohol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones, such as γ-butyrolactone. As the organic solvent having a boiling point of lower than 150°C, preferable are propylene glycol monomethyl ether acetate, propylene glycol monomethyl ether, propylene glycol monoethyl ether, cyclopentanone, and mixtures of two or more kinds thereof. As the organic solvent having a boiling point of 150°C or higher and a boiling point of lower than 220°C, preferable are cyclohexanone, diacetone alcohol, ethyl lactate, γ-butyrolactone, and mixtures of two or more kinds thereof.

The amount of the organic solvent (C) to be contained is preferably 5,000 to 100,000 parts by mass based on 100 parts by mass of the polymer (A).

### [Additives]

The inventive composition for forming a resist underlayer film can further contain at least one kind selected from (D) a surfactant and (E) a crosslinking agent besides the above-described components (A) to (C). By adjusting the kinds and amounts of these materials, it is possible to optimize various properties, such as the curing temperature, coating property, and patterning property, of the composition. In the following, each component will be described.

### [(D) Surfactant]

In the inventive composition for forming a resist underlayer film, a surfactant (D) can be contained so as to enhance the coating property in spin-coating. One kind of the surfactant (D) may be used or two or more kinds thereof may be used in combination. As examples of the surfactant (D), those disclosed in paragraphs [0142] to [0147] of JP2009-269953A can be used. When the surfactant (D) is to be contained, the contained amount is preferably 0.001 to 20 parts by mass, more preferably 0.01 to 10 parts by mass, based on 100 parts by mass of the polymer (A).

### [(E) Crosslinking Agent]

In addition, in the inventive composition for forming a resist underlayer film, a crosslinking agent (E) can also be contained so as to increase curability and to further suppress intermixing with a resist upper layer film. The crosslinking agent is not particularly limited, and known various types of crosslinking agents can be widely used. Examples thereof include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (E) may be used or two or more kinds thereof may be used in combination. When the crosslinking agent (E) is to be contained, the contained amount is preferably 5 to 50 parts by mass, more preferably 10 to 40 parts by mass, based on 100 parts by mass of the polymer (A). When the contained amount is 5 parts by mass or more, sufficient curability can be exhibited, so that intermixing with the resist upper layer film can be suppressed. Meanwhile, when the contained amount is 50 parts by mass or less, there is no risk of adhesiveness degradation due to a decrease in the proportion of the polymer (A) in the composition.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy-and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis(4,5-diphenyl-2-oxazoline), 2,2'-methylenebis(4-phenyl-2-oxazoline), 2,2'-methylenebis(4-tert-butyl-2-oxazoline), 2,2'-bis(2-oxazoline), 1,3-phenylenebis(2-oxazoline), 1,4-phenylenebis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of polynuclear phenol-based crosslinking agents include compounds shown by the following general formula (6).

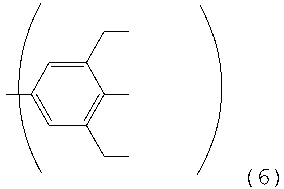

In the formula, Q represents a single bond or a hydrocarbon group with a valency of "q" having 1 to 20 carbon atoms. R₁₄ represents a hydrogen atom or an alkyl group having 1 to 20 carbon atoms. "q" represents an integer of 1 to 5.

In the general formula (6), Q represents a single bond or a hydrocarbon group with a valency of "q" having 1 to 20 carbon atoms. "q" represents an integer of 1 to 5, preferably 2 or 3. Specific examples of Q include groups obtained by removing "q" hydrogen atoms from methane, ethane, propane, butane, isobutane, pentane, cyclopentane, hexane, cyclohexane, methyl pentane, methyl cyclohexane, dimethyl cyclohexane, trimethyl cyclohexane, benzene, toluene, xylene, ethyl benzene, ethyl isopropylbenzene, diisopropylbenzene, methylnaphthalene, ethyl naphthalene, and eicosane. R₁₄ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compound represented by the general formula (6) include the following compounds. In particular, in view of enhancing the curability and film thickness uniformity of the resist underlayer film, hexamethoxymethylated compounds of triphenolmethane, triphenolethane, 1,1,1-tris(4-hydroxyphenyl)ethane, and tris(4-hydroxyphenyl)-1-ethyl-4-isopropylbenzene are preferable.

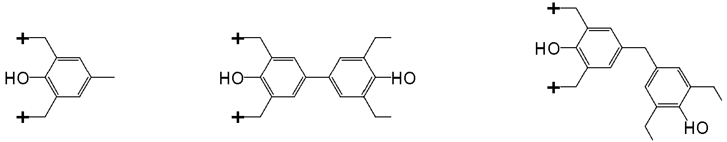

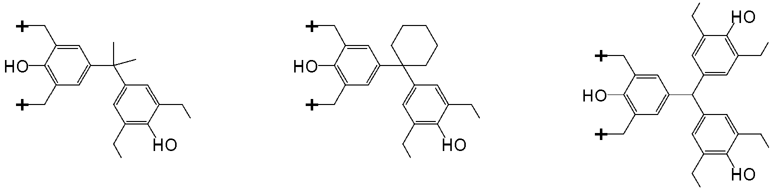

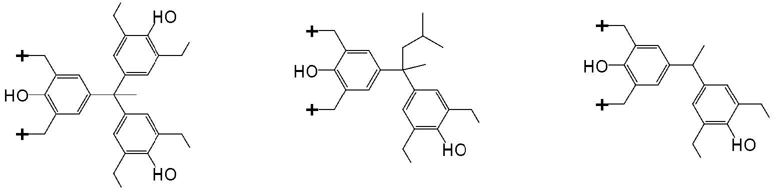

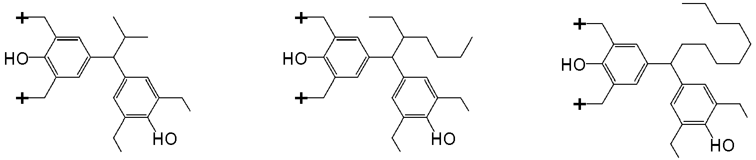

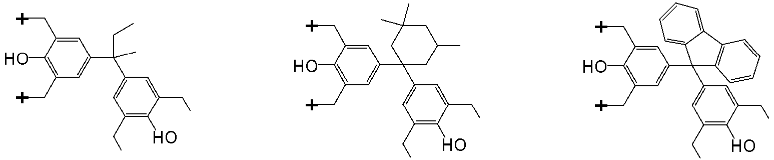

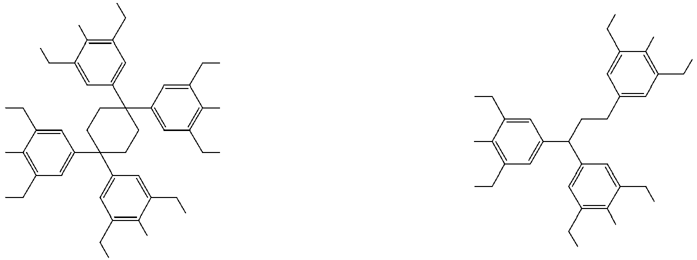

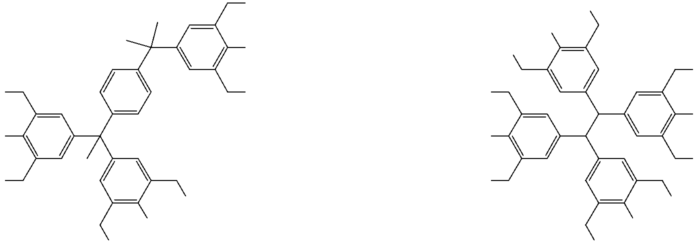

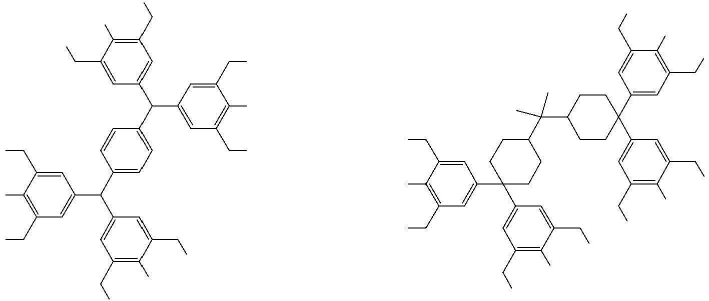

One kind of the crosslinking agent (E) can be used, or two or more kinds thereof can be used in combination. The amount of the crosslinking agent (E) to be contained is preferably 5 mass% to 50 mass%, more preferably 10 mass% to 40 mass%, based on 100 parts by mass of the polymer (A). When the contained amount is 5 mass% or more, sufficient curability can be provided, and intermixing with the resist upper layer film can be suppressed. Meanwhile, when the contained amount if 50 mass% or less, there is no risk of the proportion of the polymer (A) in the composition being too low, and it is possible to obtain sufficiently the benefit of improvement in the lithography performance of the resist by virtue of the organic sulfonyl anion structure in the polymer (A) and so forth.

The thickness of a resist underlayer film obtained from the inventive composition for forming a resist underlayer film is selected appropriately, but is preferably 2 to 100 nm, particularly preferably 5 to 20 nm.

In addition, the inventive composition for forming a resist underlayer film is extremely useful as a resist underlayer film material for multilayer resist processes such as a 2-layer resist process and a 4-layer resist process using an organic film and a silicon-containing middle layer film.

The silicon-containing middle layer film can be a silicon-containing resist middle layer film or an inorganic hard mask middle layer film in accordance with the patterning processes described below. The inorganic hard mask middle layer film is preferably selected from a silicon oxide film, a silicon nitride film, and a silicon oxynitride film.

### [Method for Forming Resist Underlayer Film]

The present invention provides a method for forming, by using the above-described composition for forming a resist underlayer film, a resist underlayer film that makes it possible to improve residues at the bottom of a resist while maintaining favorable resist adhesiveness in a fine patterning process according to a multilayer resist method in a semiconductor device manufacturing process. That is, the present invention provides a method for forming a resist underlayer film employed in a semiconductor device manufacturing process, the method including: spin-coating a substrate to be processed with the above-described composition for forming a resist underlayer film; and heating the substrate coated with the composition for forming a resist underlayer film at a temperature of 100°C or higher to 300°C or lower for 10 to 600 seconds to form a resist underlayer film.

In the inventive method for forming a resist underlayer film, a substrate to be processed is coated with the above-described composition for forming a resist underlayer film by a spin-coating method or the like. After the spin-coating, baking (a heat treatment) is performed in order to evaporate the organic solvent and promote a crosslinking reaction to prevent intermixing with the resist upper layer film or the silicon-containing middle layer film. The baking is preferably performed at 100°C or higher and 300°C or lower for 10 to 600 seconds, more preferably at 200°C or higher and 250°C or lower for 10 to 300 seconds. Considering the effect on damage to the resist underlayer film and deformation of the wafer, the upper limit of the heating temperature in the wafer process of the lithography is preferably set to 300°C or lower, more preferably 250°C or lower.

Alternatively, in the inventive method for forming a resist underlayer film, a resist underlayer film can also be formed by coating a substrate to be processed with the inventive composition for forming a resist underlayer film by a spin-coating method or the like in the same manner as above and curing the composition for forming a resist underlayer film by baking in an atmosphere having an oxygen concentration of 0.1% or more to 21% or less. That is, the present invention provides a method for forming a resist underlayer film employed in a semiconductor device manufacturing process, the method including: spin-coating a substrate to be processed with the above-described composition for forming a resist underlayer film; and heating the substrate coated with the composition for forming a resist underlayer film in an atmosphere having an oxygen concentration of 0.1% or more to 21% or less to form a resist underlayer film. By baking the inventive composition for forming a resist underlayer film in such an oxygen atmosphere, a sufficiently cured resist underlayer film can be obtained.

The atmosphere during the baking may be in air, or an inert gas such as N₂, Ar, and He may also be introduced. In this event, the atmosphere may have an oxygen concentration of 0.0001% or more to less than 0.1%. That is, the present invention provides a method for forming a resist underlayer film employed in a semiconductor device manufacturing process, the method including: spin-coating a substrate to be processed with the above-described composition for forming a resist underlayer film; and heating the substrate coated with the composition for forming a resist underlayer film in an atmosphere having an oxygen concentration of 0.0001% or more to less than 0.1% to form a resist underlayer film. In addition, the baking temperature and so forth can be as described above. The crosslinking reaction during the resist underlayer film formation can be promoted without causing degradation of the substrate to be processed even when the substrate to be processed contains a material that is unstable to heating under an oxygen atmosphere.

### [Patterning Process]

The present invention provides a patterning process for forming a pattern in a substrate to be processed, including the steps of:
(I-1) applying the above-described composition for forming a resist underlayer film on a substrate to be processed and then performing a heat treatment to form a resist underlayer film;
(I-2) forming a resist upper layer film on the resist underlayer film by using a photoresist material;
(I-3) subjecting the resist upper layer film to pattern exposure and then development to form a pattern in the resist upper layer film;
(I-4) transferring the pattern to the resist underlayer film by dry etching while using the resist upper layer film having the formed pattern as a mask; and
(I-5) forming the pattern in the substrate to be processed by processing the substrate to be processed while using the resist underlayer film having the transferred pattern as a mask.

The inventive patterning process will be described with the following 4-layer resist process as an example, but the present invention is not limited to this process. Firstly, the present invention provides a patterning process for forming a pattern in a substrate to be processed, including at least the following steps:
forming an organic film on a substrate to be processed by using an organic film material;
forming a silicon-containing middle layer film (silicon-containing resist middle layer film) on the organic film by using a resist middle layer film material containing a silicon atom;
forming a resist underlayer film on the silicon-containing resist middle layer film by using the inventive composition for forming a resist underlayer film;
forming a resist upper layer film on the resist underlayer film by using a resist upper layer film material (photoresist material) including a photoresist composition so that a multilayer resist film is constructed;
forming a resist upper layer film pattern in the resist upper layer film by exposing a pattern circuit region of the resist upper layer film, and then performing development;
forming a resist underlayer film pattern by etching the resist underlayer film while using the obtained resist upper layer film pattern as an etching mask;
forming a silicon-containing resist middle layer film pattern by etching the silicon-containing resist middle layer film while using the obtained resist underlayer film pattern as an etching mask;
forming an organic film pattern by etching the organic film while using the obtained silicon-containing resist middle layer film pattern as an etching mask; and
further forming the pattern in the substrate to be processed by etching the substrate to be processed while using the obtained organic film pattern as an etching mask.

That is, the present invention provides a patterning process for forming a pattern in a substrate to be processed, including the steps of:
(II-1) forming an organic film on a substrate to be processed;
(II-2) forming a silicon-containing resist middle layer film on the organic film;
(II-3) applying the above-described composition for forming a resist underlayer film on the silicon-containing resist middle layer film and then performing a heat treatment to form a resist underlayer film;
(II-4) forming a resist upper layer film on the resist underlayer film by using a photoresist material;
(II-5) subjecting the resist upper layer film to pattern exposure and then development to form a pattern in the resist upper layer film;
(II-6) transferring the pattern to the resist underlayer film by dry etching while using the resist upper layer film having the formed pattern as a mask;
(II-7) transferring the pattern to the silicon-containing resist middle layer film by dry etching while using the resist underlayer film having the transferred pattern as a mask;
(II-8) transferring the pattern to the organic film by dry etching while using the silicon-containing resist middle layer film having the transferred pattern as a mask; and
(II-9) forming the pattern in the substrate to be processed by processing the substrate to be processed while using the organic film having the transferred pattern as a mask.

As the silicon-containing resist middle layer film in the 4-layer resist process, a polysilsesquioxane-based middle layer film is also favorably used. The silicon-containing resist middle layer film having an antireflective effect can suppress the reflection. Particularly, for 193-nm light exposure, a material containing many aromatic groups and having high substrate etching resistance is used as an organic film, so that the k-value and thus the substrate reflection are increased. However, the reflection can be suppressed by the silicon-containing resist middle layer film, and so the substrate reflection can be reduced to 0.5% or less. As the silicon-containing resist middle layer film having the antireflective effect, a polysilsesquioxane is preferably used, the polysilsesquioxane having anthracene for 248-nm and 157-nm light exposure, or a phenyl group or a light-absorbing group having a silicon-silicon bond for 193-nm light exposure in a pendant structure, and being crosslinked by an acid or heat.

In this case, forming a silicon-containing resist middle layer film by a spin-coating method is simpler and more advantageous regarding cost than a CVD method.

Alternatively, an inorganic hard mask middle layer film may be formed as the silicon-containing middle layer film, and in this case, it is possible to perform at least the following steps:
forming an organic film on the substrate to be processed by using an organic film material;
forming an inorganic hard mask middle layer film selected from a silicon oxide film, a silicon nitride film, and a silicon oxynitride film on the organic film;
forming a resist underlayer film by using the inventive composition for forming a resist underlayer film on the inorganic hard mask middle layer film;
forming a resist upper layer film on the resist underlayer film by using a resist upper layer film material (photoresist material) including a photoresist composition so that a multilayer resist film is constructed;
forming a resist upper layer film pattern in the resist upper layer film by exposing a pattern circuit region of the resist upper layer film, and then performing development;
forming a resist underlayer film pattern by etching the resist underlayer film while using the obtained resist upper layer film pattern as an etching mask;
forming an inorganic hard mask middle layer film pattern by etching the inorganic hard mask middle layer film while using the obtained resist underlayer film pattern as an etching mask;
forming an organic film pattern by etching the organic film while using the obtained inorganic hard mask middle layer film pattern as an etching mask; and
further forming the pattern in the substrate to be processed by etching the substrate to be processed while using the obtained organic film pattern as an etching mask.

That is, the present invention provides a patterning process for forming a pattern in a substrate to be processed, including the steps of:
(III-1) forming an organic film on a substrate to be processed;
(III-2) forming an inorganic hard mask middle layer film selected from a silicon oxide film, a silicon nitride film, and a silicon oxynitride film on the organic film;
(III-3) applying the above-described composition for forming a resist underlayer film on the inorganic hard mask middle layer film and then performing a heat treatment to form a resist underlayer film;
(III-4) forming a resist upper layer film on the resist underlayer film by using a photoresist material;
(III-5) subjecting the resist upper layer film to pattern exposure and then development to form a pattern in the resist upper layer film;
(III-6) transferring the pattern to the resist underlayer film by dry etching while using the resist upper layer film having the formed pattern as a mask;
(III-7) transferring the pattern to the inorganic hard mask middle layer film by dry etching while using the resist underlayer film having the transferred pattern as a mask;
(III-8) transferring the pattern to the organic film by dry etching while using the inorganic hard mask middle layer film having the transferred pattern as a mask; and
(III-9) forming the pattern in the substrate to be processed by processing the substrate to be processed while using the organic film having the transferred pattern as a mask.

In the case where an inorganic hard mask middle layer film is formed on the organic film as described above, a silicon oxide film, a silicon nitride film, and a silicon oxynitride film (SiON film) can be formed by a CVD method, an ALD method, or the like. That is, the inorganic hard mask middle layer film is preferably formed by a CVD method or an ALD method. The method for forming the silicon nitride film is disclosed in, for example, JP2002-334869A and WO2004/066377A1. The film thickness of the inorganic hard mask middle layer film is preferably 5 to 200 nm, more preferably 10 to 100 nm. As the inorganic hard mask middle layer film, a SiON film is most preferably used, being effective as an antireflective coating. When the SiON film is formed, the substrate temperature reaches 300 to 500°C. Hence, the organic film needs to withstand the temperature of 300 to 500°C.

The resist upper layer film in the 4-layer resist process may be a positive type or a negative type, and any generally-used photoresist material can be employed. Furthermore, the resist upper layer film is preferably formed from a photoresist material containing at least an organic metal compound and a solvent. The organic metal compound more preferably contains at least one selected from titanium, cobalt, copper, zinc, zirconium, lead, indium, tin, antimony, and hafnium, but is not limited thereto. Examples of the solvent include 4-methyl-2-pentanol, but are not limited thereto. After spin-coating of the photoresist material, pre-baking is preferably performed at 60 to 180°C for 10 to 300 seconds. Then, light exposure, post-exposure baking (PEB), and development are performed according to conventional methods to obtain the resist upper layer film pattern. Note that the thickness of the resist upper layer film is not particularly limited, but is preferably 30 to 500 nm, and particularly preferably 50 to 400 nm.

When the resist upper layer film is one formed using a photoresist material containing at least an organic metal compound and a solvent, the resist upper layer film has an effect of suppressing fine pattern collapse, and it is also possible to make appropriate adjustments to the pattern profile, exposure sensitivity, etc. of the resist upper layer film. At the same time, it is possible to prevent the organic metal compound from contaminating the substrate to be processed when using the photoresist material containing the organic metal compound and the solvent.

A circuit pattern (resist upper layer film pattern) is formed in the resist upper layer film. As a method for forming a pattern in the resist upper layer film, it is preferable to use a lithography using light having a wavelength of 10 nm or more to 300 nm or less, a direct drawing by electron beam, a nanoimprinting, or a combination thereof.

Note that examples of exposure light include a high-energy beam with a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray of 3 to 20 nm (EUV), electron beam (EB), ion beam, X-ray, etc.

Additionally, in the formation of the circuit pattern, it is preferable to use alkaline development, development using an organic solvent, or development using dry etching as a development method.

Next, etching is performed while using the obtained resist upper layer film pattern as a mask. The etching of the resist underlayer film obtained from the inventive composition for forming a resist underlayer film in the 4-layer resist process is performed by using an oxygen-based gas while using the resist upper layer film pattern as a mask. Thereby, the resist underlayer film pattern is formed.

Subsequently, etching is performed while using the obtained resist underlayer film pattern as a mask. The etching of the silicon-containing resist middle layer film and the inorganic hard mask middle layer film is performed by using a fluorocarbon-based gas while using the obtained resist underlayer film pattern as a mask. Thereby, the silicon-containing resist middle layer film pattern and the inorganic hard mask middle layer film pattern are formed.

The etching of the resist underlayer film may be performed continuously before the etching of the silicon-containing middle layer film. Alternatively, after the resist underlayer film is etched alone, the etching apparatus is changed, for example, and then the etching of the silicon-containing middle layer film may be performed.

Next, the organic film is etched while using the obtained silicon-containing resist middle layer film pattern and inorganic hard mask middle layer film pattern as masks. The etching of the organic film is performed by using oxygen gas or hydrogen gas while using the obtained silicon-containing resist middle layer film pattern or the inorganic hard mask middle layer film pattern as a mask. Thereby, the organic film pattern is formed.

Subsequently, the substrate to be processed can be etched according to a conventional method. For example, the substrate to be processed made of SiO₂, SiN, or silica-based low-dielectric insulating film is etched mainly with a fluorocarbon-based gas; and p-Si, Al, or W is etched mainly with a chlorine- or bromine-based gas. When the substrate is processed by etching with a fluorocarbon-based gas, the silicon-containing middle layer film pattern in the 4-layer resist process is removed when the substrate is processed. When the substrate is etched with a chlorine- or bromine-based gas, the silicon-containing middle layer film pattern needs to be removed by additional dry etching with a fluorocarbon-based gas after the substrate processing.

Note that the substrate to be processed is not particularly limited, and it is possible to use a semiconductor device substrate or the semiconductor device substrate coated with any of a metal film, a metal carbide film, a metal oxide film, a metal nitride film, a metal oxycarbide film, or a metal oxynitride film. As the metal, it is possible to use silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

Specific examples include: substrates made of Si, α-Si, p-Si, SiO₂, SiN, SiON, W, TiN, Al, or the like; the substrate coated with a layer to be processed; etc. Examples of the layer to be processed include: various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, in particular, 100 to 5,000 nm. Note that when the layer to be processed is formed, the substrate and the layer to be processed are formed from different materials.

Hereinbelow, an example of the 4-layer resist process will be specifically described with reference to FIG. 1. As shown in FIG. 1 (A), in the 4-layer resist process, an organic film 3 is formed by using an organic film material on a layer 2 to be processed that has been stacked on a substrate 1. Then, a silicon-containing middle layer film 4 is formed, a resist underlayer film 5 is formed by using the inventive composition for forming a resist underlayer film thereon, and a resist upper layer film 6 is formed thereon.

Next, as shown in FIG. 1 (B), a required portion 7 of the resist upper layer film is exposed to light, followed by PEB and development to form a resist upper layer film pattern 6a (FIG. 1 (C)). While using the obtained resist upper layer film pattern 6a as a mask, the resist underlayer film 5 is etched by using an O₂-based gas. Thereby, a resist underlayer film pattern 5a is formed (FIG. 1 (D)). While using the obtained resist underlayer film pattern 5a as a mask, the silicon-containing middle layer film 4 is etched by using a CF-based gas. Thereby, a silicon-containing middle layer film pattern 4a is formed (FIG. 1 (E)). After the resist underlayer film pattern 5a is removed, the organic film 3 is etched with an O₂-based gas while using the obtained silicon-containing middle layer film pattern 4a as a mask. Thereby, an organic film pattern 3a is formed (FIG. 1 (F)). Furthermore, after the silicon-containing middle layer film pattern 4a is removed, the layer 2 to be processed is etched while using the organic film pattern 3a as a mask. Thus, a pattern 2a is formed (FIG. 1 (G)).

As described above, the inventive patterning processes make it possible to form a fine pattern with high precision in a substrate to be processed in the multilayer resist processes.

### EXAMPLES

Hereinafter, the present invention will be described further specifically with reference to Synthesis Examples, Comparative Synthesis Examples, Examples, and Comparative Examples. However, the present invention is not limited thereto. Note that the molecular weight was measured by gel permeation chromatography (GPC) using tetrahydrofuran (THF), N,N-dimethylformamide (DMF), or a fluorine-containing solvent such as 1,1,1,3,3,3-hexafluoro-2-propanol, as an eluent, the weight-average molecular weight (Mw) and the number-average molecular weight (Mn) were determined in terms of polystyrene or polymethyl methacrylate, and dispersity (Mw/Mn) was calculated therefrom.

Polymers (A1) to (A43) and comparative polymers (R1) to (R4) to be used as a polymer (A) for compositions for forming a resist underlayer film were synthesized using the monomers (B1) to (B22) shown below.

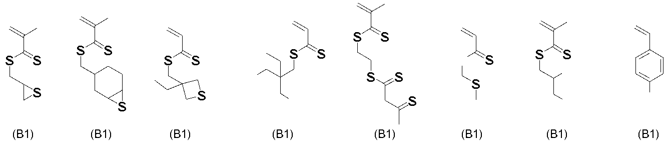

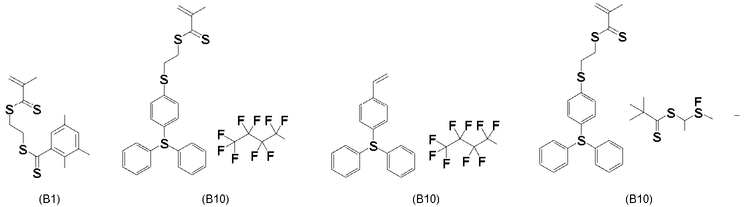

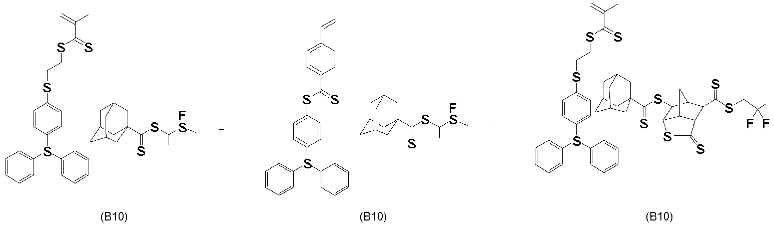

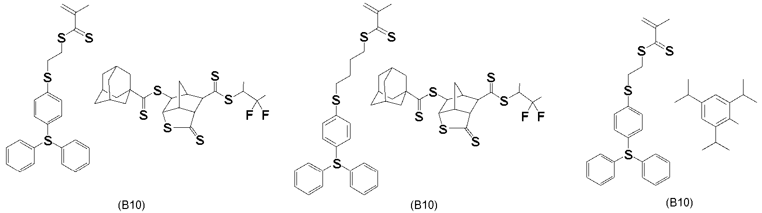

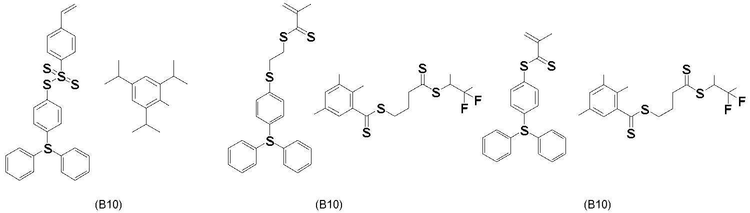

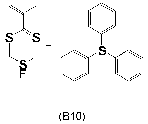

### [Synthesis Example 1] Synthesis of Polymer (A1)

Under a nitrogen atmosphere, 64.9 g of the monomer (B1), 35.1 g of the monomer (B10), 5.84 g of V-601 (Dimethyl 2,2'-Azobis(isobutyrate), available from Wako Pure Chemical Industries Ltd.), and 340 g of DAA (diacetone alcohol) were measured and charged into a 1-L flask. Subsequently, degassing was performed while stirring the mixture to prepare a monomer-polymerization initiator solution. 60 g of DAA was measured and charged into a different 1-L flask having a nitrogen atmosphere. After degassing while stirring, the resultant was heated until the inner temperature reached 80°C. The monomer-polymerization initiator solution was added thereto dropwise over 4 hours. Subsequently, the polymer solution was stirred for 16 hours while maintaining the temperature at 80°C, and then was cooled to room temperature. The obtained polymer solution was added dropwise to 1,500 g of vigorously stirred hexane, and the deposited polymer was collected by filtration. Furthermore, the obtained polymer was washed twice with 600 g of hexane. After that, the polymer was vacuum dried at 50°C for 20 hours to obtain a polymer (A1) in white powder form (yield: 90.2 g, 90%). When the weight-average molecular weight (Mw) and dispersity (Mw/Mn) of the polymer (A1) were measured by GPC, the results were: Mw = 23,400, Mw/Mn = 1.7.

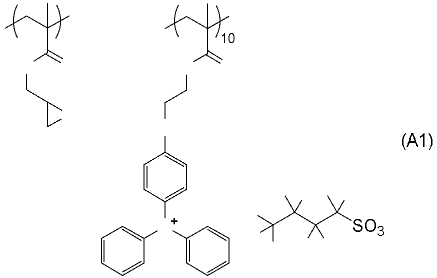

### [Synthesis Examples 2 to 43, Comparative Synthesis

### Examples 1 to 4] Synthesis of Polymers (A2) to (A43) and Comparative Polymers (R1) to (R4)

Except that the kinds of the monomers, the blending ratios of the monomers, and the amount of the polymerization initiator were changed, reaction and post-processing were performed under the same conditions as in Synthesis Example 1 to obtain the polymers (A2) to (A43) and comparative polymers (R1) to (R4) shown in Tables 1 and 2 as products. In addition, the weight-average molecular weight (Mw) and dispersity (Mw/Mn) determined by GPC are shown.

**[Table 1]**

| | Polymer | Monomer 1 | Monomer 1 Proportion (mol%) | Monomer 2 | Monomer 2 Proportion (mol%) | Monomer 3 | Monomer 3 Proportion (mol%) | Monomer 4 | Monomer 4 Proportion (mol%) | Molecular weight (Mw) | Dispersity (Mw/Mn) |
|---|---|---|---|---|---|---|---|---|---|---|---|
| Synthesis Example 1 | (A1) | (B1) | 90 | (B10) | 10 | | | | | 23400 | 1.7 |
| Synthesis Example 2 | (A2) | (B1) | 90 | (B11) | 10 | | | | | 25700 | 1.7 |
| Synthesis Example 3 | (A3) | (B1) | 90 | (B12) | 10 | | | | | 28400 | 1.8 |
| Synthesis Example 4 | (A4) | (B1) | 90 | (B13) | 10 | | | | | 29300 | 1.9 |
| Synthesis Example 5 | (A5) | (B1) | 60 | (B2) | 30 | (B13) | 10 | | | 30600 | 1.9 |
| Synthesis Example 6 | (A6) | (B1) | 30 | (B2) | 60 | (B13) | 10 | | | 31500 | 1.9 |
| Synthesis Example 7 | (A7) | (B2) | 90 | (B13) | 10 | | | | | 32300 | 2 |
| Synthesis Example 8 | (A8) | (B1) | 90 | (B14) | 10 | | | | | 27300 | 1.9 |
| Synthesis Example 9 | (A9) | (B1) | 60 | (B3) | 30 | (B14) | 10 | | | 28600 | 2.0 |
| Synthesis Example 10 | (A10) | (B1) | 30 | (B3) | 60 | (B14) | 10 | | | 29300 | 1.9 |
| Synthesis Example 11 | (A11) | (B3) | 90 | (B14) | 10 | | | | | 30200 | 2.0 |
| Synthesis Example 12 | (A12) | (B3) | 90 | (B14) | 10 | | | | | 15200 | 1.5 |
| Synthesis Example 13 | (A13) | (B1) | 70 | (B4) | 20 | (B15) | 10 | | | 27800 | 1.9 |
| Synthesis Example 14 | (A14) | (B1) | 40 | (B2) | 30 | (B4) | 20 | (B15) | 10 | 28600 | 1.9 |
| Synthesis Example 15 | (A15) | (B1) | 30 | (B2) | 40 | (B4) | 20 | (B15) | 10 | 28800 | 1.9 |
| Synthesis Example 16 | (A16) | (B1) | 70 | (B5) | 20 | (B15) | 10 | | | 28400 | 1.9 |
| Synthesis Example 17 | (A17) | (B1) | 70 | (B6) | 20 | (B15) | 10 | | | 27600 | 1.9 |
| Synthesis Example 18 | (A18) | (B1) | 70 | (B7) | 20 | (B15) | 10 | | | 28200 | 1.8 |
| Synthesis Example 19 | (A19) | (B1) | 70 | (B8) | 20 | (B15) | 10 | | | 28800 | 1.9 |
| Synthesis Example 20 | (A20) | (B1) | 70 | (B9) | 20 | (B15) | 10 | | | 29100 | 1.9 |
| Synthesis Example 21 | (A21) | (B1) | 90 | (B16) | 10 | | | | | 28300 | 1.8 |
| Synthesis Example 22 | (A22) | (B1) | 60 | (B2) | 30 | (B16) | 10 | | | 29200 | 1.8 |
| Synthesis Example 23 | (A23) | (B1) | 30 | (B2) | 40 | (B4) | 20 | (B16) | 10 | 29500 | 1.9 |
| Synthesis Example 24 | (A24) | (B2) | 90 | (B16) | 10 | | | | | 29800 | 1.9 |

**[Table 2]**

| | Polymer | Monomer 1 | Monomer 1 Proportion (mol%) | Monomer 2 | Monomer 2 Proportion (mol%) | Monomer 3 | Monomer 3 Proportion (mol%) | Monomer 4 | Monomer 4 Proportion (mol%) | Molecular weight (Mw) | Dispersity (Mw/Mn) |
|---|---|---|---|---|---|---|---|---|---|---|---|
| Synthesis Example 25 | (A25) | (B2) | 30 | (B3) | 60 | (B16) | 10 | | | 29400 | 1.9 |
| Synthesis Example 26 | (A26) | (B2) | 30 | (B3) | 40 | (B4) | 20 | (B16) | 10 | 29600 | 1.9 |
| Synthesis Example 27 | (A27) | (B1) | 90 | (B17) | 10 | | | | | 27600 | 1.8 |
| Synthesis Example 28 | (A28) | (B1) | 60 | (B3) | 30 | (B17) | 10 | | | 28500 | 1.8 |
| Synthesis Example 29 | (A29) | (B1) | 30 | (B3) | 60 | (B17) | 10 | | | 28700 | 1.9 |
| Synthesis Example 30 | (A30) | (B3) | 90 | (B17) | 10 | | | | | 29300 | 1.9 |
| Synthesis Example 31 | (A31) | (B1) | 30 | (B3) | 40 | (B5) | 20 | (B17) | 10 | 28900 | 1.8 |
| Synthesis Example 32 | (A32) | (B1) | 90 | (B18) | 10 | | | | | 27400 | 1.8 |
| Synthesis Example 33 | (A33) | (B2) | 90 | (B19) | 10 | | | | | 29100 | 1.8 |
| Synthesis Example 34 | (A34) | (B1) | 90 | (B20) | 10 | | | | | 32100 | 2.0 |
| Synthesis Example 35 | (A35) | (B1) | 60 | (B3) | 30 | (B20) | 10 | | | 33400 | 2.0 |
| Synthesis Example 36 | (A36) | (B1) | 30 | (B3) | 60 | (B20) | 10 | | | 34100 | 2.1 |
| Synthesis Example 37 | (A37) | (B3) | 90 | (B20) | 10 | | | | | 34500 | 2.1 |
| Synthesis Example 38 | (A38) | (B1) | 50 | (B4) | 40 | (B20) | 10 | | | 7300 | 1.6 |
| Synthesis Example 39 | (A39) | (B1) | 50 | (B7) | 40 | (B20) | 10 | | | 6800 | 1.6 |
| Synthesis Example 40 | (A40) | (B2) | 90 | (B21) | 10 | | | | | 29400 | 1.9 |
| Synthesis Example 41 | (A41) | (B2) | 60 | (B3) | 30 | (B21) | 10 | | | 29500 | 1.9 |
| Synthesis Example 42 | (A42) | (B2) | 30 | (B3) | 60 | (B21) | 10 | | | 29300 | 1.9 |
| Synthesis Example 43 | (A43) | (B3) | 90 | (B21) | 10 | | | | | 29600 | 1.9 |
| Comparative Synthesis Example 1 | (R1) | (B1) | 100 | | | | | | | 25400 | 1.7 |
| Comparative Synthesis Example 2 | (R2) | (B1) | 70 | (B2) | 30 | | | | | 26300 | 1.8 |
| Comparative Synthesis Example 3 | (R3) | (B1) | 30 | (B3) | 60 | (B22) | 10 | | | 27400 | 1.8 |
| Comparative Synthesis Example 4 | (R4) | (B1) | 30 | (B3) | 50 | (B4) | 20 | | | 26900 | 1.8 |

### [Preparation of Compositions (AL-1 to -52, Comparative AL-1 to -8) for Forming Resist Underlayer Film]

The polymers (A1) to (A43), the comparative polymers (R1) to (R4), the additives (AD1) to (AD10) shown below, propylene glycol monomethyl ether acetate (PGMEA) containing 0.01 mass% of PF636 (available from OMNOVA), diacetone alcohol (DAA), ethyl lactate (EL), and cyclohexanone (CyHO) were used, and the components were dissolved in the proportions shown in Tables 3 and 4. The solution was then filtered through a 0.1-µm filter made of fluorinated resin to prepare each of compositions (AL-1 to -52, comparative AL-1 to -8) for forming a resist underlayer film. Then, it was visually confirmed that no solid was present in the solutions. Incidentally, comparative AL-8 was prepared according to Example 34 described in paragraph [0221] of Patent Document 7. In Tables 3 and 4, the contained amounts are expressed in parts by mass.

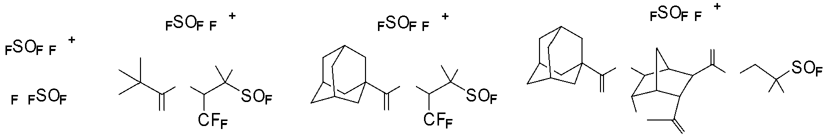

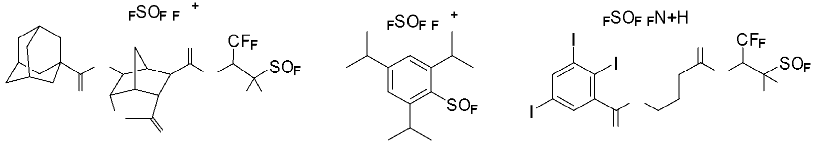

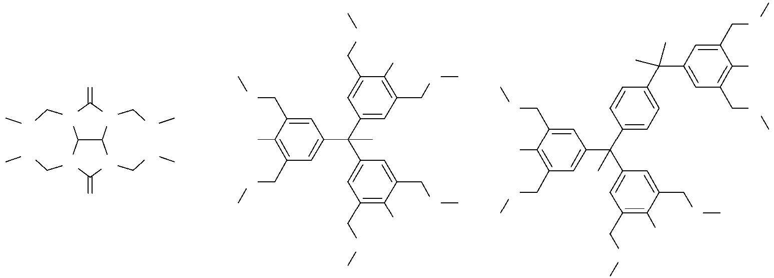

**[Table 3]**

| | Polymer | Additive 1 | Additive 2 | Solvents |
|---|---|---|---|---|
| AL-1 | (A1)[1.0] | (AD1)[0.005] | - | PGMEA[134], DAA[33], EL[167] |
| AL-2 | (A1)[1.0] | (AD1)[0.01] | - | PGMEA[134], DAA[33], EL[167] |
| AL-3 | (A1)[0.9] | (AD1)[0.005] | (AD8)[0.1] | PGMEA[134], DAA[33], EL[167] |
| AL-4 | (A1)[0.9] | (AD1)[0.005] | (AD9)[0.1] | PGMEA[134], DAA[33], EL[167] |
| AL-5 | (A1)[0.9] | (AD1)[0.005] | (AD10)[0.1] | PGMEA[134], DAA[33], EL[167] |
| AL-6 | (A2)[1.0] | (AD1)[0.005] | - | PGMEA[134], DAA[33], EL[167] |
| AL-7 | (A2)[1.0] | (AD1)[0.005] | - | PGMEA[32], DAA[8], EL[40] |
| AL-8 | (A3)[1.0] | (AD2)[0.005] | - | PGMEA[134], DAA[33], EL[167] |
| AL-9 | (A3)[1.0] | (AD2)[0.005] | (AD9)[0.1] | PGMEA[134], DAA[33], EL[167] |
| AL-10 | (A4)[1.0] | (AD3)[0.005] | - | PGMEA[134], DAA[33], EL[167] |
| AL-11 | (A5)[1.0] | (AD3)[0.005] | - | PGMEA[134], DAA[33], EL[167] |
| AL-12 | (A6)[1.0] | (AD3)[0.005] | - | PGMEA[134], DAA[33], EL[167] |
| AL-13 | (A7)[1.0] | (AD3)[0.005] | - | PGMEA[134], DAA[33], EL[167] |
| AL-14 | (A8)[1.0] | (AD3)[0.005] | - | PGMEA[134], DAA[33], EL[167] |
| AL-15 | (A9)[1.0] | (AD3)[0.005] | - | PGMEA[134], DAA[33], EL[167] |
| AL-16 | (A10)[1.0] | (AD3)[0.005] | - | PGMEA[134], DAA[33], EL[167] |
| AL-17 | (A10)[1.0] | (AD3)[0.005] | (AD9)[0.1] | PGMEA[134], DAA[33], EL[167] |
| AL-18 | (A11)[1.0] | (AD3)[0.005] | - | PGMEA[134], DAA[33], EL[167] |
| AL-19 | (A12)[1.0] | (AD3)[0.005] | - | PGMEA[134], DAA[33], EL[167] |
| AL-20 | (A13)[1.0] | (AD4)[0.005] | - | PGMEA[134], DAA[33], EL[167] |
| AL-21 | (A14)[1.0] | (AD4)[0.005] | - | PGMEA[134], DAA[33], EL[167] |
| AL-22 | (A14)[1.0] | (AD4)[0.005] | (AD9)[0.1] | PGMEA[134], DAA[33], EL[167] |
| AL-23 | (A15)[1.0] | (AD4)[0.005] | - | PGMEA[134], DAA[33], EL[167] |
| AL-24 | (A16)[1.0] | (AD4)[0.005] | - | PGMEA[134], DAA[33], EL[167] |
| AL-25 | (A17)[1.0] | (AD4)[0.005] | - | PGMEA[134], DAA[33], EL[167] |
| AL-26 | (A18)[1.0] | (AD4)[0.005] | - | PGMEA[134], DAA[33], EL[167] |
| AL-27 | (A19)[1.0] | (AD4)[0.005] | - | PGMEA[134], DAA[33], EL[167] |
| AL-28 | (A20)[1.0] | (AD4)[0.005] | - | PGMEA[134], DAA[33], EL[167] |
| AL-29 | (A21)[1.0] | (AD5)[0.005] | - | PGMEA[134], DAA[33], EL[167] |
| AL-30 | (A22)[1.0] | (AD5)[0.005] | - | PGMEA[134], DAA[33], EL[167] |

**[Table 4]**

| | Polymer | Additive 1 | Additive 2 | Solvents |
|---|---|---|---|---|
| AL-31 | (A23)[1.0] | (AD5)[0.005] | - | PGMEA[134], DAA[33], EL[167] |
| AL-32 | (A24)[1.0] | (AD5)[0.005] | - | PGMEA[134], DAA[33], EL[167] |
| AL-33 | (A25)[1.0] | (AD5)[0.005] | - | PGMEA[134], DAA[33], EL[167] |
| AL-34 | (A26)[1.0] | (AD5)[0.005] | - | PGMEA[134], DAA[33], EL[167] |
| AL-35 | (A26)[1.0] | (AD5)[0.005] | (AD9)[0.1] | PGMEA[134], DAA[33], EL[167] |
| AL-36 | (A27)[1.0] | (AD5)[0.005] | - | PGMEA[134], DAA[33], EL[167] |
| AL-37 | (A28)[1.0] | (AD5)[0.005] | - | PGMEA[134], DAA[33], EL[167] |
| AL-38 | (A29)[1.0] | (AD5)[0.005] | - | PGMEA[134], DAA[33], EL[167] |
| AL-39 | (A30)[1.0] | (AD5)[0.005] | - | PGMEA[134], DAA[33], EL[167] |
| AL-40 | (A31)[1.0] | (AD5)[0.005] | - | PGMEA[134], DAA[33], EL[167] |
| AL-41 | (A32)[1.0] | (AD6)[0.005] | - | PGMEA[134], DAA[33], EL[167] |
| AL-42 | (A33)[1.0] | (AD6)[0.005] | - | PGMEA[134], DAA[33], EL[167] |
| AL-43 | (A34)[1.0] | (AD7)[0.005] | - | PGMEA[134], DAA[33], EL[167] |
| AL-44 | (A35)[1.0] | (AD7)[0.005] | - | PGMEA[134], DAA[33], EL[167] |
| AL-45 | (A36) [1.0] | (AD7)[0.005] | - | PGMEA[134], DAA[33], EL[167] |
| AL-46 | (A37)[1.0] | (AD7)[0.005] | - | PGMEA[134], DAA[33], EL[167] |
| AL-47 | (A38)[1.0] | (AD7)[0.005] | - | PGMEA[160], CyHO[40] |
| AL-48 | (A39)[1.0] | (AD7)[0.005] | - | PGMEA[160], CyHO[40] |
| AL-49 | (A40)[1.0] | (AD7)[0.005] | - | PGMEA[134], DAA[33], EL[167] |
| AL-50 | (A41)[1.0] | (AD7)[0.005] | - | PGMEA[134], DAA[33], EL[167] |
| AL-51 | (A42)[1.0] | (AD7)[0.005] | - | PGMEA[134], DAA[33], EL[167] |
| AL-52 | (A43)[1.0] | (AD7)[0.005] | - | PGMEA[134], DAA[33], EL[167] |
| Comparative AL-1 | (R1)[1. 0] | (AD5)[0.005] | - | PGMEA[134], DAA[33], EL[167] |
| Comparative AL-2 | (R2)[1.0] | (AD5)[0.005] | - | PGMEA[134], DAA[33], EL[167] |
| Comparative AL-3 | (R3)[1.0] | (AD5)[0.005] | - | PGMEA[134], DAA[33], EL[167] |
| Comparative AL-4 | (R4)[1.0] | (AD5)[0.005] | - | PGMEA[134], DAA[33], EL[167] |
| Comparative AL-5 | (A1) [1. 0] | - | - | PGMEA[134], DAA[33], EL[167] |
| Comparative AL-6 | (A1)[1.0] | (AD2)[0.005] | - | PGMEA[134], DAA[33], EL[167] |
| Comparative AL-7 | (A38)[1. 0] | - | - | PGMEA[160], CyHO[40] |
| Comparative AL-8 | (A39)[1.0] | - | - | PGMEA[160], CyHO[40] |

### [Example 1] Storage Stability Evaluation (Examples 1-1 to 1-52, Comparative Examples 1-1 to 1-8)

Each of the compositions (AL-1 to -52, comparative AL-1 to -8) for forming a resist underlayer film prepared above was respectively placed in a brown-colored bottle and tightly sealed in, and stored in an incubator at -10°C for one month. After that, it was visually observed whether or not there was a precipitate in the solution. The results are shown in Tables 5 and 6.

**[Table 5]**

| | Composition | Presence or absence of precipitate |
|---|---|---|
| Example 1-1 | AL-1 | Absent |
| Example 1-2 | AL-2 | Absent |
| Example 1-3 | AL-3 | Absent |
| Example 1-4 | AL-4 | Absent |
| Example 1-5 | AL-5 | Absent |
| Example 1-6 | AL-6 | Absent |
| Example 1-7 | AL-7 | Absent |
| Example 1-8 | AL-8 | Absent |
| Example 1-9 | AL-9 | Absent |
| Example 1-10 | AL-10 | Absent |
| Example 1-11 | AL-11 | Absent |
| Example 1-12 | AL-12 | Absent |
| Example 1-13 | AL-13 | Absent |
| Example 1-14 | AL-14 | Absent |
| Example 1-15 | AL-15 | Absent |
| Example 1-16 | AL-16 | Absent |
| Example 1-17 | AL-17 | Absent |
| Example 1-18 | AL-18 | Absent |
| Example 1-19 | AL-19 | Absent |
| Example 1-20 | AL-20 | Absent |
| Example 1-21 | AL-21 | Absent |
| Example 1-22 | AL-22 | Absent |
| Example 1-23 | AL-23 | Absent |
| Example 1-24 | AL-24 | Absent |
| Example 1-25 | AL-25 | Absent |
| Example 1-26 | AL-26 | Absent |
| Example 1-27 | AL-27 | Absent |
| Example 1-28 | AL-28 | Absent |
| Example 1-29 | AL-29 | Absent |
| Example 1-30 | AL-30 | Absent |

**[Table 6]**

| | Composition | Presence or absence of precipitate |
|---|---|---|
| Example 1-31 | AL-31 | Absent |
| Example 1-32 | AL-32 | Absent |
| Example 1-33 | AL-33 | Absent |
| Example 1-34 | AL-34 | Absent |
| Example 1-35 | AL-35 | Absent |
| Example 1-36 | AL-36 | Absent |
| Example 1-37 | AL-37 | Absent |
| Example 1-38 | AL-38 | Absent |
| Example 1-39 | AL-39 | Absent |
| Example 1-40 | AL-40 | Absent |
| Example 1-41 | AL-41 | Absent |
| Example 1-42 | AL-42 | Absent |
| Example 1-43 | AL-43 | Absent |
| Example 1-44 | AL-44 | Absent |
| Example 1-45 | AL-45 | Absent |
| Example 1-46 | AL-46 | Absent |
| Example 1-47 | AL-47 | Absent |
| Example 1-48 | AL-48 | Absent |
| Example 1-49 | AL-49 | Absent |
| Example 1-50 | AL-50 | Absent |
| Example 1-51 | AL-51 | Absent |
| Example 1-52 | AL-52 | Absent |
| Comparative Example 1-1 | Comparative AL-1 | Absent |
| Comparative Example 1-2 | Comparative AL-2 | Absent |
| Comparative Example 1-3 | Comparative AL-3 | Present |
| Comparative Example 1-4 | Comparative AL-4 | Absent |
| Comparative Example 1-5 | Comparative AL-5 | Absent |
| Comparative Example 1-6 | Comparative AL-6 | Present |
| Comparative Example 1-7 | Comparative AL-7 | Absent |
| Comparative Example 1-8 | Comparative AL-8 | Absent |

As shown in Tables 5 and 6, no precipitate was generated in Examples 1-1 to 1-52, where the inventive compositions (AL-1 to -52) for forming a resist underlayer film were used, and Comparative Examples 1-1, 1-2, 1-4, 1-5, 1-7, and 1-8. In these materials, at least only one kind of anion was contained, and it can be assumed that the fact that new ion pairs were not formed after the materials were mixed had an effect on the suppression of precipitate generation. On the other hand, generation of a precipitate was observed in the Comparative Examples in which the anion was of one kind but a polymer in which an onium cation structure was pendently bonded to the polymer main chain was not contained, that is, in Comparative Example 1-3, where the organic sulfonyl anion was bonded to the polymer main chain, and in Comparative Example 1-6, where the thermal acid generator contained an anion molecule different from that of the polymer.

### [Example 2] Solvent Resistance Evaluation (Examples 2-1 to 2-52, Comparative Examples 2-1 to 2-6)

Each of the compositions (AL-1 to -52, comparative AL-1, -2, -4, -5, -7, -8) for forming a resist underlayer film prepared above was respectively applied onto a silicon substrate and baked at 215°C for 60 seconds. Then, the film thickness was measured. A PGMEA solvent was dispensed on each film and allowed to stand for 30 seconds. The resultant was spin-dried and baked at 100°C for 60 seconds to evaporate the PGMEA solvent, and the film thickness was measured again. The difference between the film thicknesses of before and after the PGMEA treatment was calculated to evaluate solvent resistance. The results are shown in Tables 7 and 8.

**[Table 7]**

| | Composition | Film thickness after film formation: a (Å) | Film thickness after PGMEA treatment: b (Å) | (b/a) ×100 (%) |
|---|---|---|---|---|
| Example 2-1 | AL-1 | 50.6 | 50.1 | 99.0 |
| Example 2-2 | AL-2 | 50.4 | 50.2 | 99.6 |
| Example 2-3 | AL-3 | 50.7 | 50.4 | 99.4 |
| Example 2-4 | AL-4 | 50.8 | 50.6 | 99.6 |
| Example 2-5 | AL-5 | 50.3 | 50.1 | 99.6 |
| Example 2-6 | AL-6 | 50.6 | 50.2 | 99.2 |
| Example 2-7 | AL-7 | 204.1 | 203.2 | 99.6 |
| Example 2-8 | AL-8 | 50.4 | 50.1 | 99.4 |
| Example 2-9 | AL-9 | 50.1 | 49.9 | 99.6 |
| Example 2-10 | AL-10 | 50.2 | 49.8 | 99.2 |
| Example 2-11 | AL-11 | 50.6 | 50.2 | 99.2 |
| Example 2-12 | AL-12 | 50.8 | 50.3 | 99.0 |
| Example 2-13 | AL-13 | 50.9 | 50.5 | 99.2 |
| Example 2-14 | AL-14 | 50.6 | 50.2 | 99.2 |
| Example 2-15 | AL-15 | 50.4 | 50.0 | 99.2 |
| Example 2-16 | AL-16 | 50.5 | 50.1 | 99.2 |
| Example 2-17 | AL-17 | 50.6 | 50.3 | 99.4 |
| Example 2-18 | AL-18 | 50.3 | 49.9 | 99.2 |
| Example 2-19 | AL-19 | 50.0 | 49.5 | 99.0 |
| Example 2-20 | AL-20 | 50.4 | 49.9 | 99.0 |
| Example 2-21 | AL-21 | 50.3 | 49.9 | 99.2 |
| Example 2-22 | AL-22 | 50.6 | 50.3 | 99.4 |
| Example 2-23 | AL-23 | 50.4 | 50.0 | 99.2 |
| Example 2-24 | AL-24 | 50.8 | 50.3 | 99.0 |
| Example 2-25 | AL-25 | 50.8 | 50.4 | 99.2 |
| Example 2-26 | AL-26 | 50.2 | 49.7 | 99.0 |
| Example 2-27 | AL-27 | 50.4 | 49.9 | 99.0 |
| Example 2-28 | AL-28 | 50.8 | 50.4 | 99.2 |
| Example 2-29 | AL-29 | 50.9 | 50.5 | 99.2 |

**[Table 8]**

| | Composition | Film thickness after film formation: a (Å) | Film thickness after PGMEA treatment: b (Å) | (b/a) ×100 (%) |
|---|---|---|---|---|
| Example 2-30 | AL-30 | 50.1 | 49.7 | 99.2 |
| Example 2-31 | AL-31 | 50.4 | 50.0 | 99.2 |
| Example 2-32 | AL-32 | 50.2 | 49.7 | 99.0 |
| Example 2-33 | AL-33 | 50.7 | 50.2 | 99.0 |
| Example 2-34 | AL-34 | 50.6 | 50.1 | 99.0 |
| Example 2-35 | AL-35 | 50.2 | 50.0 | 99.6 |
| Example 2-36 | AL-36 | 50.3 | 49.9 | 99.2 |
| Example 2-37 | AL-37 | 50.4 | 50.0 | 99.2 |
| Example 2-38 | AL-38 | 50.5 | 50.0 | 99.0 |
| Example 2-39 | AL-39 | 50.2 | 49.8 | 99.2 |
| Example 2-40 | AL-40 | 50.8 | 50.4 | 99.2 |
| Example 2-41 | AL-41 | 50.2 | 49.8 | 99.2 |
| Example 2-42 | AL-42 | 50.3 | 49.9 | 99.2 |
| Example 2-43 | AL-43 | 50.5 | 50.0 | 99.0 |
| Example 2-44 | AL-44 | 50.6 | 50.2 | 99.2 |
| Example 2-45 | AL-45 | 50.3 | 49.8 | 99.0 |
| Example 2-46 | AL-46 | 50.8 | 50.4 | 99.2 |
| Example 2-47 | AL-47 | 50.7 | 50.2 | 99.0 |
| Example 2-48 | AL-48 | 50.4 | 49.9 | 99.2 |
| Example 2-49 | AL-49 | 50.2 | 49.8 | 99.2 |
| Example 2-50 | AL-50 | 50.1 | 49.6 | 99.0 |
| Example 2-51 | AL-51 | 50.4 | 49.9 | 99.0 |
| Example 2-52 | AL-52 | 50.5 | 50.1 | 99.2 |
| Comparative Example 2-1 | Comparative AL-1 | 50.7 | 50.3 | 99.2 |
| Comparative Example 2-2 | Comparative AL-2 | 50.2 | 49.8 | 99.2 |
| Comparative Example 2-3 | Comparative AL-4 | 50.6 | 50.2 | 99.2 |
| Comparative Example 2-4 | Comparative AL-5 | 50.8 | 49.9 | 98.2 |
| Comparative Example 2-5 | Comparative AL-7 | 50.4 | 49.6 | 98.4 |
| Comparative Example 2-6 | Comparative AL-8 | 50.6 | 49.8 | 98.4 |

As shown in Tables 7 and 8, in the cases of the inventive compositions (AL-1 to -52) for forming a resist underlayer film and comparative AL-1, -2, -4, -5, -7, and -8, remaining film was observed even after the PGMEA treatment, and it was confirmed that the compositions had curability. However, in Comparative Examples 2-4 to 2-6, where no thermal acid generator was contained, the amount of film loss was somewhat greater than in the other Examples and Comparative Examples. This suggests that the curability of the film can be enhanced by adding a thermal acid generator.

### [Example 3] Patterning Test by EUV Exposure using Positive Resist 1 (Examples 3-1 to 3-45, Comparative Examples 3-1 to 3-6)

Spin-on carbon ODL-301 (carbon content: 88 mass%) available from Shin-Etsu Chemical Co., Ltd. was applied to silicon wafer substrates and baked at 350°C for 60 seconds to form a 100-nm thick organic film. A silicon-containing spin-on hard mask SHB-A940 (silicon content: 43 mass%) available from Shin-Etsu Chemical Co., Ltd. was applied thereon and baked at 215°C for 60 seconds to form a 15-nm thick silicon-containing resist middle layer film. Furthermore, each of the above-described compositions (AL-1, -5 to -16, -18, -20, -21, -23 to -34, -36 to -52, comparative AL-1, -2, -4, -5, -7, -8) for forming a resist underlayer film was respectively applied and baked at 215°C for 60 seconds to form a resist underlayer film. The composition for forming a positive resist upper layer film described in Table 9 was applied thereon and baked at 100°C for 60 seconds to form a 40-nm thick resist upper layer film.

The composition (monolayer resist for EUV) for forming a positive resist upper layer film was prepared by: dissolving a polymer PRP1 and a quencher Q1 in an organic solvent containing 0.1 mass% of FC-4430 (available from Sumitomo 3M Ltd.) in proportions shown in Table 9; and filtering the solution through a 0.1-µm filter made of a fluorinated resin.

**[Table 9]**

| | Polymer (parts by mass) | Quencher (parts by mass) | Organic solvent (parts by mass) |
|---|---|---|---|
| Composition for forming positive resist upper layer film | PRP1 (100) | Q1 (0.25) | PGMEA/DAA (3,000/1,000) |

Polymer: PRP1
Molecular weight: Mw = 9,200
Dispersity: Mw/Mn = 1.8

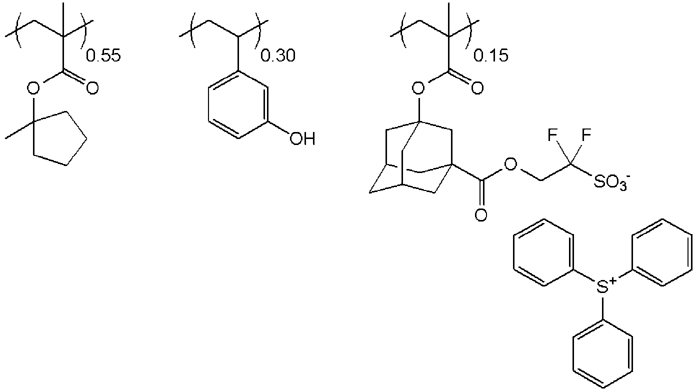

Quencher: Q1

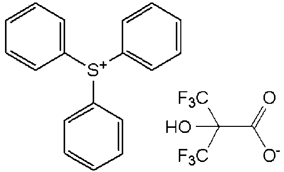

Next, an 18-nm 1:1 line-and-space (LS) pattern was exposed using an EUV exposure apparatus (EUV scanner NXE3400 manufactured by ASML, NA: 0.33, σ: 0.9, 90° dipole illumination), baked (PEB) at 90°C for 60 seconds, and developed with a 2.38 mass% aqueous solution of tetramethylammonium hydroxide (TMAH) for 30 seconds. Thus, a line-and-space pattern having a space width of 18 nm and a pitch of 36 nm was obtained. Regarding this pattern, the sectional profile was observed with an electron microscope.

The cross-sectional profile of the obtained pattern was evaluated with an electron microscope (S-4700) manufactured by Hitachi, Ltd. The results are shown in Tables 10 and 11.

**[Table 10]**

| | Composition | Pattern sectional profile after development |
|---|---|---|
| Example 3-1 | AL-1 | Vertical profile |
| Example 3-2 | AL-5 | Vertical profile |
| Example 3-3 | AL-6 | Vertical profile |
| Example 3-4 | AL-7 | Vertical profile |
| Example 3-5 | AL-8 | Vertical profile |
| Example 3-6 | AL-9 | Vertical profile |
| Example 3-7 | AL-10 | Vertical profile |
| Example 3-8 | AL-11 | Vertical profile |
| Example 3-9 | AL-12 | Vertical profile |
| Example 3-10 | AL-13 | Vertical profile |
| Example 3-11 | AL-14 | Vertical profile |
| Example 3-12 | AL-15 | Vertical profile |
| Example 3-13 | AL-16 | Vertical profile |
| Example 3-14 | AL-18 | Vertical profile |
| Example 3-15 | AL-20 | Vertical profile |
| Example 3-16 | AL-21 | Vertical profile |
| Example 3-17 | AL-23 | Vertical profile |
| Example 3-18 | AL-24 | Vertical profile |
| Example 3-19 | AL-25 | Vertical profile |
| Example 3-20 | AL-26 | Vertical profile |
| Example 3-21 | AL-27 | Vertical profile |
| Example 3-22 | AL-28 | Vertical profile |
| Example 3-23 | AL-29 | Vertical profile |
| Example 3-24 | AL-30 | Vertical profile |
| Example 3-25 | AL-31 | Vertical profile |

**[Table 11]**

| | Composition | Pattern sectional profile after development |
|---|---|---|
| Example 3-26 | AL-32 | Vertical profile |
| Example 3-27 | AL-33 | Vertical profile |
| Example 3-28 | AL-34 | Vertical profile |
| Example 3-29 | AL-36 | Vertical profile |
| Example 3-30 | AL-37 | Vertical profile |
| Example 3-31 | AL-38 | Vertical profile |
| Example Example 3-32 | AL-39 | Vertical profile |
| Example 3-33 | AL-40 | Vertical profile |
| Example Example 3-34 | AL-41 | Vertical profile |
| Example 3-35 | AL-42 | Vertical profile |
| Example 3-36 | AL-43 | Vertical profile |
| Example 3-37 | AL-44 | Vertical profile |
| Example 3-38 | AL-45 | Vertical profile |
| Example 3-39 | AL-46 | Vertical profile |
| Example 3-40 | AL-47 | Vertical profile |
| Example 3-41 | AL-48 | Vertical profile |
| Example 3-42 | AL-49 | Vertical profile |
| Example 3-43 | AL-50 | Vertical profile |
| Example 3-44 | AL-51 | Vertical profile |
| Example 3-45 | AL-52 | Vertical profile |
| Comparative Example 3-1 | Comparative AL-1 | Trailing profile |
| Comparative Example 3-2 | Comparative AL-2 | Trailing profile |
| Comparative Example 3-3 | Comparative AL-4 | Trailing profile |
| Comparative Example 3-4 | Comparative AL-5 | Vertical profile |
| Comparative Example 3-5 | Comparative AL-7 | Vertical profile |
| Comparative Example 3-6 | Comparative AL-8 | Vertical profile |

As shown in Tables 10 and 11, in Examples 3-1 to 3-45, where the inventive compositions for forming a resist underlayer film were used, and Comparative Examples 3-4 to 3-6, where the polymer included an organic sulfonyl anion structure, a vertical cross-sectional pattern profile was obtained. On the other hand, in Comparative Examples 3-1 to 3-3, where a polymer that did not include an organic sulfonyl anion structure was used, a trailing profile was observed. It can be assumed that, by imparting an acid-generating structure to the polymer, contained in a large amount, it was possible to supply acid from the resist underlayer film at the bottom of the pattern, and the trailing profile was improved.

### [Example 4] Patterning Test by EUV Exposure using Positive Resist 2 (Examples 4-1 to 4-45, Comparative Examples 4-1 to 4-6)

Spin-on carbon ODL-301 (carbon content: 88 mass%) available from Shin-Etsu Chemical Co., Ltd. was applied to silicon wafer substrates and baked at 350°C for 60 seconds to form a 100-nm thick organic film. A silicon-containing spin-on hard mask SHB-A940 (silicon content: 43 mass%) available from Shin-Etsu Chemical Co., Ltd. was applied thereon and baked at 215°C for 60 seconds to form a 15-nm thick silicon-containing resist middle layer film. Furthermore, each of the above-described compositions (AL-1, -5 to -16, -18, -20, -21, -23 to -34, -36 to -52, comparative AL-1, -2, -4, -5, -7, -8) for forming a resist underlayer film was respectively applied and baked at 215°C for 60 seconds to form a resist underlayer film. The composition-2 for forming a positive resist upper layer film described in Table 12 was applied thereon and baked at 105°C for 60 seconds to form a 50-nm thick resist upper layer film.

The composition-2 (monolayer resist-2 for EUV) for forming a positive resist upper layer film was prepared by: dissolving a polymer PRP2, a thermal acid generator PAG2, and a quencher Q2 in an organic solvent containing 0.01 mass% of PF636 (available from OMNOVA) in proportions shown in Table 12; and filtering the solution through a 0.1-µm filter made of a fluorinated resin.

**[Table 12]**

| | Polymer (parts by mass) | Thermal acid generator (parts by mass) | Quencher (parts by mass) | Organic solvent (parts by mass) |
|---|---|---|---|---|
| Composition-2 for forming positive resist upper layer film | PRP2 (10) | PAG2 (2.57) | Q2 | PGMEA (200) |
| | | | (0.458) | DAA (50) |

Polymer: PRP2
Molecular weight: Mw = 5,200
Dispersity: Mw/Mn = 1.45

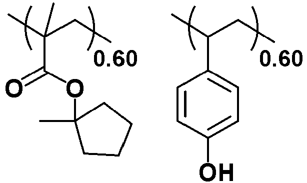

Thermal acid generator: PAG2

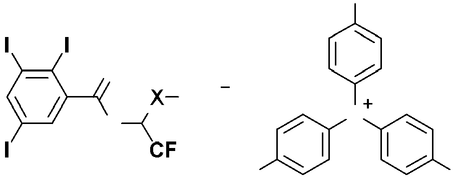

Quencher: Q2

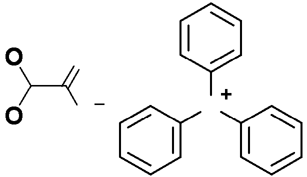

Subsequently, the resist film was exposed using an EUV scanner NXE3400 (NA 0.33, σ 0.9/0.6, quadrupole illumination, 40 nm in pitch on wafer size, hole pattern mask with +20% bias), manufactured by ASML Holding N.V. Then, PEB was performed at 80°C for 60 seconds using a hot plate. Thereafter, development was performed with a 2.38 mass% aqueous TMAH solution for 30 seconds to form a hole pattern with 20 nm in size. Regarding this pattern, the sectional profile was observed with an electron microscope (S-4700) manufactured by Hitachi, Ltd. The results are shown in Tables 13 and 14.

**[Table 13]**

| | Composition | Pattern sectional profile after development |
|---|---|---|
| Example 4-1 | AL-1 | Vertical profile |
| Example 4-2 | AL-5 | Vertical profile |
| Example 4-3 | AL-6 | Vertical profile |
| Example 4-4 | AL-7 | Vertical profile |
| Example 4-5 | AL-8 | Vertical profile |
| Example 4-6 | AL-9 | Vertical profile |
| Example 4-7 | AL-10 | Vertical profile |
| Example 4-8 | AL-11 | Vertical profile |
| Example 4-9 | AL-12 | Vertical profile |
| Example 4-10 | AL-13 | Vertical profile |
| Example 4-11 | AL-14 | Vertical profile |
| Example 4-12 | AL-15 | Vertical profile |
| Example 4-13 | AL-16 | Vertical profile |
| Example 4-14 | AL-18 | Vertical profile |
| Example 4-15 | AL-20 | Vertical profile |
| Example 4-16 | AL-21 | Vertical profile |
| Example 4-17 | AL-23 | Vertical profile |
| Example 4-18 | AL-24 | Vertical profile |
| Example 4-19 | AL-25 | Vertical profile |
| Example 4-20 | AL-26 | Vertical profile |
| Example 4-21 | AL-27 | Vertical profile |
| Example 4-22 | AL-28 | Vertical profile |
| Example 4-23 | AL-29 | Vertical profile |
| Example 4-24 | AL-30 | Vertical profile |
| Example 4-25 | AL-31 | Vertical profile |

**[Table 14]**

| | Composition | Pattern sectional profile after development |
|---|---|---|
| Example 4-26 | AL-32 | Vertical profile |
| Example 4-27 | AL-33 | Vertical profile |
| Example 4-28 | AL-34 | Vertical profile |
| Example 4-29 | AL-36 | Vertical profile |
| Example 4-30 | AL-37 | Vertical profile |
| Example 4-31 | AL-38 | Vertical profile |
| Example 4-32 | AL-39 | Vertical profile |
| Example 4-33 | AL-40 | Vertical profile |
| Example 4-34 | AL-41 | Vertical profile |
| Example 4-35 | AL-42 | Vertical profile |
| Example 4-36 | AL-43 | Vertical profile |
| Example 4-37 | AL-44 | Vertical profile |
| Example 4-38 | AL-45 | Vertical profile |
| Example 4-39 | AL-46 | Vertical profile |
| Example 4-40 | AL-47 | Vertical profile |
| Example 4-41 | AL-48 | Vertical profile |
| Example 4-42 | AL-49 | Vertical profile |
| Example 4-43 | AL-50 | Vertical profile |
| Example 4-44 | AL-51 | Vertical profile |
| Example 4-45 | AL-52 | Vertical profile |
| Comparative Example 4-1 | Comparative AL-1 | Trailing profile |
| Comparative Example 4-2 | Comparative AL-2 | Trailing profile |
| Comparative Example 4-3 | Comparative AL-4 | Trailing profile |
| Comparative Example 4-4 | Comparative AL-5 | Somewhat trailing profile |
| Comparative Example 4-5 | Comparative AL-7 | Somewhat trailing profile |
| Comparative Example 4-6 | Comparative AL-8 | Somewhat trailing profile |

As shown in Tables 13 and 14, in Examples 4-1 to 4-45, where the inventive compositions for forming a resist underlayer film were used, the patterns had a better sectional profile compared to Comparative Examples 4-1 to 4-6. On the other hand, in this test, comparative AL-5, -7, and -8, which exhibited a favorable pattern profile in Example 3, also had a somewhat trailing profile compared to the Examples. From the fact that, regarding these samples, film loss was somewhat great in the solvent resistance test, it can be assumed that intermixing with another resist occurred due to insufficient curability, resulting in a slightly trailing profile.

### [Example 5] Electron Beam Patterning Test (Examples 5-1 to 5-33, Comparative Examples 5-1 to 5-3)

Each of the compositions (AL-10 to -16, -18, -19, -23, -24, -28 to -31, -33 to -40, -43 to -52, comparative AL-5, -7, -8) for forming a resist underlayer film was respectively applied to silicon wafer substrates and baked at 215°C for 60 seconds to form a 5-nm thick resist underlayer film. A metal-containing resist of a resist upper layer film material was applied thereon and baked at 100°C for 60 seconds to form a 40-nm thick resist upper layer film.

As the resist upper layer film material (metal-containing resist), a resist composition R-1 was prepared by: mixing and dissolving a resist material at the composition shown in Table 15 below; and filtering the obtained solution through a 0.2-µm filter made of Teflon (registered trademark).

**[Table 15]**

| Resist | Component A (parts by mass) | Component B (parts by mass) | Component C (parts by mass) | Component D (parts by mass) | Solvent 1 (parts by mass) | | Solvent 2 (parts by mass) | |
|---|---|---|---|---|---|---|---|---|
| R-1 | M-1 (42) | - | - | - | PGMEA | (1, 500) | DAA | (600) |

### Synthesis of Tin Compound M-1 (Component A)

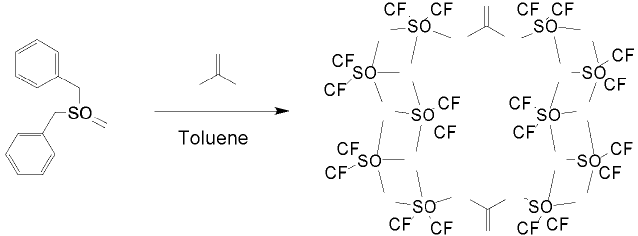

A mixture of 1.6 g of dibenzyltin oxide, 1.5 g of dimethyl carbonate, 1.1 g of methanol, and 60 g of toluene was stirred at 110°C for 3 hours, then restored to room temperature, filtered to remove insoluble matter, and then concentrated under reduced pressure. Toluene was added to the obtained concentrated residue and the mixture was heated and dissolved. Then, the resultant was restored to room temperature and subjected to recrystallization purification to obtain 0.9 g of the target product tin compound M-1 (55% yield).

Subsequently, exposure was performed using an EB drawing apparatus (ELS-F125, acceleration voltage 125 kV), manufactured by Elionix Inc. Then, PEB was performed on a hot plate at 150°C for 60 seconds. Thereafter, development was performed with 2-heptanone for 30 seconds to form a pattern.

The cross-sectional profile of the obtained pattern was evaluated with an electron microscope (S-4700) manufactured by Hitachi, Ltd. and the pattern roughness was evaluated with an electron microscope (CG5000) manufactured by Hitachi High-Technologies Corp. The results are shown in Tables 16 and 17.

**[Table 16]**

| | Composition | Pattern sectional profile after development | Film remaining in space portions after development |
|---|---|---|---|
| Example 5-1 | AL-10 | Vertical profile | Excellent |
| Example 5-2 | AL-11 | Vertical profile | Excellent |
| Example 5-3 | AL-12 | Vertical profile | Excellent |
| Example 5-4 | AL-13 | Vertical profile | Excellent |
| Example 5-5 | AL-14 | Vertical profile | Excellent |
| Example 5-6 | AL-15 | Vertical profile | Excellent |
| Example 5-7 | AL-16 | Vertical profile | Excellent |
| Example 5-8 | AL-18 | Vertical profile | Excellent |
| Example 5-9 | AL-19 | Vertical profile | Excellent |
| Example 5-10 | AL-23 | Vertical profile | Excellent |
| Example 5-11 | AL-24 | Vertical profile | Excellent |
| Example 5-12 | AL-28 | Vertical profile | Excellent |
| Example 5-13 | AL-29 | Vertical profile | Excellent |
| Example 5-14 | AL-30 | Vertical profile | Excellent |
| Example 5-15 | AL-31 | Vertical profile | Excellent |
| Example 5-16 | AL-33 | Vertical profile | Excellent |
| Example 5-17 | AL-34 | Vertical profile | Excellent |
| Example 5-18 | AL-35 | Vertical profile | Excellent |

**[Table 17]**

| | Composition | Pattern sectional profile after development | Film remaining in space portions after development |
|---|---|---|---|
| Example 5-19 | AL-36 | Vertical profile | Excellent |
| Example 5-20 | AL-37 | Vertical profile | Excellent |
| Example 5-21 | AL-38 | Vertical profile | Excellent |
| Example 5-22 | AL-39 | Vertical profile | Excellent |
| Example 5-23 | AL-40 | Vertical profile | Excellent |
| Example 5-24 | AL-43 | Vertical profile | Excellent |
| Example 5-25 | AL-44 | Vertical profile | Excellent |
| Example 5-26 | AL-45 | Vertical profile | Excellent |
| Example 5-27 | AL-46 | Vertical profile | Excellent |
| Example 5-28 | AL-47 | Vertical profile | Excellent |
| Example 5-29 | AL-48 | Vertical profile | Good |
| Example 5-30 | AL-49 | Vertical profile | Excellent |
| Example 5-31 | AL-50 | Vertical profile | Excellent |
| Example 5-32 | AL-51 | Vertical profile | Excellent |
| Example 5-33 | AL-52 | Vertical profile | Excellent |
| Comparative Example 5-1 | Comparative AL-5 | Vertical profile | Fair |
| Comparative Example 5-2 | Comparative AL-7 | Vertical profile | Fair |
| Comparative Example 5-3 | Comparative AL-8 | Vertical profile | Fair |

The meanings of the expressions in Tables 16 and 17 are as follows.
Excellent: no remaining film was found at all in space portions
Good: almost no remaining film was found in space portions
Fair: remaining film was found in space portions

As shown in Tables 16 and 17, in the test using a metal-containing resist, a pattern having a vertical profile was obtained in all Examples and Comparative Examples, but in Example 5-29, where a structural unit in which adjacent carbon atoms each had a hydroxy group was used, some remaining film was observed in space portions. This suggests the possibility that, when substituents having coordinating ability are disposed on adjacent carbon atoms, the substituents interact strongly with the metal atoms in the metal-containing resist, contributing to the remaining of the film. Meanwhile, in Comparative Examples 5-1 to 5-3, remaining film was found in space portions. It can be assumed that this is because intermixing has slightly occurred due to the curability of the film being low in the same manner as in Example 4.

From the above, the inventive compositions for forming a resist underlayer film can exhibit excellent storage stability and does not generate precipitates even after long-term storage and that, at the same time, can form a resist underlayer film that has favorable pattern collapse suppression performance and has the ability to remove resist residues at the bottom of a pattern, and are therefore, extremely useful as compositions for forming a resist underlayer film to be used in multilayer resist methods. In addition, according to the inventive patterning processes using these compositions, a fine pattern can be formed in a substrate to be processed with high precision.

The present description includes the following embodiments.
[1]: A composition for forming a resist underlayer film, comprising:
   (A) a polymer including a structural unit that includes an organic sulfonyl anion structure and an onium cation structure derived from a sulfur atom, the onium cation structure being pendently bonded to a polymer main chain;
   (B) a thermal acid generator; and
   (C) an organic solvent,
   wherein the polymer (A) and the thermal acid generator (B) each have an identical organic sulfonyl anion molecule.
[2]: The composition for forming a resist underlayer film according to [1], wherein the structural unit including the organic sulfonyl anion structure and the onium cation structure derived from a sulfur atom, included in the polymer (A), has a structure represented by the following general formula (1) or (2), 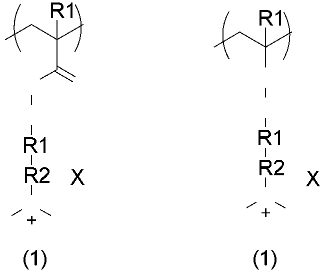 wherein R1 represents a hydrogen atom or a methyl group; R2 represents a substituted or unsubstituted divalent organic group optionally containing an ether bond or an ester bond or represents a single bond; Ar1 and Ar2 each represent a substituted or unsubstituted aromatic ring structure; Ar3 represents a substituted or unsubstituted divalent aromatic ring structure; L1 represents a divalent organic group having 1 to 30 carbon atoms or represents a single bond; X1 represents a nitrogen atom or a carbon atom, each optionally having a substituent, or represents an ether bond, an ester bond, a thioether bond, or a single bond; X⁻ has a structure identical to that of the organic sulfonyl anion molecule included in the thermal acid generator (B); and R2, Ar1, and Ar2 each optionally form a cyclic structure.
[3]: The composition for forming a resist underlayer film according to [2], wherein the X⁻ has an alicyclic structure.
[4]: The composition for forming a resist underlayer film according to any one of [1] to [3], wherein the polymer (A) does not include a structural unit that satisfies the following conditions:
   contains a total of two or more nitrogen atoms, oxygen atoms, or sulfur atoms, each having an unpaired electron, in a structure excluding an acrylate group or methacrylate group that functions as a polymerizable group, and two or fewer atoms are present between the two nitrogen atoms, oxygen atoms, or sulfur atoms.
[5]: The composition for forming a resist underlayer film according to any one of [1] to [4], wherein a ratio of the structural unit including the organic sulfonyl anion structure and the onium cation structure derived from a sulfur atom among structural units of the polymer (A) is 1 mol% or more and 30 mol% or less.
[6]: The composition for forming a resist underlayer film according to any one of [1] to [5], wherein the polymer (A) has at least one structural unit represented by the following general formula (3), 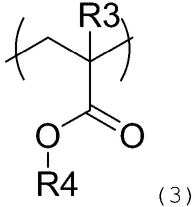 wherein R3 represents a hydrogen atom or a methyl group; and R4 represents a group selected from the following formulae (3-1) to (3-3), 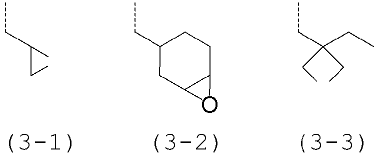 wherein a broken line represents an attachment point.
[7]: The composition for forming a resist underlayer film according to any one of [1] to [6], wherein the polymer (A) has a weight-average molecular weight of 1,000 to 50,000.
[8]: The composition for forming a resist underlayer film according to any one of [1] to [7], wherein the organic solvent (C) is a mixture of one or more kinds of organic solvent having a boiling point of lower than 150°C and one or more kinds of organic solvent having a boiling point of 150°C or higher and a boiling point of lower than 220°C.
[9]: The composition for forming a resist underlayer film according to any one of [1] to [8], further comprising at least one kind selected from (D) a surfactant and (E) a crosslinking agent.
[10]: A patterning process for forming a pattern in a substrate to be processed, comprising the steps of:
   (I-1) applying the composition for forming a resist underlayer film according to any one of [1] to [9] on a substrate to be processed and then performing a heat treatment to form a resist underlayer film;
   (I-2) forming a resist upper layer film on the resist underlayer film by using a photoresist material;
   (I-3) subjecting the resist upper layer film to pattern exposure and then development to form a pattern in the resist upper layer film;
   (I-4) transferring the pattern to the resist underlayer film by dry etching while using the resist upper layer film having the formed pattern as a mask; and
   (I-5) forming the pattern in the substrate to be processed by processing the substrate to be processed while using the resist underlayer film having the transferred pattern as a mask.
[11]: A patterning process for forming a pattern in a substrate to be processed, comprising the steps of:
   (II-1) forming an organic film on a substrate to be processed;
   (II-2) forming a silicon-containing resist middle layer film on the organic film;
   (II-3) applying the composition for forming a resist underlayer film according to any one of [1] to [9] on the silicon-containing resist middle layer film and then performing a heat treatment to form a resist underlayer film;
   (II-4) forming a resist upper layer film on the resist underlayer film by using a photoresist material;
   (II-5) subjecting the resist upper layer film to pattern exposure and then development to form a pattern in the resist upper layer film;
   (II-6) transferring the pattern to the resist underlayer film by dry etching while using the resist upper layer film having the formed pattern as a mask;
   (II-7) transferring the pattern to the silicon-containing resist middle layer film by dry etching while using the resist underlayer film having the transferred pattern as a mask;
   (II-8) transferring the pattern to the organic film by dry etching while using the silicon-containing resist middle layer film having the transferred pattern as a mask; and
   (II-9) forming the pattern in the substrate to be processed by processing the substrate to be processed while using the organic film having the transferred pattern as a mask.
[12]: A patterning process for forming a pattern in a substrate to be processed, comprising the steps of:
   (III-1) forming an organic film on a substrate to be processed;
   (III-2) forming an inorganic hard mask middle layer film selected from a silicon oxide film, a silicon nitride film, and a silicon oxynitride film on the organic film;
   (III-3) applying the composition for forming a resist underlayer film according to any one of [1] to [9] on the inorganic hard mask middle layer film and then performing a heat treatment to form a resist underlayer film;
   (III-4) forming a resist upper layer film on the resist underlayer film by using a photoresist material;
   (III-5) subjecting the resist upper layer film to pattern exposure and then development to form a pattern in the resist upper layer film;
   (III-6) transferring the pattern to the resist underlayer film by dry etching while using the resist upper layer film having the formed pattern as a mask;
   (III-7) transferring the pattern to the inorganic hard mask middle layer film by dry etching while using the resist underlayer film having the transferred pattern as a mask;
   (III-8) transferring the pattern to the organic film by dry etching while using the inorganic hard mask middle layer film having the transferred pattern as a mask; and
   (III-9) forming the pattern in the substrate to be processed by processing the substrate to be processed while using the organic film having the transferred pattern as a mask.
[13]: The patterning process according to [12], wherein the inorganic hard mask middle layer film is formed by a CVD method or an ALD method.
[14]: The patterning process according to any one of [10] to [13], wherein photolithography at a wavelength of 10 nm or more to 300 nm or less, a direct drawing by electron beam, a nanoimprinting, or a combination thereof is employed as a method for forming the pattern in the resist upper layer film.
[15]: The patterning process according to any one of [10] to [14], wherein the resist upper layer film is formed using a photoresist material containing at least an organic metal compound and a solvent.
[16]: The patterning process according to any one of [10] to [15], wherein the development is selected from alkaline development, development with an organic solvent, or development using dry etching.
[17]: The patterning process according to any one of [10] to [16], wherein the substrate to be processed is a semiconductor device substrate or the semiconductor device substrate coated with any of a metal film, a metal carbide film, a metal oxide film, a metal nitride film, a metal oxycarbide film, and a metal oxynitride film.
[18]: The patterning process according to [17], wherein as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used.
[19]: A method for forming a resist underlayer film employed in a semiconductor device manufacturing process, the method comprising:
   spin-coating a substrate to be processed with the composition for forming a resist underlayer film according to any one of [1] to [9]; and
   heating the substrate coated with the composition for forming a resist underlayer film at a temperature of 100°C or higher to 300°C or lower for 10 to 600 seconds to form a resist underlayer film.
[20]: A method for forming a resist underlayer film employed in a semiconductor device manufacturing process, the method comprising:
   spin-coating a substrate to be processed with the composition for forming a resist underlayer film according to any one of [1] to [9]; and
   heating the substrate coated with the composition for forming a resist underlayer film in an atmosphere having an oxygen concentration of 0.1% or more to 21% or less to form a resist underlayer film.
[21]: A method for forming a resist underlayer film employed in a semiconductor device manufacturing process, the method comprising:
   spin-coating a substrate to be processed with the composition for forming a resist underlayer film according to any one of [1] to [9]; and
   heating the substrate coated with the composition for forming a resist underlayer film in an atmosphere having an oxygen concentration of 0.0001% or more to less than 0.1% to form a resist underlayer film.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a resist underlayer film, comprising:
(A) a polymer including a structural unit that includes an organic sulfonyl anion structure and an onium cation structure derived from a sulfur atom, the onium cation structure being pendently bonded to a polymer main chain;
(B) a thermal acid generator; and
(C) an organic solvent,
wherein the polymer (A) and the thermal acid generator (B) each have an identical organic sulfonyl anion molecule.

2. The composition for forming a resist underlayer film according to claim 1, wherein the structural unit including the organic sulfonyl anion structure and the onium cation structure derived from a sulfur atom, included in the polymer (A), has a structure represented by the following general formula (1) or (2), 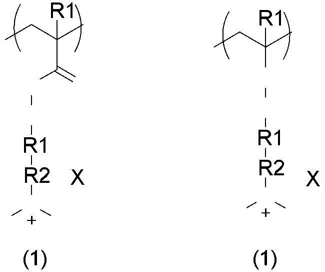 wherein R1 represents a hydrogen atom or a methyl group; R2 represents a substituted or unsubstituted divalent organic group optionally containing an ether bond or an ester bond or represents a single bond; Ar1 and Ar2 each represent a substituted or unsubstituted aromatic ring structure; Ar3 represents a substituted or unsubstituted divalent aromatic ring structure; L1 represents a divalent organic group having 1 to 30 carbon atoms or represents a single bond; X1 represents a nitrogen atom or a carbon atom, each optionally having a substituent, or represents an ether bond, an ester bond, a thioether bond, or a single bond; X⁻ has a structure identical to that of the organic sulfonyl anion molecule included in the thermal acid generator (B); and R2, Ar1, and Ar2 each optionally form a cyclic structure.

3. The composition for forming a resist underlayer film according to claim 2, wherein the X⁻ has an alicyclic structure.

4. The composition for forming a resist underlayer film according to any one of claims 1 to 3,
wherein the polymer (A) does not include a structural unit that satisfies the following conditions:
contains a total of two or more nitrogen atoms, oxygen atoms, or sulfur atoms, each having an unpaired electron, in a structure excluding an acrylate group or methacrylate group that functions as a polymerizable group, and two or fewer atoms are present between the two nitrogen atoms, oxygen atoms, or sulfur atoms; and/or
wherein a ratio of the structural unit including the organic sulfonyl anion structure and the onium cation structure derived from a sulfur atom among structural units of the polymer (A) is 1 mol% or more and 30 mol% or less.

5. The composition for forming a resist underlayer film according to any one of claims 1 to 4,
wherein the polymer (A) has at least one structural unit represented by the following general formula (3), 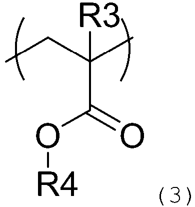
wherein R3 represents a hydrogen atom or a methyl group; and R4 represents a group selected from the following formulae (3-1) to (3-3), 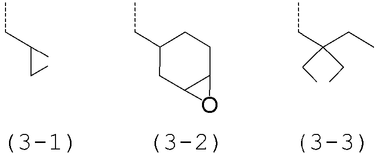
wherein a broken line represents an attachment point; and/or
wherein the polymer (A) has a weight-average molecular weight of 1,000 to 50,000.

6. The composition for forming a resist underlayer film according to any one of claims 1 to 5,
wherein the organic solvent (C) is a mixture of one or more kinds of organic solvent having a boiling point of lower than 150°C and one or more kinds of organic solvent having a boiling point of 150°C or higher and a boiling point of lower than 220°C; and/or
wherein the composition for forming a resist underlayer film further comprises at least one kind selected from (D) a surfactant and (E) a crosslinking agent.

7. A patterning process for forming a pattern in a substrate to be processed, comprising the steps of:
(I-1) applying the composition for forming a resist underlayer film according to any one of claims 1 to 6 on a substrate to be processed and then performing a heat treatment to form a resist underlayer film;
(I-2) forming a resist upper layer film on the resist underlayer film by using a photoresist material;
(I-3) subjecting the resist upper layer film to pattern exposure and then development to form a pattern in the resist upper layer film;
(I-4) transferring the pattern to the resist underlayer film by dry etching while using the resist upper layer film having the formed pattern as a mask; and
(I-5) forming the pattern in the substrate to be processed by processing the substrate to be processed while using the resist underlayer film having the transferred pattern as a mask.

8. A patterning process for forming a pattern in a substrate to be processed, comprising the steps of:
(II-1) forming an organic film on a substrate to be processed;
(II-2) forming a silicon-containing resist middle layer film on the organic film;
(II-3) applying the composition for forming a resist underlayer film according to any one of claims 1 to 6 on the silicon-containing resist middle layer film and then performing a heat treatment to form a resist underlayer film;
(II-4) forming a resist upper layer film on the resist underlayer film by using a photoresist material;
(II-5) subjecting the resist upper layer film to pattern exposure and then development to form a pattern in the resist upper layer film;
(II-6) transferring the pattern to the resist underlayer film by dry etching while using the resist upper layer film having the formed pattern as a mask;
(II-7) transferring the pattern to the silicon-containing resist middle layer film by dry etching while using the resist underlayer film having the transferred pattern as a mask;
(II-8) transferring the pattern to the organic film by dry etching while using the silicon-containing resist middle layer film having the transferred pattern as a mask; and
(II-9) forming the pattern in the substrate to be processed by processing the substrate to be processed while using the organic film having the transferred pattern as a mask.

9. A patterning process for forming a pattern in a substrate to be processed, comprising the steps of:
(III-1) forming an organic film on a substrate to be processed;
(III-2) forming an inorganic hard mask middle layer film selected from a silicon oxide film, a silicon nitride film, and a silicon oxynitride film on the organic film;
(III-3) applying the composition for forming a resist underlayer film according to any one of claims 1 to 6 on the inorganic hard mask middle layer film and then performing a heat treatment to form a resist underlayer film;
(III-4) forming a resist upper layer film on the resist underlayer film by using a photoresist material;
(III-5) subjecting the resist upper layer film to pattern exposure and then development to form a pattern in the resist upper layer film;
(III-6) transferring the pattern to the resist underlayer film by dry etching while using the resist upper layer film having the formed pattern as a mask;
(III-7) transferring the pattern to the inorganic hard mask middle layer film by dry etching while using the resist underlayer film having the transferred pattern as a mask;
(III-8) transferring the pattern to the organic film by dry etching while using the inorganic hard mask middle layer film having the transferred pattern as a mask; and
(III-9) forming the pattern in the substrate to be processed by processing the substrate to be processed while using the organic film having the transferred pattern as a mask.

10. The patterning process according to claim 9, wherein the inorganic hard mask middle layer film is formed by a CVD method or an ALD method.

11. The patterning process according to any one of claims 7 to 10,
wherein photolithography at a wavelength of 10 nm or more to 300 nm or less, a direct drawing by electron beam, a nanoimprinting, or a combination thereof is employed as a method for forming the pattern in the resist upper layer film; and/or
wherein the resist upper layer film is formed using a photoresist material containing at least an organic metal compound and a solvent; and/or
wherein the development is selected from alkaline development, development with an organic solvent, or development using dry etching.

12. The patterning process according to any one of claims 7 to 11, wherein the substrate to be processed is a semiconductor device substrate or the semiconductor device substrate coated with any of a metal film, a metal carbide film, a metal oxide film, a metal nitride film, a metal oxycarbide film, and a metal oxynitride film, wherein as the metal, in particular silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used.

13. A method for forming a resist underlayer film employed in a semiconductor device manufacturing process, the method comprising:
spin-coating a substrate to be processed with the composition for forming a resist underlayer film according to any one of claims 1 to 6; and
heating the substrate coated with the composition for forming a resist underlayer film at a temperature of 100°C or higher to 300°C or lower for 10 to 600 seconds to form a resist underlayer film.

14. A method for forming a resist underlayer film employed in a semiconductor device manufacturing process, the method comprising:
spin-coating a substrate to be processed with the composition for forming a resist underlayer film according to any one of claims 1 to 6; and
heating the substrate coated with the composition for forming a resist underlayer film in an atmosphere having an oxygen concentration of 0.1% or more to 21% or less to form a resist underlayer film.

15. A method for forming a resist underlayer film employed in a semiconductor device manufacturing process, the method comprising:
spin-coating a substrate to be processed with the composition for forming a resist underlayer film according to any one of claims 1 to 6; and
heating the substrate coated with the composition for forming a resist underlayer film in an atmosphere having an oxygen concentration of 0.0001% or more to less than 0.1% to form a resist underlayer film.
